# EUROPEAN PATENT APPLICATION

(11) **EP 4 646 059 A1**
(43) Date of publication of application: **05.11.2025**
(21) Application number: 25741435.9
(22) Date of filing: 10.01.2025
(51) Int. Cl.: H10F 10/14

(54) **SOLAR CELL AND PHOTOVOLTAIC MODULE**

(30) Priority: 16.01.2024 CN 202410065730; 14.09.2024 CN 202411295529
(71) Applicant: Longi Green Energy Technology Co., Ltd., Xi'an, Shaanxi 710100 (CN)
(72) Inventor: QIU, Haoran, Xi' an, Shaanxi 710100 (CN); LI, Junjun, Xi' an, Shaanxi 710100 (CN); WANG, Genshun, Xi' an, Shaanxi 710100 (CN); WU, Hua, Xi' an, Shaanxi 710100 (CN); YU, Mingzhe, Xi' an, Shaanxi 710100 (CN); YE, Feng, Xi' an, Shaanxi 710100 (CN); FANG, Liang, Xi' an, Shaanxi 710100 (CN); XU, Xixiang, Xi' an, Shaanxi 710100 (CN)
(74) Representative: Pfenning, Meinig & Partner mbB
(86) International application number: PCT/CN2025/071890
(87) International publication number: WO 2025/152873

(57) **Abstract**

The present application discloses a solar cell and a photovoltaic module. The solar cell includes: a silicon substrate, where the silicon substrate includes a light-receiving surface and a back surface that are opposite to each other and a side surface arranged between the light-receiving surface and the back surface; a protective layer is arranged on the side surface, and the protective layer includes a first conductive layer, an insulating layer, and a second conductive layer that are arranged in sequence on the side surface; and a conductivity type of the first conductive layer is opposite to a conductivity type of the second conductive layer. Insulating isolation is performed between the first conductive layer and the second conductive layer using the insulating layer, so that a conductive layer that is peripherally plated on the side surface of the silicon substrate does not need to be specially removed in manufacturing procedure of the solar cell, which helps simplify a production process of the solar cell. In addition, the protective layer is used to form shielding protection on the side surface of the silicon substrate, so that risks of damage and current leakage that are caused by direct exposure of the side surface of the silicon substrate can be avoided, and carrier recombination on the side surface of the silicon substrate can be reduced, thereby improving the conversion efficiency of the solar cell.

## Description

### CROSS-REFERENCE TO RELATED APPLICATIONS

The present application claims priority to Chinese Patent Application No. 202410065730.3 filed with the China National Intellectual Property Administration on January 16, 2024 and entitled "SOLAR CELL AND PHOTOVOLTAIC MODULE", and Chinese Patent Application No. 202411295529.0 filed with the China National Intellectual Property Administration on September 14, 2024 and entitled "BACK CONTACT CELL AND PHOTOVOLTAIC MODULE", which are incorporated herein by reference in their entireties.

### TECHNICAL FIELD

The present application relates to the field of photovoltaic technologies, and specifically to a solar cell and a photovoltaic module.

### BACKGROUND

A solar cell is an apparatus that can convert sun's light energy into electric energy. Specifically, when the solar cell is in operation, sunlight irradiates a semiconductor p-n junction of the solar cell, and new electron-hole pairs are formed. Under the action of a built-in electric field of the p-n junction, photogenerated holes flow to a p region, photogenerated ions flow to an n region, and a current can be generated after the circuit is completed. A solar cell with a positive electrode and a negative electrode both being located on a back surface of the solar cell is a back contact cell. Compared with a double-sided contact solar cell, a front surface of the back contact cell is not covered by a metal electrode, so that a light utilization rate of a side with a light-receiving surface of the back contact cell is higher. Therefore, the back contact cell has a higher short-circuit current and higher photoelectric conversion efficiency, which is currently one of the technical directions for implementing a high-efficient crystalline silicon solar cell.

However, in an existing back contact cell, a front surface and a back surface of a silicon substrate are passivated, and a side surface of the silicon substrate is directly exposed to the outside. In this case, recombination on the side surface is severe, and a damage risk is high, leading to reduced efficiency of the back contact cell.

### SUMMARY

The present application aims to provide a solar cell and a photovoltaic module. A film layer arranged on a side surface of a silicon substrate protects the side surface of the silicon substrate, so that while a damage risk of the side surface is reduced, the side surface of the silicon substrate can be passivated to reduce carrier recombination on the side surface of the silicon substrate, thereby improving the conversion efficiency of a back contact cell.

To resolve the foregoing technical problem, the present application is implemented as follows:
In a first aspect, the present application provides a solar cell, including a silicon substrate. The silicon substrate includes a light-receiving surface and a back surface that are opposite to each other and a side surface arranged between the light-receiving surface and the back surface.

A protective layer is arranged on the side surface. In a direction away from the silicon substrate, the protective layer includes a first conductive layer, an insulating layer, and a second conductive layer that are arranged in sequence on the side surface. A conductivity type of the first conductive layer is opposite to a conductivity type of the second conductive layer.

In the present application, the protective layer is arranged on the side surface of the silicon substrate. The protective layer includes the first conductive layer, the insulating layer, and the second conductive layer that are arranged on the side surface of the silicon substrate. Insulating isolation is performed between the first conductive layer and the second conductive layer using the insulating layer, so that a conductive layer that is peripherally plated on the side surface of the silicon substrate does not need to be specially removed in a manufacturing procedure of the solar cell, which helps simplify a production process of the solar cell. In addition, the protective layer may be used to achieve passivation and protective effects on the side surface of the silicon substrate, so that risks of damage and current leakage that are caused by direct exposure of the side surface of the silicon substrate can be avoided, and carrier recombination on the side surface of the silicon substrate can be reduced, thereby improving the conversion efficiency of the solar cell.

In some embodiments, in a direction parallel to the back surface, the back surface includes a first region and a second region that are alternately arranged. The first conductive layer is formed on the first region, and the second conductive layer is formed on the second region.

In some embodiments, the protective layer further includes a first passivation layer located between the side surface and the first conductive layer and a second passivation layer located between the insulating layer and the second conductive layer.

In a direction parallel to the back surface, the back surface includes a first region and a second region that are alternately arranged. In the direction away from the silicon substrate, the first passivation layer and the first conductive layer are formed in sequence on the first region, and the second passivation layer and the second conductive layer are formed in sequence on the second region. The insulating layer is arranged between the first region and the second region.

In some embodiments, a junction between the side surface and the back surface is a first position, a junction between the side surface and the light-receiving surface is a second position, and a thickness of the protective layer at the first position is greater than a thickness of the protective layer at the second position.

In some embodiments, the thickness of the protective layer at the first position is D1, and the thickness of the protective layer at the second position is D2, satisfying: 1 < D1/D2 ≤ 10.

In some embodiments, a total thickness of the first passivation layer and the first conductive layer on the back surface is H1, a total thickness of the first passivation layer and the first conductive layer located at the first position is H11, and a total thickness of the first passivation layer and the first conductive layer located at the second position is H12, satisfying: H12 < H11 ≤ H1.

In some embodiments, a total thickness of the first passivation layer and the first conductive layer located at the first position on the side surface is H11, and a total thickness of the first passivation layer and the first conductive layer located at the second position on the side surface is H12, satisfying: 0.2 ≤ H12/H11 < 1.

In some embodiments, a total thickness H1 of the first passivation layer and the first conductive layer on the back surface and a total thickness H11 of the first passivation layer and the first conductive layer located at the first position satisfy: 0.5 ≤ H11/H1 ≤ 1.

In some embodiments, a total thickness H1 of the first passivation layer and the first conductive layer on the back surface and a total thickness H12 of the first passivation layer and the first conductive layer located at the second position satisfy: 0.2 ≤ H12/H1 ≤ 0.6.

In some embodiments, a thickness of the insulating layer on the back surface is H2, a thickness of the insulating layer located at the first position is H21, and a thickness of the insulating layer located at the second position is H22, satisfying: H22 < H21 ≤ H2.

In some embodiments, a thickness H21 of the insulating layer located at the first position on the side surface and a thickness H22 of the insulating layer located at the second position on the side surface satisfy: 0.2 ≤ H22/H21 < 1.

In some embodiments, a thickness H2 of the insulating layer on the back surface and a thickness H21 of the insulating layer located at the first position satisfy: 0.5 ≤ H211H2 ≤ 1.

In some embodiments, a thickness H2 of the insulating layer on the back surface and a total thickness H22 of the insulating layer located at the second position satisfy: 0.2 ≤ H22/H2 ≤ 0.6.

In some embodiments, a total thickness of the second passivation layer and the second conductive layer on the back surface is H3, a total thickness of the second passivation layer and the second conductive layer located at the first position is H31, and a total thickness of the second passivation layer and the second conductive layer located at the second position is H32, satisfying: H32 < H31 ≤ H3.

In some embodiments, a total thickness H31 of the second passivation layer and the second conductive layer located at the first position on the side surface and a total thickness H32 of the second passivation layer and the second conductive layer located at the second position on the side surface satisfy: 0.2 ≤ H32/H31 < 1.

In some embodiments, a total thickness H3 of the second passivation layer and the second conductive layer on the back surface and a total thickness H31 of the second passivation layer and the second conductive layer located at the first position satisfy: 0.5 ≤ H311H3 ≤ 1.

In some embodiments, a total thickness H3 of the second passivation layer and the second conductive layer on the back surface and a total thickness H32 of the second passivation layer and the second conductive layer located at the second position satisfy: 0.2 ≤ H32/H3 ≤ 0.6.

In some embodiments, the protective layer further includes a third passivation layer and an anti-reflection layer, the third passivation layer is arranged on a side of the second conductive layer away from the side surface, and the anti-reflection layer is arranged on a side of the third passivation layer away from the second conductive layer.

In the direction away from the silicon substrate, the third passivation layer and the anti-reflection layer are formed in sequence on the light-receiving surface.

In some embodiments, a total thickness of the third passivation layer and the anti-reflection layer on the light-receiving surface is H4, a total thickness of the third passivation layer and the anti-reflection layer located at the first position is H41, and a total thickness of the third passivation layer and the anti-reflection layer located at the second position is H42, satisfying: H41 < H42 ≤ H4.

In some embodiments, a total thickness H41 of the third passivation layer and the anti-reflection layer located at the first position on the side surface and a total thickness H42 of the third passivation layer and the anti-reflection layer located at the second position on the side surface satisfy: 0.1 ≤ H42/H41 < 1.

In some embodiments, a total thickness H4 of the third passivation layer and the anti-reflection layer on the light-receiving surface and a total thickness H41 of the third passivation layer and the anti-reflection layer located at the first position satisfy: 0.1 ≤ H41/H4 ≤ 0.4.

In some embodiments, a total thickness H4 of the third passivation layer and the anti-reflection layer on the light-receiving surface and a total thickness H42 of the third passivation layer and the anti-reflection layer located at the second position satisfy: 0.5 ≤ H42/H4 ≤ 0.8.

In some embodiments, the protective layer further includes: a transparent conductive layer, where the transparent conductive layer is arranged on a side of the anti-reflection layer away from the side surface.

The transparent conductive layer is arranged on at least one of the first region and the second region, and the transparent conductive layer is arranged on a side of the first conductive layer and/or the second conductive layer away from the back surface.

In some embodiments, a thickness of the transparent conductive layer located on the back surface is H5, a thickness of the transparent conductive layer located at the first position is H51, and a thickness of the transparent conductive layer located at the second position is H52, satisfying: H52 < H51 ≤ H5.

In some embodiments, a thickness H51 of the transparent conductive layer located at the first position on the side surface and a thickness H52 of the transparent conductive layer located at the second position on the side surface satisfy: 0.3 ≤ H52/H51 < 1.

In some embodiments, a thickness H5 of the transparent conductive layer on the back surface and a thickness H51 of the transparent conductive layer located at the first position satisfy: 0.5 ≤ H51/H5 ≤ 1.

In some embodiments, a thickness H5 of the transparent conductive layer on the back surface and a thickness H52 of the transparent conductive layer located at the second position satisfy: 0.2 ≤ H52/H5 ≤ 0.5.

In a first group of possible implementations of the first aspect, further, the solar cell is a back contact cell.

The first conductive layer is a first doped silicon layer, the second conductive layer is a second doped silicon layer, and the insulating layer includes a surface passivation layer and an anti-reflection layer.

The back contact cell includes: a first interface passivation layer, the first doped silicon layer, the surface passivation layer, the anti-reflection layer, an intrinsic silicon layer, the second doped silicon layer, and a transparent conductive layer that are arranged in sequence on the side surface in the direction away from the silicon substrate.

In a thickness direction of the silicon substrate, the surface passivation layer and the anti-reflection layer are further arranged in sequence on the light-receiving surface, and the surface passivation layer and the anti-reflection layer extend from the light-receiving surface to the side surface.

In the present application, in the case of employing the foregoing technical solution, the first interface passivation layer, the first doped silicon layer, the surface passivation layer, the anti-reflection layer, the intrinsic silicon layer, the second doped silicon layer, and the transparent conductive layer are arranged in sequence on the side surface of the silicon substrate in a direction away from the side surface. The presence of the foregoing film layers can isolate the side surface of the silicon substrate from the external environment, and reduce a risk of damage problems such as scratching caused to the side surface of the silicon substrate by factors such as crushing and collision after transfer or encapsulation. In addition, a risk that water and the like enter the solar cell from the side surface of the solar cell to cause a failure of the solar cell can also be reduced, thereby improving the service life of the back contact cell. In addition, the surface passivation layer and the anti-reflection layer are located on the light-receiving surface of the silicon substrate and also extend to the side surface of the silicon substrate. In this case, on the side surface of the silicon substrate, the first doped silicon layer and the second doped silicon layer that have opposite conductivity types may be isolated by the surface passivation layer and the anti-reflection layer, to prevent conduction and current leakage between the first doped silicon layer and the second doped silicon layer, so that the back contact cell has high conversion efficiency. In addition, the parts of the surface passivation layer and the anti-reflection layer that are arranged on the light-receiving surface can reduce carrier recombination and a surface reflectance, and then the surface passivation layer and the anti-reflection layer extend to the side surface of the silicon substrate, and can further be used to isolate the first doped silicon layer and the second doped silicon layer without additionally forming another insulating layer using another deposition step to prevent current leakage between the first doped silicon layer and the second doped silicon layer. In this way, a manufacturing procedure of the back contact cell can be simplified, and compatibility between a film layer isolating the first doped silicon layer and the second doped silicon layer and another structure in the back contact cell also does not need to be considered, thereby ensuring a high yield of the back contact cell. In addition, the first interface passivation layer and the first doped silicon layer arranged on the side surface of the silicon substrate have a passivation effect on the silicon substrate, and the surface passivation layer that implements insulating isolation between the first doped silicon layer and the second doped silicon layer on the side surface can also passivate the side surface of the silicon substrate, thereby further reducing a carrier recombination rate on the side surface of the silicon substrate and improving the conversion efficiency of the back contact cell.

In addition, in an actual manufacturing procedure, a sequence of forming corresponding film layers arranged on the back surface and the light-receiving surface of the silicon substrate affects a sequence of forming corresponding film layers on the side surface of the silicon substrate. Because the sequence of forming the film layers on the back surface and the light-receiving surface of the silicon substrate is closely related to a process, a solar cell structure, a device, and the like, the sequence of forming the film layers on the back surface and the light-receiving surface of the silicon substrate cannot be randomly adjusted, that is, the sequence of the film layers formed on the side surface of the silicon substrate cannot be randomly adjusted, and a requirement on a sequence of forming the film layers on the side surface of the silicon substrate, a technical problem to be resolved, a requirement on a sequence of forming film layers on front and back surfaces, a technical problem to be resolved, and the like need to be considered comprehensively.

In some embodiments, the back surface includes a first region and a second region. The first interface passivation layer and the first doped silicon layer are located on the first region. The intrinsic silicon layer and the second doped silicon layer are located on the second region, extend from the second region to the first region, and cover a part of the first interface passivation layer and the first doped silicon layer. The insulating layer further includes an insulating mask layer. The insulating mask layer is arranged between the first doped silicon layer and the surface passivation layer that are located on the side surface, and the insulating mask layer is further arranged between the intrinsic silicon layer and the first doped silicon layer that are located on the back surface in the thickness direction of the silicon substrate. In the case of employing the foregoing technical solution, on the back surface of the silicon substrate, the intrinsic silicon layer and the second doped silicon layer are arranged in sequence to form a stack on the second region in the thickness direction of the silicon substrate, and also cover parts of the first interface passivation layer and the first doped silicon layer. In this case, a forming range of the intrinsic silicon layer and the second doped silicon layer on the side of the back surface of the silicon substrate is large, which helps reduce an etching range of the intrinsic silicon layer and the second doped silicon layer that are arranged on the whole layer in a manufacturing procedure, thereby helping improve the production capacity of etching. In addition, the parts of the intrinsic silicon layer and the second doped silicon layer covering the first doped silicon layer can protect an edge of the first doped silicon layer, to prevent an etchant from affecting the edge of the first doped silicon layer, thereby ensuring high carrier collection efficiency at the edge of the first doped silicon layer. The insulating mask layer, together with the surface passivation layer and the anti-reflection layer, may separate the first doped silicon layer and the second doped silicon layer on the side surface, thereby further suppressing current leakage on the side surface. In addition, the side surface of the silicon substrate can also be passivated, thereby further reducing a quantity of defects on the side surface of the silicon substrate. In addition, the insulating mask layer is also formed on the side surface, which further helps reduce a requirement on the thickness of the intrinsic silicon layer, and endows the intrinsic silicon layer with low tunnel resistance while ensuring low forward current leakage between the first doped silicon layer and the second doped silicon layer, which helps improve the carrier collection efficiency of the second doped silicon layer on the side of the back surface.

In some embodiments, on the side surface of the silicon substrate, a thickness of the insulating mask layer gradually increases in a direction from the light-receiving surface to the back surface.

In some embodiments, the insulating mask layer arranged on the side surface is located on a local region of the side surface. In the thickness direction of the silicon substrate, a ratio of a maximum extension length of the insulating mask layer on the side surface to a thickness of the silicon substrate is less than or equal to 80%. In the case of employing the foregoing technical solution, it may be understood that a larger extension length of the insulating mask layer on the side surface indicates an insulating mask layer with a larger formation range to isolate the first doped silicon layer and the second doped silicon layer on the side surface of the silicon substrate. Lower forward current leakage of the back contact cell indicates a stronger protective effect on the side surface of the silicon substrate by the insulating mask layer. However, a smaller extension length of the insulating mask layer on the side surface indicates a larger range of a reverse current leakage region formed between the first doped silicon layer and the second doped silicon layer on the side surface of the silicon substrate and a lower hot spot risk of the back contact cell. Based on this, when the ratio of the maximum extension length of the insulating mask layer on the side surface to the thickness of the silicon substrate is less than or equal to 80%, the forward current leakage, the hot spot risk, and the protection of the side surface of the back contact cell may be regulated according to an actual application scenario requirement of the back contact cell by adjusting the maximum extension length of the insulating mask layer on the side surface, thereby facilitating a balance among the forward current leakage, the hot spot risk, and the protection of the side surface of the back contact cell.

In some embodiments, the first interface passivation layer and the first doped silicon layer that are arranged on the side surface are located only on a local region of the side surface and close to the back surface. In the thickness direction of the silicon substrate, a ratio of a maximum extension length of the first interface passivation layer and the first doped silicon layer on the side surface to a thickness of the silicon substrate is greater than or equal to 70%; and/or a surface of a region in the side surface that is not covered by the first interface passivation layer and the first doped silicon layer is a textured surface, and a ratio of a maximum extension length of the textured surface on the side surface to the thickness of the silicon substrate is less than or equal to 30%; and/or in the side surface, a surface reflectance of a region that is not covered by the first interface passivation layer and the first doped silicon layer is less than a surface reflectance of a region that is covered by the first interface passivation layer and the first doped silicon layer; and/or a surface of a region in the side surface that is not covered by the first interface passivation layer and the first doped silicon layer is a textured surface; and/or a surface of a region in the side surface that is covered by the first interface passivation layer and the first doped silicon layer is a polished surface. In the case of employing the foregoing technical solution, as described above, the first interface passivation layer and the first doped silicon layer have a passivation effect on the side surface of the silicon substrate. Therefore, when the ratios of the maximum extension lengths of the first interface passivation layer and the first doped silicon layer on the side surface to the thickness of the silicon substrate are greater than or equal to 70%, it is ensured that the first interface passivation layer and the first doped silicon layer have large forming ranges on the side surface of the silicon substrate, so that surfaces of more regions on the side surface have low carrier recombination rates, thereby further improving the conversion efficiency of the back contact cell. In addition, most regions of the side surface of the silicon substrate are covered by the first interface passivation layer and the first doped silicon layer. In this case, the first interface passivation layer and the first doped silicon layer have a protective effect on most regions of the side surface of the silicon substrate, and as water and the like are prevented from intruding, it is ensured that the side surface of the silicon substrate is protected by the stack of layers with large thicknesses, thereby further improving a protective effect of the side surface of the silicon substrate. For the application principle of the beneficial effect of that the surface of the region in the side surface that is not covered by the first interface passivation layer and the first doped silicon layer is a textured surface and the ratio of the maximum extension length of the textured surface on the side surface to the thickness of the silicon substrate is less than or equal to 30%, refer to the foregoing descriptions, and details are not described herein again. In addition, compared with a region in the side surface that is covered by the first interface passivation layer and the first doped silicon layer, the surface reflectance of the region in the side surface of the silicon substrate that is not covered by the first interface passivation layer and the first doped silicon layer is low. In this case, although the passivation effect of the surface of the region in the side surface of the silicon substrate that is not covered by the first interface passivation layer and the first doped silicon layer is relatively low, the surface of the region has a relatively high light trapping effect, which is beneficial to refracting more light into the silicon substrate from a side of the side surface of the silicon substrate close to the light-receiving surface, thereby helping improve the conversion efficiency of the back contact cell. In addition, it is not necessary to strictly control manufacturing conditions to keep all the first interface passivation layer and the first doped silicon layer on the side surface in a process of removing the first interface passivation layer and the first doped silicon layer that are peripherally plated on the light-receiving surface, thereby reducing the manufacturing difficulty of the back contact cell. Moreover, when the surface of the region in the side surface that is covered by the first interface passivation layer and the first doped silicon layer is a polished surface, the surface of the region in the side surface that is covered by the first interface passivation layer and the first doped silicon layer is flat, which facilitates the formation of the first interface passivation layer and the first doped silicon layer that are thick on the region, thereby enhancing a passivation effect of the first interface passivation layer and the first doped silicon layer on a corresponding region of the side surface, and further improving the conversion efficiency of the back contact cell.

In some embodiments, a thickness of each part of the first interface passivation layer and/or the first doped silicon layer is the same. In this case, it is beneficial to enable each part of the first interface passivation layer and/or the first doped silicon layer to have a high passivation effect, so that each region corresponding to the first interface passivation layer in the silicon substrate and/or the first doped silicon layer in the silicon substrate has a relatively low carrier recombination rate, thereby further improving the conversion efficiency of the back contact cell.

In some embodiments, on the side surface of the silicon substrate, a thickness of the surface passivation layer is equal, or the thickness of the surface passivation layer gradually increases in a direction from the back surface to the light-receiving surface. In the case of employing the foregoing technical solution, within a particular range, the thickness of the surface passivation layer is directly proportional to the passivation effect and the insulating isolation effect of the surface passivation layer. Based on this, when the thickness of the surface passivation layer is equal on the side surface of the silicon substrate, each part of the surface passivation layer has a high passivation effect and a high insulating isolation characteristic, which helps enable each region in the side surface of the silicon substrate that is covered by the surface passivation layer to have a low quantity of surface defects, and further helps the surface passivation layer having a uniform thickness better achieve an electrical isolation effect of the first doped silicon layer and the second doped silicon layer, thereby reducing forward current leakage. When the thickness of the surface passivation layer gradually increases in the direction from the back surface to the light-receiving surface, the part of the surface passivation layer on the side surface close to the light-receiving surface has a high passivation effect and a better insulating isolation characteristic. In this way, while the quantity of surface defects in the region in the side surface of the silicon substrate close to the light-receiving surface is further reduced, the risk of current leakage between the first doped silicon layer and the second doped silicon layer is further reduced, thereby helping increase an open-circuit voltage and a fill factor of the back contact cell.

In some embodiments, on the side surface of the silicon substrate, the thickness of the anti-reflection layer gradually increases in the direction from the back surface to the light-receiving surface. In this case, the part of the surface passivation layer on the side surface close to the light-receiving surface is endowed with a better insulating isolation characteristic, which further reduces a current leakage risk between the first doped silicon layer and the second doped silicon layer, thereby helping increase an open-circuit voltage and a fill factor of the back contact cell.

In some embodiments, on the side surface of the silicon substrate, a thickness of at least one of the intrinsic silicon layer, the second doped silicon layer, and the transparent conductive layer gradually increases in a direction from the light-receiving surface to the back surface. In the case of employing the foregoing technical solution, on the side surface of the silicon substrate, the thickness of at least one of the intrinsic silicon layer, the second doped silicon layer, and the transparent conductive layer close to the back surface is large, which is beneficial to improving a protective effect of the film layer on the region in the side surface of the silicon substrate close to the back surface, and can further improve the structural reliability of the side surface in the back contact cell.

In some embodiments, the surface passivation layer and the anti-reflection layer that are arranged on the side surface are located on a local region of the side surface and close to the light-receiving surface. In a thickness direction of the silicon substrate, ratios of maximum extension lengths of the surface passivation layer and the anti-reflection layer on the side surface to the thickness of the silicon substrate are less than or equal to 80%. In the case of employing the foregoing technical solution, when the surface passivation layer and the anti-reflection layer are formed on the light-receiving surface and the side surface of the silicon substrate, the surface passivation layer and the anti-reflection layer may also be formed on the side of the back surface due to peripheral plating. To eliminate the impact of the surface passivation layer and the anti-reflection layer on the back surface on the carrier collection efficiency of a second interface passivation layer and the second doped silicon layer, the parts of the surface passivation layer and the anti-reflection layer that are peripherally plated on the back surface need to be removed. Based on this, when the surface passivation layer and the anti-reflection layer that are arranged on the side surface may be located on a local region of the side surface, difficulty in removing the parts of the surface passivation layer and the anti-reflection layer that are peripherally plated on the back surface can be reduced, and manufacturing precision requirements can be reduced. In addition, at the region in the side surface of the silicon substrate that is not covered by the surface passivation layer and the anti-reflection layer, the first doped silicon layer may be in electrical contact with the second doped silicon layer having a conductivity type opposite to that of the first doped silicon layer through the second interface passivation layer, so that a diode structure having a low reverse breakdown voltage is formed on the side surface of the silicon substrate, thereby helping reduce a hot spot risk of the back contact cell and improving the anti-burnout capability of the back contact cell. Alternatively, the surface passivation layer arranged on the side surface is located on a local region of the side surface and close to the light-receiving surface. In a thickness direction of the silicon substrate, a ratio of the maximum extension length of the surface passivation layer on the side surface to the thickness of the silicon substrate is less than or equal to 80%. For beneficial effects corresponding to this feature, details are not described herein again.

In some embodiments, a material of the surface passivation layer includes at least one of aluminum oxide, intrinsic amorphous silicon, and doped silicate glass. In the case of employing the foregoing technical solution, the aluminum oxide and the intrinsic amorphous silicon contain hydrogen, and when the material of the surface passivation layer includes aluminum oxide and/or intrinsic amorphous silicon, hydrogen passivation may be performed on the silicon substrate and the first doped silicon layer, thereby further improving a passivation effect of the surface passivation layer. The doped silicate glass is doped with an impurity of a corresponding conductivity type, and field passivation may further be performed on the silicon substrate and the first doped silicon layer, so that the passivation effect of the surface passivation layer can be further be improved. Next, a manufacturing procedure of the surface passivation layer made of doped silicate glass is simple, which helps reduce manufacturing difficulty of the back contact cell.

In some embodiments, a thickness of the first doped silicon layer is greater than or equal to 30 nm and less than or equal to 140 nm. In the case of employing the foregoing technical solution, the presence of the transparent conductive layer can improve carrier collection efficiency, and leave a margin for thinning the first doped silicon layer. In other words, the thickness of the first doped silicon layer can be suitably reduced due to the presence of the transparent conductive layer without reducing the carrier collection efficiency. Based on this, when the thickness of the first doped silicon layer is within the foregoing range, the first doped silicon layer has a small thickness, which is beneficial to reducing the parasitic absorption thereof, thereby further improving the working efficiency of the back contact cell. In addition, a time period for depositing the first doped silicon layer can also be reduced, thereby improving the manufacturing efficiency of the first doped silicon layer.

In some embodiments, the thickness of the intrinsic silicon layer is greater than or equal to 8 nm and less than or equal to 14 nm. In this case, the intrinsic silicon layer has a large thickness, which is beneficial to enhancing an isolation effect of the intrinsic silicon layer on the first doped silicon layer and the second doped silicon layer, thereby reducing a risk of forward current leakage.

In some embodiments, in the side surface of the silicon substrate, a region on which the first interface passivation layer and the first doped silicon layer are arranged has a pedestal-like texture structure. A thickness of the first interface passivation layer located on a bottom surface of the pedestal-like texture structure is less than a thickness of the first interface passivation layer located on a side wall of the pedestal-like texture structure. In the case of employing the foregoing technical solution, it may be understood that the bottom surface of the pedestal-like texture structure and the side wall of the pedestal-like texture structure have different crystallographic directions. Specifically, the bottom surface of the pedestal-like texture structure is a [110] crystallographic direction, and a quantity of dangling bonds on a surface of the [110] crystallographic direction is relatively small. The side wall of the pedestal-like texture structure is a [111] crystallographic direction, and a quantity of dangling bonds of the [111] crystallographic direction is relatively large. Based on this, when the thickness of the first interface passivation layer that is located on the bottom surface of the pedestal-like texture structure is less than the thickness of the first interface passivation layer that is located on the side wall of the pedestal-like texture structure, it is beneficial to enable a part with the thickness of the first interface passivation layer that is located on the side wall of the pedestal-like texture structure to have a relatively high passivation effect, thereby meeting a requirement of the side wall of the pedestal-like texture structure for a high passivation effect, reducing a carrier recombination rate of the side wall of the pedestal-like texture structure, and further improving the working efficiency of the back contact cell.

In some embodiments, the side surface of the silicon substrate has a pedestal-like texture structure. A thickness of the first interface passivation layer located on a bottom surface of the pedestal-like texture structure is less than a thickness of the first interface passivation layer located on a side wall of the pedestal-like texture structure. A thickness of the intrinsic silicon layer located on the bottom surface of the pedestal-like texture structure is greater than a thickness of the intrinsic silicon layer located on the side wall of the pedestal-like texture structure; and/or a thickness of the second doped silicon layer located on the bottom surface of the pedestal-like texture structure is greater than a thickness of the second doped silicon layer located on the side wall of the pedestal-like texture structure. In the case of employing the foregoing technical solution, a magnitude relationship between the thicknesses of the first interface passivation layer on the bottom surface and the side wall of the pedestal-like texture structure is opposite to a magnitude relationship between the thicknesses of the intrinsic silicon layer and/or the second doped silicon layer on the bottom surface and the side wall of the pedestal-like texture structure. In this case, a large thickness of the first interface passivation layer that is located on the side wall of the pedestal-like texture structure may make up for a weak passivation effect and protective effect of the intrinsic silicon layer and/or the second doped silicon layer due to a small thickness of the intrinsic silicon layer and/or the second doped silicon layer on the side wall of the pedestal-like texture structure. In addition, a large thickness of the intrinsic silicon layer and/or the second doped silicon layer that are located on the bottom surface of the pedestal-like texture structure can make up for a weak passivation effect and protective effect of the first interface passivation layer due to a small thickness of the first interface passivation layer on the bottom surface of the pedestal-like texture structure, thereby ensuring that under a joint passivation effect and protective effect of the first interface passivation layer and the intrinsic silicon layer and/or the second doped silicon layer, the bottom surface and the side surface of the pedestal-like texture structure that correspond to the side surface of the silicon substrate both have high passivation effects and protective strength.

In some embodiments, in the side surface of the silicon substrate, a surface of a region on which the first interface passivation layer and the first doped silicon layer are arranged has a pedestal-like texture structure. In addition, a thickness of the first interface passivation layer located on a bottom surface of the pedestal-like texture structure is greater than a thickness of the first interface passivation layer located on a side wall of the pedestal-like texture structure.

In some embodiments, a doped layer is formed in the side surface of the silicon substrate. A dopant in the doped layer includes a dopant in the first doped silicon layer. In the case of employing the foregoing technical solution, a high-low junction may be formed between the doped layer and the first doped silicon layer, so that energy bands of the first doped silicon layer and the side surface of the silicon substrate are more matched, a passivation effect of the first doped silicon layer on the side surface of the silicon substrate is improved, and the open-circuit voltage of the back contact cell is increased.

In a second group of possible implementations of the first aspect, further, the solar cell is a back contact cell.

The first conductive layer is a first doped silicon layer, the second conductive layer is a second doped silicon layer, and the insulating layer includes an insulating mask layer. The back contact cell includes: a first interface passivation layer, the first doped silicon layer, the insulating mask layer, an intrinsic silicon layer, the second doped silicon layer, and a transparent conductive layer that are arranged in sequence on the side surface in the direction away from the silicon substrate. The back contact cell includes a surface passivation layer arranged on the light-receiving surface, and the surface passivation layer extends from the light-receiving surface to the side surface. The back contact cell further includes a second interface passivation layer that is arranged on the back surface and located between the silicon substrate and the second doped silicon layer, and the second interface passivation layer extends from the back surface to the side surface. On the side surface, the intrinsic silicon layer includes the surface passivation layer and the second interface passivation layer that are arranged to form a stack in a direction away from the side surface.

In the present application, in the case of employing the foregoing technical solution, in addition to the intrinsic silicon layer arranged between the first doped silicon layer and the second doped silicon layer, the insulating mask layer is further arranged. In this way, while it is ensured that forward current leakage loss is reduced, a requirement on the thickness of the intrinsic silicon layer can be lowered, and the tunnel resistance of the intrinsic silicon layer can be lowered, which is beneficial to improving the carrier collection efficiency of the second doped silicon layer arranged on the side of the back surface of the silicon substrate, thereby further improving the conversion efficiency of the back contact cell. In addition, the presence of the insulating mask layer can further enhance a protective effect on the side surface of the silicon substrate, and further improve the structural reliability of the side surface of the back contact cell. In addition, in an actual manufacturing procedure, a sequence of forming corresponding film layers arranged on the back surface and the light-receiving surface of the silicon substrate affects a sequence of forming corresponding film layers on the side surface of the silicon substrate. Because the sequence of forming the film layers on the back surface and the light-receiving surface of the silicon substrate is closely related to a process, a solar cell structure, a device, and the like, the sequence of forming the film layers on the back surface and the light-receiving surface of the silicon substrate cannot be randomly adjusted, that is, the sequence of the film layers formed on the side surface of the silicon substrate cannot be randomly adjusted, and a requirement on a sequence of forming the film layers on the side surface of the silicon substrate, a technical problem to be resolved, a requirement on a sequence of forming film layers on front and back surfaces, a technical problem to be resolved, and the like need to be considered comprehensively.

In some embodiments, the back contact cell further includes an anti-reflection layer arranged on the light-receiving surface, and the anti-reflection layer extends from the light-receiving surface to the side surface. On the side surface, the anti-reflection layer is arranged between the second doped silicon layer and the transparent conductive layer in the direction away from the side surface. In the case of employing the foregoing technical solution, one anti-reflection layer is further added to the film layers arranged on the side surface of the silicon substrate, so that the protective effect on the side surface of the silicon substrate can be further improved, thereby reducing a damage risk of the side surface of the silicon substrate and reducing forward current leakage loss. In addition, in this case, the anti-reflection layer is directly formed on a side of the second doped silicon layer away from the silicon substrate. A difference exists between the materials of the surface passivation layer and the second doped silicon layer, and the anti-reflection layer is easier to deposit on the surface passivation layer. Therefore, based on this, compared with that the anti-reflection layer is directly formed on the surface passivation layer, when the anti-reflection layer is directly formed on the side of the second doped silicon layer away from the silicon substrate, a peripheral-plating range of the anti-reflection layer on the side of the back surface can be reduced, so that the amount of etching during the removal of the peripheral plating of the anti-reflection layer on the back surface can be reduced, thereby improving the manufacturing efficiency.

In some embodiments, the first interface passivation layer and the first doped silicon layer that are arranged on the side surface are located only on a local region of the side surface and close to the back surface. In the thickness direction of the silicon substrate, a ratio of a maximum extension length of the first interface passivation layer and the first doped silicon layer on the side surface to a thickness of the silicon substrate is greater than or equal to 70%; and/or a surface of a region in the side surface that is not covered by the first interface passivation layer and the first doped silicon layer is a textured surface, and a ratio of a maximum extension length of the textured surface on the side surface to the thickness of the silicon substrate is less than or equal to 30%; and/or in the side surface, a surface reflectance of a region that is not covered by the first interface passivation layer and the first doped silicon layer is less than a surface reflectance of a region that is covered by the first interface passivation layer and the first doped silicon layer; and/or a surface of a region in the side surface that is not covered by the first interface passivation layer and the first doped silicon layer is a textured surface; and/or a surface of a region in the side surface that is covered by the first interface passivation layer and the first doped silicon layer is a polished surface.

In some embodiments, a thickness of each part of the first interface passivation layer and/or the first doped silicon layer is the same.

In some embodiments, on the side surface of the silicon substrate, a thickness of the surface passivation layer is equal, or the thickness of the surface passivation layer gradually increases in a direction from the back surface to the light-receiving surface.

In some embodiments, on the side surface of the silicon substrate, the thickness of the anti-reflection layer gradually increases in the direction from the back surface to the light-receiving surface.

In some embodiments, on the side surface of the silicon substrate, a thickness of at least one of the intrinsic silicon layer, the second doped silicon layer, and the transparent conductive layer gradually increases in a direction from the light-receiving surface to the back surface.

In some embodiments, the surface passivation layer and the anti-reflection layer that are arranged on the side surface are located on a local region of the side surface and close to the light-receiving surface. In a thickness direction of the silicon substrate, ratios of maximum extension lengths of the surface passivation layer and the anti-reflection layer on the side surface to the thickness of the silicon substrate are less than or equal to 80%.

In some embodiments, a material of the surface passivation layer includes at least one of aluminum oxide, intrinsic amorphous silicon, and doped silicate glass.

In some embodiments, a thickness of the first doped silicon layer is greater than or equal to 30 nm and less than or equal to 140 nm.

In some embodiments, the thickness of the intrinsic silicon layer is greater than or equal to 8 nm and less than or equal to 14 nm.

In some embodiments, in the side surface of the silicon substrate, a region on which the first interface passivation layer and the first doped silicon layer are arranged has a pedestal-like texture structure. A thickness of the first interface passivation layer located on a bottom surface of the pedestal-like texture structure is less than a thickness of the first interface passivation layer located on a side wall of the pedestal-like texture structure.

In some embodiments, in the side surface of the silicon substrate, a surface of a region on which the first interface passivation layer and the first doped silicon layer are arranged has a pedestal-like texture structure. In addition, a thickness of the first interface passivation layer located on a bottom surface of the pedestal-like texture structure is greater than a thickness of the first interface passivation layer located on a side wall of the pedestal-like texture structure.

In some embodiments, the side surface of the silicon substrate has a pedestal-like texture structure. A thickness of the first interface passivation layer located on a bottom surface of the pedestal-like texture structure is less than a thickness of the first interface passivation layer located on a side wall of the pedestal-like texture structure. A thickness of the intrinsic silicon layer located on the bottom surface of the pedestal-like texture structure is greater than a thickness of the intrinsic silicon layer located on the side wall of the pedestal-like texture structure; and/or a thickness of the second doped silicon layer located on the bottom surface of the pedestal-like texture structure is greater than a thickness of the second doped silicon layer located on the side wall of the pedestal-like texture structure.

In some embodiments, a doped layer is formed in the side surface of the silicon substrate. A dopant in the doped layer includes a dopant in the first doped silicon layer.

It should be understood that, in the second group and the first group of the first aspect, same or similar optional solutions have the same or similar technical effects, and details are not described herein again.

In a second aspect, the present application provides a solar cell, where the solar cell is a back contact cell, and the back contact cell includes:
a silicon substrate, the silicon substrate including a back surface and a light-receiving surface that are arranged opposite to each other and a side surface connecting the back surface and the light-receiving surface; and
a first interface passivation layer, a first doped silicon layer, an intrinsic silicon layer, a second doped silicon layer, and a transparent conductive layer that are arranged in sequence on the side surface in a direction away from the side surface, where on the side surface of the silicon substrate, the first doped silicon layer and the intrinsic silicon layer are in direct contact; and a conductivity type of the first doped silicon layer is opposite to a conductivity type of the second doped silicon layer.

In the present application, in the case of employing the foregoing technical solution, on the side surface of the silicon substrate, the first doped silicon layer may be electrically connected to the second doped silicon layer having a conductivity type opposite to that of the first doped silicon layer by the intrinsic silicon layer, so that a diode structure having a low reverse breakdown voltage is formed on the side surface of the silicon substrate, thereby reducing a hot spot risk of the back contact cell. In addition, the first doped silicon layer, the intrinsic silicon layer, and the second doped silicon layer arranged on the side surface of the silicon substrate can further passivate the side surface of the silicon substrate, thereby reducing a carrier recombination rate on the side surface of the silicon substrate and improving the conversion efficiency of the back contact cell. In addition, the first doped silicon layer, the intrinsic silicon layer, and the second doped silicon layer that are arranged on the side surface of the silicon substrate can also protect the side surface of the silicon substrate, to reduce risks of damage and current leakage that easily occur because the side surface of the silicon substrate is directly exposed, thereby improving the structural reliability of the back contact cell. In addition, in an actual manufacturing procedure, a sequence of forming corresponding film layers arranged on the back surface and the light-receiving surface of the silicon substrate affects a sequence of forming corresponding film layers on the side surface of the silicon substrate. Because the sequence of forming the film layers on the back surface and the light-receiving surface of the silicon substrate is closely related to a process, a solar cell structure, a device, and the like, the sequence of forming the film layers on the back surface and the light-receiving surface of the silicon substrate cannot be randomly adjusted, that is, the sequence of the film layers formed on the side surface of the silicon substrate cannot be randomly adjusted, and a requirement on a sequence of forming the film layers on the side surface of the silicon substrate, a technical problem to be resolved, a requirement on a sequence of forming film layers on front and back surfaces, a technical problem to be resolved, and the like need to be considered comprehensively.

In some embodiments, the back contact cell includes a surface passivation layer arranged on the light-receiving surface, and the surface passivation layer extends from the light-receiving surface to the side surface. In addition, the back contact cell further includes a second interface passivation layer that is arranged on the back surface and located between the silicon substrate and the second doped silicon layer, and the second interface passivation layer extends from the back surface to the side surface. Based on this, on the side surface, the intrinsic silicon layer includes the surface passivation layer and the second interface passivation layer that are arranged to form a stack in a direction away from the side surface. In the case of employing the foregoing technical solution, two film layers, that is, the surface passivation layer and the second interface passivation layer, are provided between the first doped silicon layer and the second doped silicon layer on the side surface of the silicon substrate. In this case, the intrinsic silicon layer has particular transmission resistance, which is beneficial to reducing forward current leakage of the back contact cell and beneficial to balancing the conversion efficiency and the hot spot risk of the back contact cell. In addition, when the low forward current leakage is obtained, it is not necessary to form an intrinsic silicon layer having a large thickness, so that a large thickness of a single second interface passivation layer or surface passivation layer is avoided, thereby ensuring that the second interface passivation layer has a low tunnel resistance and the surface passivation layer has low resistance to light transmission, thereby ensuring high conversion efficiency of the back contact cell.

In some embodiments, on the side surface of the silicon substrate, a thickness of each part of the intrinsic silicon layer is the same. In this case, each part of the intrinsic silicon layer arranged on the side surface of the silicon substrate has high passivation performance and a high protective effect, so that the carrier recombination rate on the side surface of the silicon substrate can be further reduced, and the structural reliability of the back contact cell can be improved.

In some embodiments, on the side surface of the silicon substrate, a thickness of the intrinsic silicon layer is greater than or equal to 5 nm and less than or equal to 30 nm. In the case of employing the foregoing technical solution, on the side surface of the silicon substrate, the thickness of the intrinsic silicon layer is within the foregoing range, which is beneficial to preventing poor passivation performance and a poor protective effect of the intrinsic silicon layer caused by a small thickness of the intrinsic silicon layer, thereby ensuring that the side surface has a low carrier recombination rate and high structural reliability, and is further beneficial to reducing the forward current leakage loss of the back contact cell. It can further be avoided that the thickness of the second interface passivation layer (or the second interface passivation layer and the surface passivation layer) is large because the thickness of the intrinsic silicon layer is large, to ensure that the second interface passivation layer has low tunnel resistance and the surface passivation layer has low resistance to light transmission, thereby ensuring high conversion efficiency of the back contact cell.

In some embodiments, the back contact cell further includes an anti-reflection layer. On the light-receiving surface, the anti-reflection layer is arranged on a side of the surface passivation layer away from the silicon substrate. The anti-reflection layer extends from the light-receiving surface to the side surface, and on the side surface, the anti-reflection layer is arranged between the second doped silicon layer and the transparent conductive layer. In the case of employing the foregoing technical solution, one anti-reflection layer is further added to the film layers arranged on the side surface of the silicon substrate, so that the protective effect on the side surface of the silicon substrate can be further improved, thereby reducing a damage risk of the side surface of the silicon substrate and reducing the forward current leakage loss. In addition, in this case, the anti-reflection layer is directly formed on a side of the second doped silicon layer away from the silicon substrate. A difference exists between the materials of the surface passivation layer and the second doped silicon layer, and the anti-reflection layer is easier to deposit on the surface passivation layer. Therefore, based on this, compared with that the anti-reflection layer is directly formed on the surface passivation layer, when the anti-reflection layer is directly formed on the side of the second doped silicon layer away from the silicon substrate, a peripheral-plating range of the anti-reflection layer on the side of the back surface can be reduced, so that the amount of etching during the removal of the peripheral plating of the anti-reflection layer on the back surface can be reduced, thereby improving the manufacturing efficiency.

In some embodiments, the back contact cell further includes a surface passivation layer and an anti-reflection layer that are arranged in sequence on the light-receiving surface in a thickness direction of the silicon substrate, and the surface passivation layer and the anti-reflection layer extend from the light-receiving surface to the side surface. In addition, on the side surface and in a direction away from the side surface, the surface passivation layer and the anti-reflection layer are arranged in sequence to form a stack between the second doped silicon layer and the transparent conductive layer. In this case, the presence of the surface passivation layer and the anti-reflection layer can further improve a protective effect on the side surface of the silicon substrate, thereby reducing a damage risk of the side surface of the silicon substrate.

In some embodiments, a doped layer is formed in the side surface of the silicon substrate. A dopant in the doped layer includes a dopant in the first doped silicon layer.

In some embodiments, the first interface passivation layer and the first doped silicon layer that are arranged on the side surface are located only on a local region of the side surface and close to the back surface. In the thickness direction of the silicon substrate, a ratio of a maximum extension length of the first interface passivation layer and the first doped silicon layer on the side surface to a thickness of the silicon substrate is greater than or equal to 70%; and/or a surface of a region in the side surface that is not covered by the first interface passivation layer and the first doped silicon layer is a textured surface, and a ratio of a maximum extension length of the textured surface on the side surface to the thickness of the silicon substrate is less than or equal to 30%; and/or in the side surface, a surface reflectance of a region that is not covered by the first interface passivation layer and the first doped silicon layer is less than a surface reflectance of a region that is covered by the first interface passivation layer and the first doped silicon layer; and/or a surface of a region in the side surface that is not covered by the first interface passivation layer and the first doped silicon layer is a textured surface; and/or a surface of a region in the side surface that is covered by the first interface passivation layer and the first doped silicon layer is a polished surface.

In some embodiments, a thickness of each part of the first interface passivation layer and/or the first doped silicon layer is the same.

In some embodiments, on the side surface of the silicon substrate, a thickness of the surface passivation layer is equal, or the thickness of the surface passivation layer gradually increases in a direction from the back surface to the light-receiving surface.

In some embodiments, on the side surface of the silicon substrate, the thickness of the anti-reflection layer gradually increases in the direction from the back surface to the light-receiving surface.

In some embodiments, on the side surface of the silicon substrate, a thickness of the second doped silicon layer and/or the transparent conductive layer gradually increases in a direction from the light-receiving surface to the back surface.

In some embodiments, the surface passivation layer and the anti-reflection layer that are arranged on the side surface are located on a local region of the side surface and close to the light-receiving surface. In a thickness direction of the silicon substrate, ratios of maximum extension lengths of the surface passivation layer and the anti-reflection layer on the side surface to the thickness of the silicon substrate are less than or equal to 80%.

In some embodiments, a material of the surface passivation layer includes at least one of aluminum oxide, intrinsic amorphous silicon, and doped silicate glass.

In some embodiments, a thickness of the first doped silicon layer is greater than or equal to 30 nm and less than or equal to 140 nm.

In some embodiments, in the side surface of the silicon substrate, a surface of a region on which the first interface passivation layer and the first doped silicon layer are arranged has a pedestal-like texture structure. In addition, a thickness of the first interface passivation layer located on a bottom surface of the pedestal-like texture structure is less than a thickness of the first interface passivation layer located on a side wall of the pedestal-like texture structure.

In some embodiments, in the side surface of the silicon substrate, a surface of a region on which the first interface passivation layer and the first doped silicon layer are arranged has a pedestal-like texture structure. In addition, a thickness of the first interface passivation layer located on a bottom surface of the pedestal-like texture structure is greater than a thickness of the first interface passivation layer located on a side wall of the pedestal-like texture structure.

In some embodiments, the side surface of the silicon substrate has a pedestal-like texture structure. A thickness of the first interface passivation layer located on a bottom surface of the pedestal-like texture structure is less than a thickness of the first interface passivation layer located on a side wall of the pedestal-like texture structure. A thickness of the intrinsic silicon layer located on the bottom surface of the pedestal-like texture structure is greater than a thickness of the intrinsic silicon layer located on the side wall of the pedestal-like texture structure; and/or a thickness of the second doped silicon layer located on the bottom surface of the pedestal-like texture structure is greater than a thickness of the second doped silicon layer located on the side wall of the pedestal-like texture structure.

It should be understood that, in the second aspect and the first aspect, same or similar optional solutions have the same or similar technical effects, which are not described herein again.

In a third aspect, the present application provides a photovoltaic module, including any foregoing solar cell.

The additional aspects and advantages of the present application are partially provided in the following description and partially become obvious from the following description or understood through the practice of the present application.

### BRIEF DESCRIPTION OF THE DRAWINGS

The foregoing and/or additional aspects and advantages of the present application will be apparent and easily comprehensible from the description of the embodiments with reference to the accompanying drawings.
FIG. 1 is a schematic diagram of a solar cell according to an embodiment of the present application;
FIG. 2 is a schematic diagram of a silicon substrate according to an embodiment of the present application;
FIG. 3 is a schematic diagram of a structure of an edge of a solar cell according to an embodiment of the present application;
FIG. 4 is a schematic diagram of a structure of an edge of another solar cell according to an embodiment of the present application;
FIG. 5 is a schematic diagram 1 of a structure of an edge of yet another solar cell according to an embodiment of the present application;
FIG. 6 is a schematic diagram 2 of a structure of an edge of yet another solar cell according to an embodiment of the present application;
FIG. 7 is a partial side cross-sectional view of a solar cell according to an embodiment of the present application;
FIG. 8 is a schematic longitudinal cross-sectional view 1 of a structure of a back contact cell according to an embodiment of the present application;
FIG. 9 is a schematic longitudinal cross-sectional view 2 of a structure of a back contact cell according to an embodiment of the present application;
FIG. 10 is a schematic longitudinal cross-sectional view 3 of a structure of a back contact cell according to an embodiment of the present application;
FIG. 11 is a schematic longitudinal cross-sectional view 4 of a structure of a back contact cell according to an embodiment of the present application;
FIG. 12 is a schematic longitudinal cross-sectional view 5 of a structure of a back contact cell according to an embodiment of the present application;
FIG. 13 is a schematic longitudinal cross-sectional view 6 of a structure of a back contact cell according to an embodiment of the present application;
FIG. 14 is a schematic longitudinal cross-sectional view 7 of a structure of a back contact cell according to an embodiment of the present application;
FIG. 15 is a schematic longitudinal cross-sectional view 8 of a structure of a back contact cell according to an embodiment of the present application;
FIG. 16 is a schematic longitudinal cross-sectional view 9 of a structure of a back contact cell according to an embodiment of the present application;
FIG. 17 is a schematic longitudinal cross-sectional view 10 of a structure of a back contact cell according to an embodiment of the present application; and
FIG. 18 is a schematic longitudinal cross-sectional view 11 of a structure of a back contact cell according to an embodiment of the present application.

Reference numerals:
100-silicon substrate; 110-light-receiving surface; 120-back surface;
120a-first region; 120b-second region;
130-side surface; 130a-first position; 130b-second position;
200-protective layer; 201-first passivation layer; 202-first conductive layer; 203-insulating layer; 204-second passivation layer; 205-second conductive layer; 206-third passivation layer; 207-anti-reflection layer; 208-transparent conductive layer;
12-first doped silicon layer; 13-surface passivation layer; 15-intrinsic silicon layer; 16-second doped silicon layer; 20-first interface passivation layer; 21-insulating mask layer; and 22-second interface passivation layer.

### DETAILED DESCRIPTION

Below:
The embodiments of the present application are described below in detail. Examples of the embodiments are shown in the accompanying drawings. The same or similar numerals represent the same or similar elements or elements having the same or similar functions throughout the specification. The embodiments described below with reference to the accompanying drawings are exemplary, and are only used to explain the present application but should not be construed as a limitation to the present application. All other embodiments obtained by a person of ordinary skill in the art based on the embodiments of the present application without creative efforts fall within the protection scope of the present application.

Therefore, a feature limited by "first" or "second" in the specification and claims of the present application may explicitly or implicitly comprise one or more features. In the description of the present application, "a plurality of" herein means "two or more" unless otherwise described. In addition, the term "and/or" in the description and claims represents at least one of associated objects. The character "/" generally indicates an "or" relationship between the contextual objects.

In the description of the present application, it needs to be understood that orientation or location relationships indicated by terms "center", "longitudinal", "transverse", "length", "width", "thickness", "up", "down", "front", "rear", "left", "right", "vertical", "horizontal", "top", "bottom", "inside", "outside", "clockwise", "counterclockwise", "axial", "radial", and "circumferential" are based on orientation or location relationships shown in the accompanying drawings, and are only used to facilitate description of the present application and simplify description, but are not used to indicate or imply that the apparatuses or elements must have specific orientations or are constructed and operated by using specific orientations, and therefore, cannot be understood as a limit to the present application.

In the description of the present application, it needs to be noted that unless otherwise expressly specified and defined, "mounted", "connected", and "connection" should be understood in a broad sense, for example, fixedly connected, detachably connected, or integrally connected; or mechanically connected, or electrically connected; or connected directly or through an intermediate, or two elements communicated internally. For persons skilled in the art, specific meanings of the terms in the present application should be understood according to specific conditions.

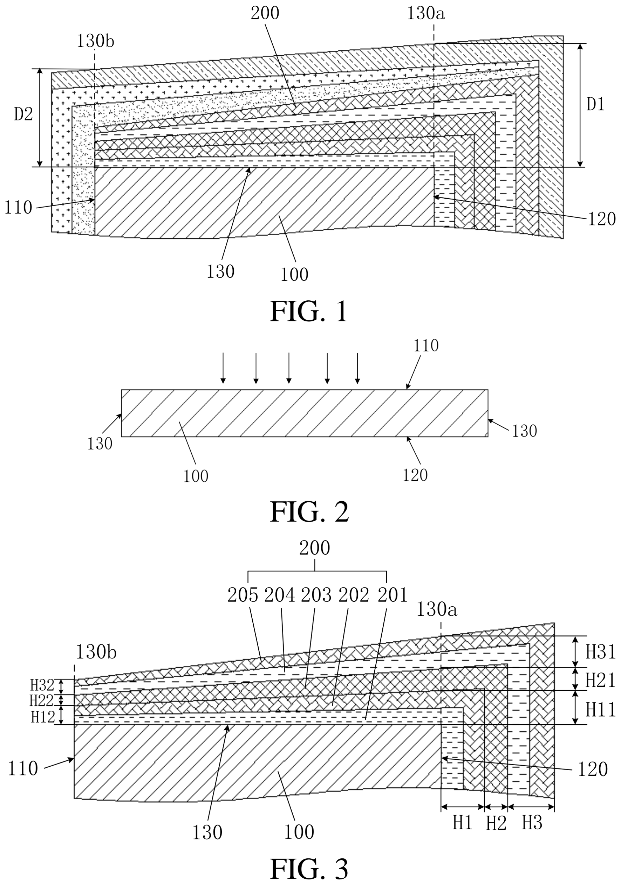

The following describes in detail, with reference to the accompanying drawings and by using specific embodiments and application scenarios thereof, a solar cell and a photovoltaic module provided in the embodiments of the present application. In a first aspect, FIG. 1 is a schematic diagram of a solar cell according to an embodiment of the present application. A solar cell according to some embodiments of the present application includes: a silicon substrate 100. The silicon substrate 100 includes a light-receiving surface 110 and a back surface 120 that are opposite to each other and a side surface 130 arranged between the light-receiving surface 110 and the back surface 120. A protective layer 200 is arranged on the side surface 130. As shown in FIG. 3, the protective layer 200 includes a first conductive layer 202, an insulating layer 203, and a second conductive layer 205 that are arranged in sequence on the side surface 130. A conductivity type of the first conductive layer 202 is opposite to a conductivity type of the second conductive layer 205.

In the embodiments of the present application, the protective layer 200 is arranged on the side surface 130 of the silicon substrate 100, and the protective layer 200 includes the first conductive layer 202, the insulating layer 203, and the second conductive layer 205. Insulating isolation is performed between the first conductive layer 202 and the second conductive layer 205 using the insulating layer 203, so that a conductive layer that is peripherally plated on the side surface 130 of the silicon substrate 100 does not need to be specially removed in a manufacturing procedure of the solar cell, which helps simplify a production process of the solar cell. In addition, the protective layer 200 may be used to achieve passivation and protective effects on the side surface 130 of the silicon substrate 100, so that risks of damage and current leakage that are caused by direct exposure of the side surface 130 of the silicon substrate 100 can be avoided, and carrier recombination on the side surface 130 of the silicon substrate 100 can be reduced, thereby improving the conversion efficiency of the solar cell.

The following describes the structure of the solar cell and the like in some embodiments of the embodiments of the present application with reference to FIG. 1 to FIG. 7.

Specifically, FIG. 2 is a schematic diagram of a silicon substrate according to an embodiment of the present application. The silicon substrate 100 in the solar cell includes a light-receiving surface 110 and a back surface 120 that are opposite to each other and a side surface 130 arranged at a periphery of the silicon substrate 100. The light-receiving surface 110 is a surface of the silicon substrate 100 that receives incident light. The back surface 120 is a surface of the silicon substrate 100 away from the light-receiving surface 110. The side surface 130 connects the light-receiving surface 110 and the back surface 120. Further, the protective layer 200 is arranged on the peripheral side surface 130 of the silicon substrate 100, so that the peripheral side surface 130 of the silicon substrate 100 is blocked and protected by the protective layer 200.

It may be understood that in a manufacturing process of the solar cell, the first conductive layer 202 and the second conductive layer 205 having different conductivity types usually need to be processed on the light-receiving surface 110 and/or the back surface 120 of the silicon substrate 100. In this procedure, a peripherally plated layer is inevitably formed on the side surface 130 of the silicon substrate 100. To avoid a problem of current leakage caused by direct contact and conduction between the first conductive layer 202 and the second conductive layer 205 due to peripheral plating on the side surface 130, in the embodiments of the present application, an insulating layer 203 is arranged between the first conductive layer 202 and the second conductive layer 205 on the side surface 130, to perform insulating isolation on the first conductive layer 202 and the second conductive layer 205. In this way, in a manufacturing process of the solar cell, it is not necessary to specially remove the first conductive layer 202 and the second conductive layer 205 peripherally plated on the side surface 130, so that a problem of current leakage of the side surface 130 caused by peripheral plating can be resolved, and a processing process can be simplified. In addition, the protective layer 200 formed by the insulating layer 203, the first conductive layer 202, and the second conductive layer 205 can further achieve passivation and protective effects on the side surface 130, thereby helping improve the performance of the solar cell.

It needs to be noted that in the embodiments of the present application, the insulating layer 203 arranged on the side surface 130 of the silicon substrate 100 may be separately manufactured in the manufacturing process of the solar cell. Alternatively, based on an existing manufacturing process of a solar cell, in a manufacturing procedure of a film layer structure for the back surface 120 and/or the light-receiving surface 110 of the silicon substrate 100, a corresponding insulating layer 203 is simultaneously formed on the peripheral side surface 130 of the silicon substrate 100. This may be flexibly arranged according to an actual case. This is not limited in the embodiments of the present application.

In some embodiments, the conductivity type of the first conductive layer 202 is opposite to the conductivity type of the second conductive layer 205. One of the first conductive layer 202 and the second conductive layer 205 may be arranged as: an N-type amorphous silicon layer, an N-type microcrystalline silicon layer, a mixed layer of N-type amorphous silicon and microcrystalline silicon, an N-type transition metal compound layer, an N-type polycrystalline silicon layer, or the like. The other of the first conductive layer 202 and the second conductive layer 205 may be arranged as: P-type amorphous silicon, P-type microcrystalline silicon, a mixed layer of P-type amorphous silicon and microcrystalline silicon, a P-type transition metal compound layer, a P-type polycrystalline silicon layer, or the like.

In some embodiments, the insulating layer 203 may be made using a silicon nitride layer, a silicon oxide layer, a silicon oxynitride layer, a silicon carbide layer, or another material. Certainly, the insulating layer 203 may alternatively be made using another material. This is not limited in the embodiments of the present application.

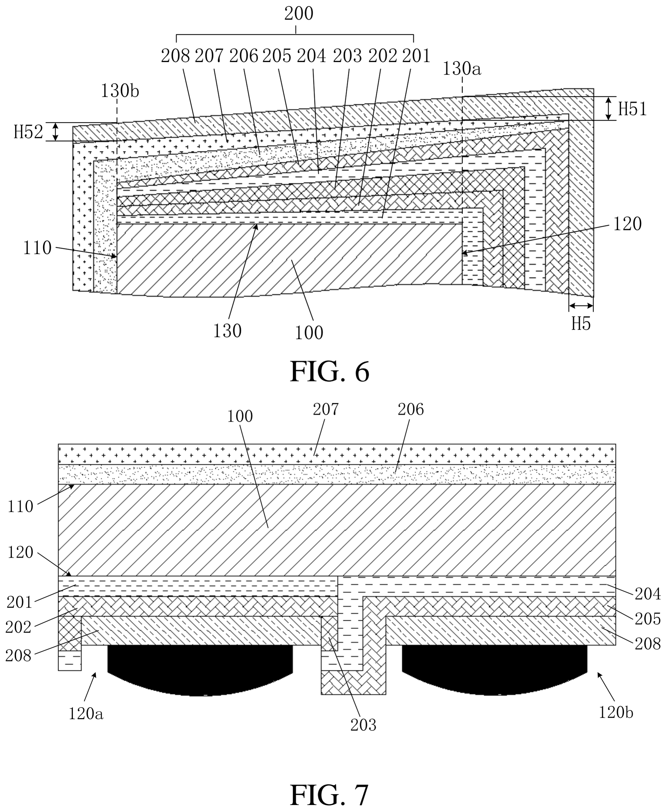

In some embodiments, as shown in FIG. 7, in a direction parallel to the back surface 120, the back surface 120 includes a first region 120a and a second region 120b that are alternately arranged; and the first conductive layer 202 is formed on the first region 120a, and the second conductive layer 205 is formed on the second region 120b.

It may be understood that the structure of the solar cell in the embodiments of the present application may be used in a back contact cell, for example, may be used in an HBC cell. In the back contact cell, a PN junction and a metal gate line are both arranged on the back surface 120 of the solar cell.

In a manufacturing procedure of the back contact cell, the first conductive layer 202 needs to be deposited on the first region 120a of the back surface 120 of the silicon substrate 100, and the second conductive layer 205 needs to be deposited on the second region 120b. In this procedure, the side surface 130 of the silicon substrate 100 may be peripherally plated with both the first conductive layer 202 and the second conductive layer 205. The insulating layer 203 is arranged between the first conductive layer 202 and the second conductive layer 205 on the side surface 130, so that a problem of current leakage caused by direct contact and conduction between the first conductive layer 202 and the second conductive layer 205 on the side surface 130 of the silicon substrate 100 can be avoided. In addition, the protective layer 200 can be used to further achieve passivation and protective effects on the side surface 130.

In a specific application, the insulating layer 203 may be arranged on only the side surface 130 of the silicon substrate 100. The insulating layer 203 may be alternatively arranged on both the side surface 130 and the back surface 120 of the silicon substrate 100. For example, the insulating layer 203 is also arranged between the first region 120a and the second region 120b. This may be flexibly arranged according to an actual case, and is not limited in the present application herein.

In some embodiments, As shown in FIG. 3, the protective layer 200 further includes a first passivation layer 201 located between the side surface 130 of the silicon substrate 100 and the first conductive layer 202 and a second passivation layer 204 located between the insulating layer 203 and the second conductive layer 205; as shown in FIG. 7, in a direction parallel to the back surface 120, the back surface 120 includes a first region 120a and a second region 120b that are alternately arranged; and in a direction away from the silicon substrate 100, the first passivation layer 201 and the first conductive layer 202 are formed in sequence on the first region 120a, and the second passivation layer 204 and the second conductive layer 205 are formed in sequence on the second region 120b; and the insulating layer 203 is arranged between the first region 120a and the second region 120b.

In the embodiments of the present application, the first passivation layer 201 is arranged between the silicon substrate 100 and the first conductive layer 202, and the second passivation layer 204 is arranged between the insulating layer 203 and the second conductive layer 205. While the side surface 130 of the silicon substrate 100 is blocked and protected, a passivation effect of the entire protective layer 200 on the side surface 130 of the silicon substrate 100 can be further improved, thereby improving the conversion efficiency of the solar cell.

In addition, the film layer structure of the side surface 130 of the silicon substrate 100 is arranged to match the film layer structure of the back surface 120 of the silicon substrate 100, so that in a processing process of the solar cell, when the film layer structure is processed and shaped on the back surface 120 of the silicon substrate 100, the corresponding protective layer 200 can be simultaneously formed on the side surface 130 of the silicon substrate 100. In this way, a processing procedure can be simplified, thereby improving processing efficiency.

It may be understood that in the film layer structures of the back surface 120 and the side surface 130 of the silicon substrate 100, film layer structures of the same type may be processed and formed in a single step using a corresponding process. For example, a PECVD process may be used to simultaneously deposit the first passivation layer 201 on the back surface 120 and the side surface 130 of the silicon substrate 100. Correspondingly, a PECVD process may also be used to further deposit the first conductive layer 202 on the surface of the first passivation layer 201. In this way, the first passivation layer 201 and the first conductive layer 202 may be processed simultaneously on the back surface 120 and the side surface 130 of the silicon substrate 100.

FIG. 7 is a partial side cross-sectional view of a solar cell according to an embodiment of the present application. The back surface 120 of the silicon substrate 100 includes the first region 120a and the second region 120b that are alternated. The first passivation layer 201 and the first conductive layer 202 are arranged in sequence on the back surface of the silicon substrate 100 on the first region 120a. The second passivation layer 204 and the second conductive layer 205 are arranged in sequence on the back surface of the silicon substrate 100 on the second region 120b. The insulating layer 203 is arranged between the first region 120a and the second region 120b to perform insulating isolation on the first region 120a and the second region 120b.

In a specific application, a PECVD process or another processing process may be used to sequentially process the first passivation layer 201, the first conductive layer 202, and the insulating layer 203 on the back surface 120 and the peripheral side surface 130 of the silicon substrate 100. Further, a mask layer is arranged on the surface of the insulating layer 203 on the back surface 120 of the silicon substrate 100. The film layer structure on the back surface 120 of the silicon substrate 100 is pattered through photography, laser, etching, or another process to form the first region 120a and the second region 120b on the back surface 120, and remove the first passivation layer 201 and the first conductive layer 202 on the second region 120b. Then, a PECVD process or another processing process is used to process the second passivation layer 204 and the second conductive layer 205 on the second region 120b, and simultaneously, the second passivation layer 204 and the second conductive layer 205 are also formed on the peripheral side surface 130 of the silicon substrate 100.

In this way, the protective layer 200 formed by the peripheral side surface 130 of the silicon substrate 100 may be adapted to the film layer structure of the back surface 120 of the silicon substrate 100, to process the protective layer 200 on the side surface 130 of the silicon substrate 100 without adding a processing step. Therefore, a processing procedure of the solar cell is simplified, and the side surface 130 of the silicon substrate 100 can be blocked and protected.

It needs to be noted that a specific film layer structure on the back surface 120 of the silicon substrate 100 may be arranged according to an actual requirement. This is not limited in the embodiments of the present application herein.

In some other embodiments, the first passivation layer 201 and the second passivation layer 204 may be arranged as: at least one of an amorphous silicon layer, a hydrogenated amorphous silicon layer, a carbon-doped amorphous silicon layer, and an intrinsic amorphous silicon layer.

Certainly, specific structures and manufacturing materials of the first conductive layer 202, the second conductive layer 205, the first passivation layer 201, and the second passivation layer 204 may be flexibly selected according to the structural design of the solar cell. This is not limited in the embodiments of the present application.

In some embodiments, as shown in FIG. 1, a junction between the side surface 130 and the back surface 120 is a first position 130a, a junction between the side surface 130 and the light-receiving surface 110 is a second position 130b, and a thickness of the protective layer 200 at the first position 130a is greater than a thickness of the protective layer 200 at the second position 130b.

In the embodiments of the present application, it is set that the thickness of the protective layer 200 on the side close to the back surface 120 of the silicon substrate 100 is greater than the thickness on the side close to the light-receiving surface 110 of the silicon substrate 100, thereby strengthening a protective effect on the side of the side surface 130 of the silicon substrate 100 close to the back surface 120.

Usually, in a back contact cell, P+ and N+ emitters, a back field, and positive and negative electrodes are all arranged on the back surface 120 of the silicon substrate 100. Therefore, the peripheral side surface 130 of the silicon substrate 100 has a higher risk of current leakage on a side close to the back surface 120. Therefore, in the embodiments of the present application, the thickness of the protective layer 200 of the side surface 130 of the silicon substrate 100 on the side close to the back surface 120 is greater than the thickness of the protective layer 200 on the side close to the light-receiving surface 110, to increase a protective effect of the protective layer 200 on the side of the side surface 130 of the silicon substrate 100 close to the back surface 120.

In some embodiments, as shown in FIG. 1, the thickness of the protective layer 200 at the first position 130a is D1, and the thickness of the protective layer 200 at the second position 130b is D2, satisfying: 1 < D1/D2 ≤ 10, in some embodiments, 2.5 ≤ D1/D2 ≤ 10.

In the embodiments of the present application, a proper value range of a ratio D1/D2 of the thickness D1 of the protective layer 200 of the side surface 130 of the silicon substrate 100 at the first position 130a to the thickness D2 of the protective layer 200 at the second position 130b is set, so that the thicknesses of the protective layer 200 of the side surface 130 of the silicon substrate 100 at different positions are different. In this way, the entire side surface 130 of the silicon substrate 100 can be effectively blocked and protected, and loss of materials required for manufacturing the protective layer 200 can be suitably reduced.

For example, the ratio D1/D2 of the total thickness D1 of the protective layer 200 at the first position 130a to the total thickness D2 of the protective layer 200 at the second position 130b may be set to: any value of 1.5, 2, 2.5, 3, 3.5, 4, 5, 6, 7, 8, 9, 10, and the like or a range between any two of the values.

The thickness of the protective layer 200 located on the side surface 130 of the silicon substrate 100 is a linear distance, in a direction perpendicular to the side surface 130 of the silicon substrate 100, between a side of the protective layer 200 that faces the silicon substrate 100 and a side of the protective layer 200 away from the silicon substrate 100.

In some embodiments, as shown in FIG. 3, a total thickness of the first passivation layer 201 and the first conductive layer 202 on the back surface 120 is H1, a total thickness of the first passivation layer 201 and the first conductive layer 202 located at the first position 130a on the side surface 130 is H11, and a total thickness of the first passivation layer 201 and the first conductive layer 202 located at the second position 130b on the side surface 130 is H12, satisfying: H12 < H11 ≤ H1.

In the embodiments of the present application, the total thickness of the first passivation layer 201 and the first conductive layer 202 located on the side surface 130 of the silicon substrate 100 is set to be less than or equal to the total thickness of the first passivation layer 201 and the first conductive layer 202 located on the back surface 120 of the silicon substrate 100, to reduce loss of materials required for manufacturing the first passivation layer 201 and the first conductive layer 202 while the side surface 130 of the silicon substrate 100 is blocked and protected. In addition, it is set that the total thickness H11 of the first passivation layer 201 and the first conductive layer 202 on the side surface 130 of the silicon substrate 100 at the first position 130a is greater than the total thickness H12 at the second position 130b, thereby strengthening a protective effect on the side of the side surface 130 of the silicon substrate 100 close to the back surface 120.

It may be understood that, in the embodiments of the present application, the first passivation layer 201 on the back surface 120 and the side surface 130 of the silicon substrate 100 may be obtained using a one-step forming process. For example, the first passivation layer 201 may be simultaneously deposited on the back surface 120 and the side surface 130 of the silicon substrate 100 using a PECVD process. Similarly, a one-step forming process may also be used to process the surface of the first passivation layer 201 on the back surface 120 and the side surface 130 of the silicon substrate 100 to obtain the first conductive layer 202, so that the first conductive layer 202 covers the surface of the first passivation layer 201.

It needs to be noted that a manufacturing manner of the first passivation layer 201 and the first conductive layer 202 may use a PECVD process, or use another manufacturing process. This is not limited in the embodiments of the present application.

In some embodiments, a total thickness H11 of the first passivation layer 201 and the first conductive layer 202 located at the first position 130a on the side surface 130 and a total thickness H12 of the first passivation layer 201 and the first conductive layer 202 located at the second position 130b on the side surface 130 satisfy: 0.2 ≤ H12/H11 < 1. A proper value range of H12/H11 is set, so that the first passivation layer 201 and the first conductive layer 202 can be used to block and protect the side surface of the silicon substrate 100, and a protective effect on the side of the side surface 130 of the silicon substrate 100 close to the back surface 120 is enhanced.

Specifically, a ratio H12/H11 of a total thickness H12 of the first passivation layer 201 and the first conductive layer 202 on the side surface 130 at the second position 130b to a total thickness H11 at the first position 130a may be set to: any value of 0.2, 0.3, 0.4, 0.5, 0.6, 0.7, 0.8, 0.9, 0.95, and the like or a range between any two of the values.

In some embodiments, as shown in FIG. 3, a total thickness H1 of the first passivation layer 201 and the first conductive layer 202 on the back surface 120 and a total thickness H11 of the first passivation layer 201 and the first conductive layer 202 located at the first position 130a on the side surface 130 satisfy: 0.5 ≤ H11/H1 ≤ 1.

In the embodiments of the present application, a proper value range of the ratio H11/H1 of the total thickness H11 of the first passivation layer 201 and the first conductive layer 202 at the first position 130a on the side surface 130 of the silicon substrate 100 to the total thickness H1 of the first passivation layer 201 and the first conductive layer 202 on the back surface 120 of the silicon substrate 100 is set, so that structures of the first passivation layer 201 and the first conductive layer 202 on the side surface 130 of the silicon substrate 100 may be properly set based on structures of the first passivation layer 201 and the first conductive layer 202 on the back surface 120 of the silicon substrate 100, to achieve passivation and protective effects on the side surface 130 of the silicon substrate 100, thereby reducing carrier recombination on the side surface 130, and loss of materials for manufacturing the first passivation layer 201 and the first conductive layer 202 can be further reduced, thereby reducing production costs.

For example, the ratio H11/H1 of the total thickness H11 of the first passivation layer 201 and the first conductive layer 202 located at the first position 130a on the side surface 130 to the total thickness H1 of the first passivation layer 201 and the first conductive layer 202 on the back surface 120 may be set to: any value of 0.5, 0.55, 0.6, 0.65, 0.7, 0.75, 0.8, 0.85, 0.9, 0.95, and 1, and the like or a range between any two of the values.

In some embodiments, as shown in FIG. 3, a total thickness H1 of the first passivation layer 201 and the first conductive layer 202 on the back surface 120 and a total thickness H12 of the first passivation layer 201 and the first conductive layer 202 located at the second position 130b on the side surface 130 satisfy: 0.2 ≤ H12/H1 ≤ 0.6.

In the embodiments of the present application, a proper value range of the ratio H12/H1 of the total thickness H12 of the first passivation layer 201 and the first conductive layer 202 at the second position 130b on the side surface 130 of the silicon substrate 100 to the total thickness H1 of the first passivation layer 201 and the first conductive layer 202 on the back surface 120 of the silicon substrate 100 is set, so that structures of the first passivation layer 201 and the first conductive layer 202 on the side surface 130 of the silicon substrate 100 may be properly set based on structures of the first passivation layer 201 and the first conductive layer 202 on the back surface 120 of the silicon substrate 100, to achieve passivation and protective effects on the side surface 130 of the silicon substrate 100, and loss of materials for manufacturing the first passivation layer 201 and the first conductive layer 202 can be further reduced, thereby reducing production costs.

For example, the ratio H12/H1 of the total thickness H12 of the first passivation layer 201 and the first conductive layer 202 located at the second position 130b on the side surface 130 to the total thickness H1 of the first passivation layer 201 and the first conductive layer 202 on the back surface 120 may be set to: any value of 0.2, 0.25, 0.3, 0.35, 0.4, 0.45, 0.5, 0.55, 0.6, and the like or a range between any two of the values.

It needs to be noted that the total thickness H1 of the first passivation layer 201 and the first conductive layer 202 on the back surface 120 of the silicon substrate 100 is a total thickness of the first passivation layer 201 and the first conductive layer 202 located on the back surface 120 of the silicon substrate 100 in a direction perpendicular to the back surface 120. The total thickness of the first passivation layer 201 and the first conductive layer 202 on the side surface 130 of the silicon substrate 100 is a total thickness of the first passivation layer 201 and the first conductive layer 202 located on the side surface 130 of the silicon substrate 100 in a direction perpendicular to the side surface 130.

In some embodiments, as shown in FIG. 3, a thickness of the insulating layer 203 on the back surface 120 is H2, a thickness of the insulating layer 203 located at the first position 130a on the side surface 130 is H21, and a thickness of the insulating layer 203 located at the second position 130b on the side surface 130 is H22, satisfying: H22 < H21 ≤ H2.

In the embodiments of the present application, the thickness of the insulating layer 203 located on the side surface 130 of the silicon substrate 100 is set to be less than or equal to the thickness of the insulating layer 203 located on the back surface 120 of the silicon substrate 100, to reduce loss of materials for manufacturing the insulating layer 203 while the side surface 130 of the silicon substrate 100 is blocked and protected using the insulating layer 203. In addition, it is set that the thickness H21 of the insulating layer 203 on the side surface 130 of the silicon substrate 100 at the first position 130a is greater than the thickness H22 at the second position 130b, thereby strengthening a protective effect on the side of the side surface 130 of the silicon substrate 100 close to the back surface 120.

It may be understood that, in the embodiments of the present application, the insulating layer 203 on the back surface 120 and the side surface 130 of the silicon substrate 100 may be obtained using a one-step forming process. For example, the insulating layer 203 may be simultaneously deposited on the back surface 120 and the side surface 130 of the silicon substrate 100 using a PECVD process. It needs to be noted that a specific manufacturing manner of the insulating layer 203 may be flexibly set according to an actual case. This is not limited in the embodiments of the present application.

In some embodiments, a thickness H21 of the insulating layer 203 located at the first position 130a on the side surface 130 and a thickness H22 of the insulating layer 203 located at the second position 130b on the side surface 130 satisfy: 0.2 ≤ H22/H21 < 1.

In the embodiments of the present application, a proper value range of H22/H21 is set, so that the insulating layer 203 is used to provide an insulating isolation effect between the first conductive layer 202 and the second conductive layer 205 on the side surface 130, and the insulating layer 203, the first conductive layer 202, and the second conductive layer 205 further form the protective layer to block and protect the side surface 130 of the silicon substrate 100. In addition, a protective effect on the side of the side surface 130 of the silicon substrate 100 close to the back surface 120 can be strengthened.

Specifically, a ratio H22/H21 of a thickness H22 of the insulating layer 203 on the side surface 130 at the second position 130b to a thickness H21 at the first position 130a may be set to: any value of 0.2, 0.3, 0.4, 0.5, 0.6, 0.7, 0.8, 0.9, 0.95, and the like or a range between any two of the values.

In some embodiments, as shown in FIG. 3, a thickness H2 of the insulating layer 203 on the back surface 120 and a thickness H21 of the insulating layer 203 located at the first position 130a on the side surface 130 satisfy: 0.5 ≤ H211H2 ≤ 1.

In the embodiments of the present application, a proper value range of the ratio H21/H2 of the thickness H21 of the insulating layer 203 at the first position 130a on the side surface 130 of the silicon substrate 100 to the thickness H2 of the insulating layer 203 on the back surface 120 of the silicon substrate 100 is set, so that the structure of the insulating layer 203 on the side surface 130 of the silicon substrate 100 can be properly arranged based on the structure of the insulating layer 203 on the back surface 120 of the silicon substrate 100, thereby facilitating actual processing and forming. In addition, the insulating layer 203, the first conductive layer 202, and the second conductive layer 205 form the protective layer 200 to achieve blocking and protective effects on the side surface 130 of the silicon substrate 100. Moreover, loss of materials required for manufacturing the insulating layer 203 can be reduced and production costs can be reduced.

For example, the ratio H21/H2 of the thickness H21 of the insulating layer 203 located at the first position 130a on the side surface 130 to the thickness H2 of the insulating layer 203 on the back surface 120 may be set to: any value of 0.5, 0.55, 0.6, 0.65, 0.7, 0.75, 0.8, 0.85, 0.9, 0.95, 1, and the like or a range between any two of the values.

In some embodiments, as shown in FIG. 3, a thickness H2 of the insulating layer 203 on the back surface 120 and a total thickness H22 of the insulating layer 203 located at the second position 130b on the side surface 130 satisfy: 0.2 ≤ H22/H2 ≤ 0.6.

In the embodiments of the present application, a proper value range of the ratio H22/H2 of the thickness H22 of the insulating layer 203 at the second position 130b on the side surface 130 of the silicon substrate 100 to the thickness H2 of the insulating layer 203 on the back surface 120 of the silicon substrate 100 is set, so that the structure of the insulating layer 203 on the side surface 130 of the silicon substrate 100 can be properly arranged based on the structure of the insulating layer 203 on the back surface 120 of the silicon substrate 100, thereby facilitating actual processing and forming. In addition, the insulating layer 203, the first conductive layer 202, and the second conductive layer 205 form the protective layer 200 to achieve blocking and protective effects on the side surface 130 of the silicon substrate 100. Moreover, loss of materials required for manufacturing the insulating layer 203 can be reduced and production costs can be reduced.

For example, the ratio H22/H2 of the total thickness H22 of the insulating layer 203 located at the second position 130b on the side surface 130 to the thickness H2 of the insulating layer 203 on the back surface 120 may be set to: any value of 0.2, 0.25, 0.3, 0.35, 0.4, 0.45, 0.5, 0.55, 0.6, and the like or a range between any two of the values.

It needs to be noted that the thickness H2 of the insulating layer 203 on the back surface 120 of the silicon substrate 100 is a thickness of the insulating layer 203 located on the back surface 120 in a direction perpendicular to the back surface 120. The thickness of the insulating layer 203 on the side surface 130 of the silicon substrate 100 is a thickness dimension of the insulating layer 203 located on the side surface 130 in a direction perpendicular to the side surface 130.

In some embodiments, as shown in FIG. 3, a total thickness of the second passivation layer 204 and the second conductive layer 205 on the back surface 120 is H3, a total thickness of the second passivation layer 204 and the second conductive layer 205 located at the first position 130a on the side surface 130 is H31, and a total thickness of the second passivation layer 204 and the second conductive layer 205 located at the second position 130b on the side surface 130 is H32, satisfying: H32 < H31 ≤ H3.

In the embodiments of the present application, the total thickness of the second passivation layer 204 and the second conductive layer 205 located on the side surface 130 of the silicon substrate 100 is set to be less than or equal to the total thickness of the second passivation layer 204 and the second conductive layer 205 located on the back surface 120 of the silicon substrate 100, to reduce loss of materials for manufacturing the second passivation layer 204 and the second conductive layer 205 while the side surface 130 of the silicon substrate 100 is blocked and protected. In addition, it is set that the total thickness H31 of the second passivation layer 204 and the second conductive layer 205 on the side surface 130 of the silicon substrate 100 at the first position 130a is greater than the total thickness H32 at the second position 130b, thereby strengthening a protective effect on the side of the side surface 130 of the silicon substrate 100 close to the back surface 120.

It may be understood that, in the embodiments of the present application, the second passivation layer 204 on the back surface 120 and the side surface 130 of the silicon substrate 100 may be obtained using a one-step forming process. For example, the second passivation layer 204 may be first simultaneously deposited on the back surface 120 and the side surface 130 of the silicon substrate 100 using a PECVD process. Similarly, a one-step forming process may also be used to further process the surface of the second passivation layer 204 to obtain the second conductive layer 205, so that the second conductive layer 205 covers the surface of the second passivation layer 204.

It needs to be noted that a manufacturing manner of the second passivation layer 204 and the second conductive layer 205 may use a PECVD process, or use another manufacturing process. This is not limited in the embodiments of the present application.

In some embodiments, a total thickness H31 of the second passivation layer 204 and the second conductive layer 205 located at the first position 130a on the side surface 130 and a total thickness H32 of the second passivation layer 204 and the second conductive layer 205 located at the second position 130b on the side surface 130 satisfy: 0.2 ≤ H32/H31 < 1. A proper value range of H32/H31 is set, so that the second passivation layer 204 and the second conductive layer 205 can be used to passivate and protect the side surface 130 of the silicon substrate 100, and a protective effect on the side of the side surface 130 of the silicon substrate 100 close to the back surface 120 is enhanced.

Specifically, a ratio H32/H31 of a total thickness H32 of the second passivation layer 204 and the second conductive layer 205 on the side surface 130 at the second position 130b to a total thickness H31 at the first position 130a may be set to: any value of 0.2, 0.3, 0.4, 0.5, 0.6, 0.7, 0.8, 0.9, 0.95, and the like or a range between any two of the values. In some embodiments, as shown in FIG. 3, a total thickness H3 of the second passivation layer 204 and the second conductive layer 205 on the back surface 120 and a total thickness H31 of the second passivation layer 204 and the second conductive layer 205 located at the first position 130a on the side surface 130 satisfy: 0.5 ≤ H311H3 ≤ 1.

In the embodiments of the present application, a proper value range of the ratio H31/H3 of the total thickness H31 of the second passivation layer 204 and the second conductive layer 205 at the first position 130a on the side surface 130 of the silicon substrate 100 to the total thickness H3 of the second passivation layer 204 and the second conductive layer 205 on the back surface 120 is set, so that structures of the second passivation layer 204 and the second conductive layer 205 on the side surface 130 of the silicon substrate 100 can be properly arranged based on structures of the second passivation layer 204 and the second conductive layer 205 on the back surface 120 of the silicon substrate 100, to achieve passivation and protective effects on the side surface 130 of the silicon substrate 100, and loss of materials for manufacturing the second passivation layer 204 and the second conductive layer 205 can be further reduced, thereby reducing production costs.

For example, the ratio H31/H3 of the total thickness H31 of the second passivation layer 204 and the second conductive layer 205 located at the first position 130a on the side surface 130 to the total thickness H3 of the second passivation layer 204 and the second conductive layer 205 on the back surface 120 may be set to: any value of 0.5, 0.55, 0.6, 0.65, 0.7, 0.75, 0.8, 0.85, 0.9, 0.95, 1, and the like or a range between any two of the values.

In some embodiments, as shown in FIG. 3, a total thickness H3 of the second passivation layer 204 and the second conductive layer 205 on the back surface 120 and a total thickness H32 of the second passivation layer 204 and the second conductive layer 205 located at the second position 130b on the side surface 130 satisfy: 0.2 ≤ H32/H3 ≤ 0.6.

In the embodiments of the present application, a proper value range of the ratio H32/H3 of the total thickness H32 of the second passivation layer 204 and the second conductive layer 205 at the second position 130b on the side surface 130 of the silicon substrate 100 to the total thickness H3 of the second passivation layer 204 and the second conductive layer 205 on the back surface 120 of the silicon substrate 100 is set, so that structures of the second passivation layer 204 and the second conductive layer 205 on the side surface 130 of the silicon substrate 100 can be properly arranged based on structures of the second passivation layer 204 and the second conductive layer 205 on the back surface 120 of the silicon substrate 100, to achieve passivation and protective effects on the side surface 130 of the silicon substrate 100, and loss of materials for manufacturing the second passivation layer 204 and the second conductive layer 205 can be further reduced, thereby reducing production costs.

For example, the ratio of the total thickness H32 of the second passivation layer 204 and the second conductive layer 205 located at the second position 130b on the side surface 130 to the total thickness H3 of the second passivation layer 204 and the second conductive layer 205 on the back surface 120 may be set to: any value of 0.2, 0.25, 0.3, 0.35, 0.4, 0.45, 0.5, 0.55, 0.6, and the like or a range between any two of the values.

It needs to be noted that the total thickness H3 of the second passivation layer 204 and the second conductive layer 205 on the back surface 120 of the silicon substrate 100 is a total thickness of the second passivation layer 204 and the second conductive layer 205 located on the back surface 120 in a direction perpendicular to the back surface 120. The total thickness of the second passivation layer 204 and the second conductive layer 205 on the side surface 130 of the silicon substrate 100 is a total thickness of the second passivation layer 204 and the second conductive layer 205 located on the side surface 130 in a direction perpendicular to the side surface 130.

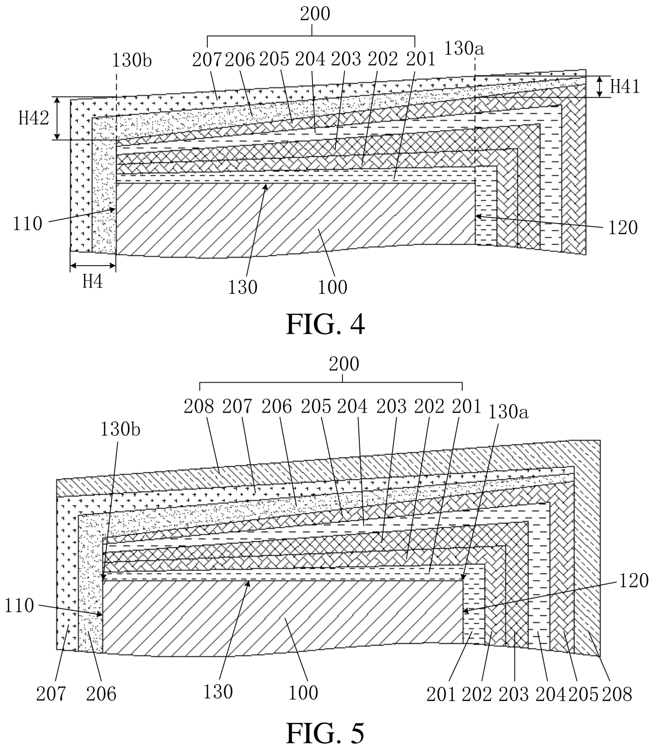

In some embodiments, FIG. 4 is a schematic diagram of an edge of another solar cell according to an embodiment of the present application. The protective layer 200 further includes a third passivation layer 206 and an anti-reflection layer 207, the third passivation layer 206 is arranged on a side of the second conductive layer 205 away from the side surface 130, and the anti-reflection layer 207 is arranged on a side of the third passivation layer 206 away from the second conductive layer 205; and in the direction away from the silicon substrate 100, the third passivation layer 206 and the anti-reflection layer 207 are formed in sequence on the light-receiving surface 110.

In the embodiments of the present application, the third passivation layer 206 and the anti-reflection layer 207 are arranged on both the light-receiving surface 110 and the side surface 130 of the silicon substrate 100, so that the third passivation layer 206 and the anti-reflection layer 207 are correspondingly formed on the side surface 130 of the silicon substrate 100 while a structural design requirement of the light-receiving surface 110 of the silicon substrate 100 is met, thereby improving blocking and protective effects on the side surface 130 of the silicon substrate 100.

It may be understood that the third passivation layer 206 on the light-receiving surface 110 and the side surface 130 of the silicon substrate 100 may be processed by using a one-step forming process. For example, the third passivation layer 206 may be simultaneously formed by depositing on the light-receiving surface 110 and the side surface 130 of the silicon substrate 100 by using a PECVD process. Similarly, a one-step forming process may also be used to finish the surface of the third passivation layer 206 on the light-receiving surface 110 and the side surface 130 of the silicon substrate 100 to obtain the anti-reflection layer 207, so that the anti-reflection layer 207 covers the surface of the third passivation layer 206.

In some embodiments, the third passivation layer 206 may be arranged as: at least one of an amorphous silicon layer, a hydrogenated amorphous silicon layer, a carbon-doped amorphous silicon layer, or an intrinsic amorphous silicon layer. The anti-reflection layer 207 may be made using one or more of silicon oxide, titanium oxide, silicon nitride, and silicon carbide.

It needs to be noted that manufacturing materials and specific manufacturing processes of the third passivation layer 206 and the anti-reflection layer 207 may be flexibly set according to an actual requirement. This is not limited in the embodiments of the present application.

In some embodiments, as shown in FIG. 4, a total thickness of the third passivation layer 206 and the anti-reflection layer 207 on the light-receiving surface 110 is H4, a total thickness of the third passivation layer 206 and the anti-reflection layer 207 located at the first position 130a on the side surface 130 is H41, and a total thickness of the third passivation layer 206 and the anti-reflection layer 207 located at the second position 130b on the side surface 130 is H42, satisfying: H41 < H42 ≤ H4.

In the embodiments of the present application, it is set that the total thickness of the third passivation layer 206 and the anti-reflection layer 207 located on the side surface 130 of the silicon substrate 100 is less than or equal to the total thickness of the third passivation layer 206 and the anti-reflection layer 207 located on the light-receiving surface 110 of the silicon substrate 100, so that the third passivation layer 206 and the anti-reflection layer 207 may be used to block and protect the side surface 130 of the silicon substrate 100 without affecting the conversion efficiency of the solar cell. In addition, the third passivation layer 206 and the anti-reflection layer 207 are arranged on the side surface 130 of the silicon substrate 100, and the total thickness H42 at the second position 130b is greater than the total thickness H41 at the first position 130a, so that the third passivation layer 206 and the anti-reflection layer 207 form gentle transition in size at a junction region at the edge of the light-receiving surface 110 and the side surface 130 of the silicon substrate 100, thereby improving a protective effect on the edge of the silicon substrate 100.

In some embodiments, a total thickness H41 of the third passivation layer 206 and the anti-reflection layer 207 located at the first position 130a on the side surface 130 and a total thickness H42 of the third passivation layer 206 and the anti-reflection layer 207 located at the second position 130b on the side surface 130 satisfy: 0.1 ≤ H42/H41 < 1. A proper value range of H42/H41 is set, so that the third passivation layer 206 and the anti-reflection layer 207 are used to block and protect the side surface 130 of the silicon substrate 100, and moreover, actual processing and forming are facilitated.

Specifically, the ratio H42/H41 of the total thickness H42 of the third passivation layer 206 and the anti-reflection layer 207 on the side surface 130 at the second position 130b to the total thickness H41 at the first position 130a may be set to: any value of 0.1, 0.2, 0.3, 0.4, 0.5, 0.6, 0.7, 0.8, 0.9, 0.95, and the like or a range between any two of the values.

In some embodiments, as shown in FIG. 4, the total thickness H4 of the third passivation layer 206 and the anti-reflection layer 207 on the light-receiving surface 110 and the total thickness H41 of the third passivation layer 206 and the anti-reflection layer 207 located at the first position 130a on the side surface 130 satisfy: 0.1 ≤ H41/H4 ≤ 0.4.

In the embodiments of the present application, a proper value range of the ratio H41/H4 of the total thickness H41 of the third passivation layer 206 and the anti-reflection layer 207 at the first position 130a on the side surface 130 of the silicon substrate 100 to the total thickness H4 of the third passivation layer 206 and the anti-reflection layer 207 on the light-receiving surface 110 of the silicon substrate 100 is set, so that structures of the third passivation layer 206 and the anti-reflection layer 207 on the side surface 130 of the silicon substrate 100 can be properly arranged based on structures of the third passivation layer 206 and the anti-reflection layer 207 on the light-receiving surface 110 of the silicon substrate 100. Further, the third passivation layer 206 and the anti-reflection layer 207 are used to achieve further blocking and protective effects on the side surface 130 of the silicon substrate 100, and loss of materials for manufacturing the third passivation layer 206 and the anti-reflection layer 207 can be further reduced, thereby reducing production costs.

For example, the ratio of the total thickness H41 of the third passivation layer 206 and the anti-reflection layer 207 located at the first position 130a on the side surface 130 to the total thickness H4 of the third passivation layer 206 and the anti-reflection layer 207 on the light-receiving surface 110 may be set to: any value of 0.1, 0.15, 0.2, 0.25, 0.3, 0.35, 0.4, and the like or a range between any two of the values.

In some embodiments, as shown in FIG. 4, the total thickness H4 of the third passivation layer 206 and the anti-reflection layer 207 on the light-receiving surface 110 and the total thickness H42 of the third passivation layer 206 and the anti-reflection layer 207 located at the second position 130b on the side surface 130 satisfy: 0.5 ≤ H42/H4 ≤ 0.8.

In the embodiments of the present application, a proper value range of the ratio H42/H4 of the total thickness H42 of the third passivation layer 206 and the anti-reflection layer 207 at the second position 130b on the side surface 130 of the silicon substrate 100 to the total thickness H4 of the third passivation layer 206 and the anti-reflection layer 207 on the light-receiving surface 110 of the silicon substrate 100 is set, so that structures of the third passivation layer 206 and the anti-reflection layer 207 on the side surface 130 of the silicon substrate 100 can be properly arranged based on structures of the third passivation layer 206 and the anti-reflection layer 207 on the light-receiving surface 110 of the silicon substrate 100. Further, the third passivation layer 206 and the anti-reflection layer 207 are used to achieve further blocking and protective effects on the side surface 130 of the silicon substrate 100, and loss of materials for manufacturing the third passivation layer 206 and the anti-reflection layer 207 can be further reduced, thereby reducing production costs.

For example, the ratio H42/H4 of the total thickness H42 of the third passivation layer 206 and the anti-reflection layer 207 located at the second position 130b on the side surface 130 to the total thickness H4 of the third passivation layer 206 and the anti-reflection layer 207 on the light-receiving surface 110 may be set to: any value of 0.5, 0.55, 0.6, 0.65, 0.7, 0.75, 0.8, and the like or a range between any two of the values.

It needs to be noted that the total thickness H4 of the third passivation layer 206 and the anti-reflection layer 207 on the light-receiving surface 110 of the silicon substrate 100 is a total thickness of the third passivation layer 206 and the anti-reflection layer 207 located on the light-receiving surface 110 in a direction perpendicular to the light-receiving surface 110. The total thickness of the third passivation layer 206 and the anti-reflection layer 207 on the side surface 130 of the silicon substrate 100 is a total thickness of the third passivation layer 206 and the anti-reflection layer 207 on the side surface 130 in a direction perpendicular to the side surface 130.

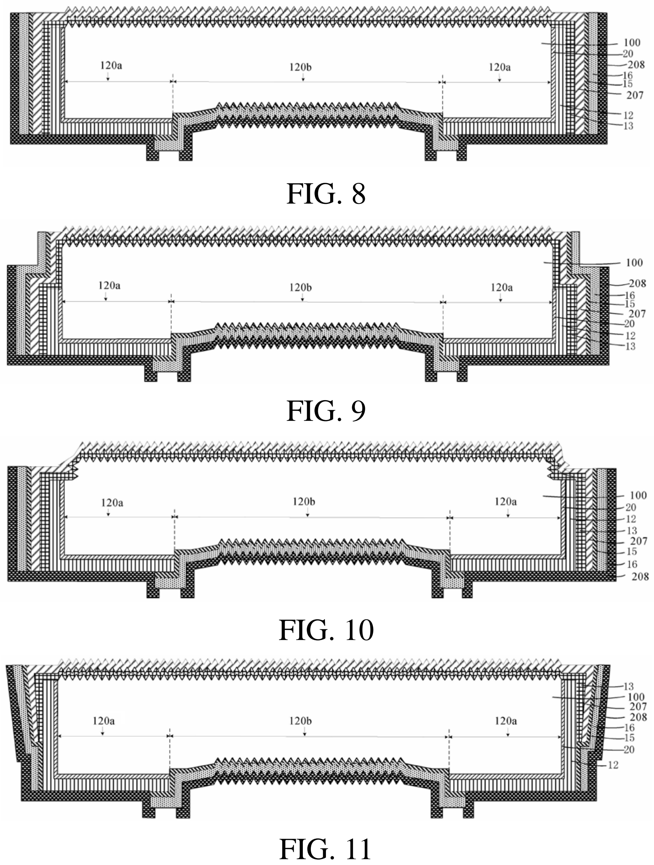

In some embodiments, FIG. 7 and FIG. 8 are schematic diagrams of a structure of an edge of yet another solar cell. The protective layer 200 further includes: a transparent conductive layer 208, where the transparent conductive layer 208 is arranged on a side of the anti-reflection layer 207 away from the side surface 130; and the transparent conductive layer 208 is arranged on at least one of the first region 120a and the second region 120b, and the transparent conductive layer 208 is arranged on a side of the first conductive layer 202 and/or the second conductive layer 205 away from the back surface 120.

In the embodiments of the present application, the transparent conductive layer 208 is arranged on both the back surface 120 and the side surface 130 of the silicon substrate 100, so that the transparent conductive layer 208 is correspondingly formed on the side surface 130 of the silicon substrate 100 while a structural design requirement of the back surface 120 of the silicon substrate 100 is met, thereby further improving blocking and protective effects on the side surface 130 of the silicon substrate 100.

The transparent conductive layer 208 on the back surface 120 and the side surface 130 of the silicon substrate 100 may be manufactured using a same process. For example, a PECVD process may be used to simultaneously deposit the transparent conductive layer 208 on the back surface 120 and the side surface 130 of the silicon substrate 100. Certainly, another processing process may be alternatively used to manufacture the transparent conductive layer 208, which is not limited in the embodiments of the present application.

For example, the transparent conductive layer 208 may be made using indium tin oxide, a conductive polymer, fluorine-doped tin dioxide, aluminum-doped zinc oxide, or another material, or may be made using another type of transparent conductive material, which may be flexibly selected according to an actual requirement. This is not limited in the embodiments of the present application.

In some embodiments, as shown in FIG. 6, a thickness of the transparent conductive layer 208 located on the back surface 120 is H5, a thickness of the transparent conductive layer 208 located at the first position 130a on the side surface 130 is H51, and a thickness of the transparent conductive layer 208 located at the second position 130b on the side surface 130 is H52, satisfying: H52 < H51 ≤ H5.

In the embodiments of the present application, it is set that the thickness of the transparent conductive layer 208 located on the side surface 130 of the silicon substrate 100 is less than or equal to the thickness of the transparent conductive layer 208 located on the back surface 120 of the silicon substrate 100, so that the transparent conductive layer 208 may be used to block and protect the side surface 130 of the silicon substrate 100 without affecting the conversion efficiency of the solar cell. In addition, it is set that the thickness H51 of the transparent conductive layer 208 on the side surface 130 of the silicon substrate 100 at the first position 130a is greater than the thickness H52 at the second position 130b, thereby strengthening a protective effect on the side of the side surface 130 of the silicon substrate 100 close to the back surface 120. In addition, the transparent conductive layer 208 forms a gentle transition in size at a junction region between the edge of the back surface 120 and the side surface 130, thereby improving a protective effect on the edge of the silicon substrate 100.

In some embodiments, a thickness H51 of the transparent conductive layer 208 located at the first position 130a on the side surface 130 and a thickness H52 of the transparent conductive layer 208 located at the second position 130b on the side surface 130 satisfy: 0.3 ≤ H52/H51 < 1. The ratio of H52/H51 is set, so that the transparent conductive layer 208 is used to block and protect the side surface 130 of the silicon substrate 100, and moreover, actual processing and forming are facilitated.

Specifically, the ratio H52/H51 of the thickness H52 of the transparent conductive layer 208 on the side surface 130 at the second position 130b to the thickness H51 at the first position 130a may be set to: any value of 0.3, 0.4, 0.5, 0.6, 0.7, 0.8, 0.9, 0.95, and the like or a range between any two of the values.

In some embodiments, as shown in FIG. 6, a thickness H5 of the transparent conductive layer 208 on the back surface 120 and a thickness H51 of the transparent conductive layer 208 located at the first position 130a on the side surface 130 satisfy: 0.5 ≤ H51/H5 ≤ 1.

In the embodiments of the present application, a proper value range of the ratio H51/H5 of the thickness H51 of the transparent conductive layer 208 at the first position 130a on the side surface 130 of the silicon substrate 100 to the thickness H5 of the transparent conductive layer 208 on the back surface 120 of the silicon substrate 100 is set, so that the structure of the transparent conductive layer 208 on the side surface 130 of the silicon substrate 100 can be properly arranged based on the structure of the transparent conductive layer 208 on the back surface 120 of the silicon substrate 100. Further, the transparent conductive layer 208 can be used to further block and protect the side surface 130 of the silicon substrate 100, and loss of materials for manufacturing the transparent conductive layer 208 can also be reduced, thereby reducing production costs.

For example, the ratio H51/H5 of the thickness H51 of the transparent conductive layer 208 located at the first position 130a on the side surface 130 to the thickness H5 of the transparent conductive layer 208 on the back surface 120 may be set to: any value of 0.5, 0.55, 0.6, 0.65, 0.7, 0.75, 0.8, 0.85, 0.9, 0.95, and 1, and the like or a range between any two of the values.

In some embodiments, as shown in FIG. 6, a thickness H5 of the transparent conductive layer 208 on the back surface 120 and a thickness H52 of the transparent conductive layer 208 located at the second position 130b on the side surface 130 satisfy: 0.2 ≤ H52/H5 ≤ 0.5.

In the embodiments of the present application, a proper value range of the ratio H52/H5 of the thickness H52 of the transparent conductive layer 208 at the second position 130b on the side surface 130 of the silicon substrate 100 to the thickness H5 of the transparent conductive layer 208 on the back surface 120 of the silicon substrate 100 is set, so that the structure of the transparent conductive layer 208 on the side surface 130 of the silicon substrate 100 can be properly arranged based on the structure of the transparent conductive layer 208 on the back surface 120 of the silicon substrate 100. Further, the transparent conductive layer 208 can be used to block and protect the side surface 130 of the silicon substrate 100, and loss of materials for manufacturing the transparent conductive layer 208 can also be reduced, thereby reducing production costs.

For example, the ratio H52/H5 of the thickness H52 of the transparent conductive layer 208 located at the second position 130b on the side surface 130 to the thickness H5 of the transparent conductive layer 208 on the back surface 120 may be set to: any value of 0.2, 0.25, 0.3, 0.35, 0.4, 0.45, 0.5, and the like or a range between any two of the values.

In some embodiments, the first region and the second region on the back surface 120 of the silicon substrate 100 are further respectively provided with an electrode. For a specific structure of the electrode, refer to related technologies, and details are not described herein again in the embodiments of the present application.

In some embodiments, a manufacturing procedure of the solar cell in the embodiments of the present application includes:
Step 1: Polish and clean the silicon substrate 100, where the silicon substrate 100 includes the light-receiving surface 110 and the back surface 120 and the side surface 130 arranged between the light-receiving surface 110 and the back surface 120, and the back surface 120 includes the first region 120a and the second region 120b that are alternately arranged.
Step 2: Sequentially deposit the first passivation layer 201, the first conductive layer 202, and the insulating layer 203 on the entire back surface 120 and the side surface 130 of the silicon substrate 100. A thickness range of the first passivation layer 201 is 4 to 200 nm, a thickness range of the first conductive layer 202 is 4 to 300 nm, and a thickness range of the insulating layer 203 is 30 to 300 nm. PECVD, LPCVD, or another process may be used as a deposition manner, which is not limited herein.
Step 3: Remove the insulating layer 203 on the second region 120b in the back surface 120 of the silicon substrate 100 using a laser to form an opening. The wavelength of the used laser may be 355 nm, 532 nm, 1064 nm, or the like.
Step 4: Perform etching using an alkaline solution to remove the first passivation layer 201 and the first conductive layer 202 at the opening and expose the silicon substrate 100 in the second region 120b; and simultaneously perform texturing and cleaning on the silicon substrate 100 at the opening and the light-receiving surface 110 of the silicon substrate 100. The used alkaline etching liquid may be an NaOH solution, a KOH solution, or another alkaline solution.
Step 5: Sequentially deposit the second passivation layer 204 and the second conductive layer 205 on the entire back surface 120 of the silicon substrate 100 and the side surface 130. A thickness range of the second passivation layer 204 is 4 to 200 nm, and a thickness range of the second conductive layer 205 is 5 to 300 nm. PECVD, LPCVD, or another process may be used as a deposition manner, which is not limited herein.
Step 6: Remove, using a laser, the second passivation layer 204 and the second conductive layer 205 that cover the first region 120a. The wavelength of the used laser may be 355 nm, 532 nm, 1064 nm, or the like.
Step 7: Etch the insulating layer 203 on the first region 120a using a wet process.
Step 8: Sequentially deposit the third passivation layer 206 and the anti-reflection layer 207 on the light-receiving surface 110 and the side surface 130 of the silicon substrate 100. A thickness range of the third passivation layer 206 is 4 to 200 nm, and a thickness of the anti-reflection layer 207 is 5 to 300 nm. PECVD, LPCVD, or another process may be used as a deposition manner, which is not limited herein.
Step 9: Deposit the transparent conductive layer in the first region 120a and the second region 120b of the back surface 120 of the silicon substrate 100. A thickness range of the transparent conductive layer is 10 to 300 nm, and PVD, RPD, or another process may be used as a deposition manner.
Step 10: Manufacture metal electrodes in the first region 120a and the second region 120b using a screen printing process.

In some other examples, with reference to the foregoing manufacturing process, process parameters in the manufacturing procedure are adjusted to control a thickness of the film layer structure deposited on the side surface 130 of the silicon substrate 100, to manufacture solar cells of different structures and perform performance tests such as an open-circuit voltage test, a short-circuit current test, and a conversion efficiency test on the corresponding solar cells.

In Comparative Example 1, the film layer structure is only deposited on the back surface 120 and the light-receiving surface 110 of the silicon substrate 100, and a peripherally plated layer that exists on the side surface 130 of the silicon substrate 100 in a manufacturing procedure is removed to expose the side surface 130 of the silicon substrate 100. In Example 1 to Example 3 and Comparative Example 2 to Comparative Example 4, while the film layers are formed on the back surface 120 and the light-receiving surface 110 of the silicon substrate 100, a corresponding film layer structure is formed on the side surface 130 of the silicon substrate 100. A difference lies in that the film layer structure formed on the side surface 130 of the silicon substrate 100 has a different total thickness.

In addition, for ease of comparison and analysis, other groups of test data are scaled proportionally using the results of the performance data of Comparative Example 1 as a basis. Specific test results are shown in Table 1.

**Table 1**

| Group | D1 (nm) | D2 (nm) | D1/D2 | Conversion efficiency | Open-circuit voltage | Short-circuit current |
|---|---|---|---|---|---|---|
| Comparative Example 1 | 0 | 0 | 0 | 1 | 1 | 1 |
| Comparative Example 2 | 600 | 40 | 15 | 0.9998 | 0.9997 | 0.9999 |
| Comparative Example 3 | 600 | 30 | 20 | 0.9996 | 0.9995 | 0.9999 |
| Comparative Example 4 | 600 | 20 | 30 | 0.9995 | 0.9994 | 0.9996 |
| Example 1 | 600 | 240 | 2.5 | 1.001 | 1.001 | 1.001 |
| Example 2 | 600 | 120 | 5 | 1.001 | 1.0009 | 1.0008 |
| Example 3 | 600 | 60 | 10 | 1.0009 | 1.0009 | 1.0006 |

It can be seen from the test data in Table 1 that, compared with that the side surface 130 of the silicon substrate 100 is directly exposed to the outside, a corresponding film layer structure is formed on the side surface 130 of the silicon substrate 100, blocking and protective effects can be achieved on the side surface 130 of the silicon substrate 100, thereby avoiding risks of damage and current leakage of the side surface 130 of the silicon substrate 100. In addition, when the film layer structure is formed on the side surface 130, the thickness of the film layer structure on the side surface 130 of the silicon substrate 100 is properly set, so that a passivation effect can be achieved on the side surface 130 of the silicon substrate 100, thereby reducing carrier recombination on the side surface 130 and improving the performance of the solar cell.

Further, the thickness D1 of the film layer structure on the side surface 130 of the silicon substrate 100 at the first position 130a (i.e., the side close to the back surface 120) and the thickness D2 of the film layer structure at the second position 130b (i.e., the side close to the light-receiving surface 110) are controlled to be within particular ranges to passivate and protect the side surface 130 of the silicon substrate 100, thereby reducing carrier recombination on the side surface 130. Because the thickness of the protective layer 200 on the side surface 130 usually does not exceed a sum of the thicknesses of the film layer of the back surface 120 and the film layer of the light-receiving surface 110, that is, the thickness of the protective layer 200 on the side surface 130 is within a relatively fixed range. If the ratio of D1/D2 is excessively large, the value of D1 is excessively small, and it is difficult to reliably block and protect a part of the side surface 130 of the silicon substrate 100 close to the light-receiving surface 110, and a passivation effect on the part of the side surface 130 close to the light-receiving surface 110 is poor, resulting in degraded overall performance of the solar cell.

Therefore, in the embodiments of the present application, a range of the ratio of the thickness D1 of the protective layer 200 on the side surface 130 at the first position 130a to the thickness D2 of the protective layer 200 at the second position 130b is set to: 1 < D1/D2 ≤ 10. In this way, a protective effect on the side surface 130 of the silicon substrate 100 can be improved, and the performance of the solar cell can be properly improved.

The following describes the structure of the solar cell and the like in some other embodiments of the first aspect of the present application with reference to FIG. 8 to FIG. 14.

In the solar cell shown in FIG. 8 to FIG. 14, the solar cell is a back contact cell. The first conductive layer 202 is a first doped silicon layer 12, the second conductive layer 205 is a second doped silicon layer 16, and the insulating layer 203 includes a surface passivation layer 13 and an anti-reflection layer 207.

As shown in FIG. 8, the back contact cell provided in the embodiments of the present application includes: a silicon substrate 100, a first interface passivation layer 20, the first doped silicon layer 12, the surface passivation layer 13, the anti-reflection layer 207, an intrinsic silicon layer 15, the second doped silicon layer 16, and a transparent conductive layer 208. The silicon substrate 100 includes a back surface and a light-receiving surface that are oppositely arranged, and a side surface connecting the back surface and the light-receiving surface. In a direction away from the side surface, the first interface passivation layer 20, the first doped silicon layer 12, the surface passivation layer 13, the anti-reflection layer 207, the intrinsic silicon layer 15, the second doped silicon layer 16, and the transparent conductive layer 208 are arranged in sequence on the side surface. A conductivity type of the first doped silicon layer 12 is opposite to a conductivity type of the second doped silicon layer 16. In a thickness direction of the silicon substrate 100, the surface passivation layer 13 and the anti-reflection layer 207 are further arranged in sequence on the light-receiving surface, and the surface passivation layer 13 and the anti-reflection layer 207 extend from the light-receiving surface to the side surface.

It may be understood that in this part, the first interface passivation layer 20 may also be referred to as the foregoing first passivation layer 201, the intrinsic silicon layer 15 may also be referred to as the foregoing second passivation layer 204, and "in a direction away from the side surface" is also "in a direction away from the silicon substrate".

In the case of employing the foregoing technical solution, as shown in FIG. 8, the first interface passivation layer 20, the first doped silicon layer 12, the surface passivation layer 13, the anti-reflection layer 207, the intrinsic silicon layer 15, the second doped silicon layer 16, and the transparent conductive layer 208 are arranged in sequence on the side surface of the silicon substrate 100 in the direction away from the side surface. The presence of the foregoing film layers can isolate the side surface of the silicon substrate 100 from the external environment, and reduce a risk of damage problems such as scratching caused to the side surface of the silicon substrate 100 by factors such as crushing and collision after transfer or encapsulation. In addition, a risk that water and the like enter the solar cell from the side surface of the solar cell to cause a failure of the solar cell can also be reduced, thereby improving the service life of the back contact cell. In addition, the surface passivation layer 13 and the anti-reflection layer 207 are located on the light-receiving surface of the silicon substrate 100 and also extend to the side surface of the silicon substrate 100. In this case, on the side surface of the silicon substrate 100, the first doped silicon layer 12 and the second doped silicon layer 16 that have opposite conductivity types may be isolated by the surface passivation layer 13 and the anti-reflection layer 207, to prevent conduction and current leakage between the first doped silicon layer 12 and the second doped silicon layer 16, thereby reducing the forward current leakage loss, so that the back contact cell has high conversion efficiency. In addition, the parts of the surface passivation layer 13 and the anti-reflection layer 207 that are arranged on the light-receiving surface can reduce carrier recombination and a surface reflectance, and then the surface passivation layer 13 and the anti-reflection layer 207 extend to the side surface of the silicon substrate 100, and can further be used to isolate the first doped silicon layer 12 and the second doped silicon layer 16 without additionally forming another insulating layer using another deposition step to prevent current leakage between the first doped silicon layer 12 and the second doped silicon layer 16. In this way, a manufacturing procedure of the back contact cell can be simplified, and compatibility between a film layer isolating the first doped silicon layer 12 and the second doped silicon layer 16 and another structure in the back contact cell also does not need to be considered, thereby ensuring a high yield of the back contact cell. In addition, the first interface passivation layer 20 and the first doped silicon layer 12 arranged on the side surface of the silicon substrate 100 have a passivation effect on the silicon substrate 100, and the surface passivation layer 13 that implements insulating isolation between the first doped silicon layer 12 and the second doped silicon layer 16 of the side surface can also passivate the side surface of the silicon substrate 100, thereby further reducing a carrier recombination rate on the side surface of the silicon substrate 100 and improving the conversion efficiency of the back contact cell.

In addition, it should be noted that in an actual manufacturing procedure, a sequence of forming corresponding film layers arranged on the back surface and the light-receiving surface of the silicon substrate affects a sequence of forming corresponding film layers on the side surface of the silicon substrate. Because the sequence of forming the film layers on the back surface and the light-receiving surface of the silicon substrate is closely related to a process, a solar cell structure, a device, and the like, the sequence of forming the film layers on the back surface and the light-receiving surface of the silicon substrate cannot be randomly adjusted, that is, the sequence of the film layers formed on the side surface of the silicon substrate cannot be randomly adjusted, and a requirement on a sequence of forming the film layers on the side surface of the silicon substrate, a technical problem to be resolved, a requirement on a sequence of forming film layers on front and back surfaces, a technical problem to be resolved, and the like need to be considered comprehensively.

In an actual application process, a conductivity type of the silicon substrate is not specifically limited in the embodiments of the present application. The conductivity type of the silicon substrate may be an N type, or may be a P type, or may be an intrinsic type.

In the foregoing case, as shown in FIG. 8, the first interface passivation layer 20, the first doped silicon layer 12, the intrinsic silicon layer 15, the second doped silicon layer 16, and the transparent conductive layer 208 included in the back contact cell are arranged on the side surface of the silicon substrate 100 and also arranged on the back surface of the silicon substrate 100. Specifically, on a side of the back surface of the silicon substrate 100, the transparent conductive layer 208 covers a side of the first doped silicon layer 12 and the second doped silicon layer 16 away from the silicon substrate 100, and a through isolation channel is provided in the transparent conductive layer 208 to disconnect a part of the transparent conductive layer 208 that corresponds to the first doped silicon layer 12 from a part of the transparent conductive layer 208 that corresponds to the second doped silicon layer 16, thereby preventing a short circuit. The distribution of the first interface passivation layer 20, the first doped silicon layer 12, the intrinsic silicon layer 15, and the second doped silicon layer 16 on the side of the back surface of the silicon substrate 100 may be set according to an actual requirement, and is not specifically limited herein.

For example, the back surface may include a first region and a second region that do not overlap. The first interface passivation layer and the first doped silicon layer are arranged on the first region, and the intrinsic silicon layer and the second doped silicon layer are arranged in sequence to form a stack on the second region in a direction away from the silicon substrate. In this case, distribution ranges of the first region and the second region on the back surface may be respectively determined based on the distribution of the first doped silicon layer and the second doped silicon layer on the back surface in an actual application scenario.

For example, the back surface may include a first region and a second region that are spaced apart and a third region located between the first region and the second region. The first interface passivation layer and the first doped silicon layer are arranged on the first region, and the intrinsic silicon layer and the second doped silicon layer are arranged in sequence to form a stack on the second region in a direction away from the silicon substrate. In this case, distribution ranges of the first region and the second region on the back surface may be respectively determined based on the distribution of the first doped silicon layer and the second doped silicon layer on the back surface in an actual application scenario. The third region is a region on the back surface on which the first doped silicon layer and the second doped silicon layer are not arranged.

For example, as shown in FIG. 8, the back surface includes a first region 120a and a second region 120b that are spaced apart. The first interface passivation layer 20 and the first doped silicon layer 12 are arranged on the first region 120a. The intrinsic silicon layer 15 and the second doped silicon layer 16 are arranged on the second region 120b, extend from the second region 120b to the first region 120a, and cover a part of the first interface passivation layer 20 and the first doped silicon layer 12. In this case, on the back surface of the silicon substrate 100, the intrinsic silicon layer 15 and the second doped silicon layer 16 are arranged in sequence to form a stack on the second region 120b in the thickness direction of the silicon substrate 100, and also cover parts of the first interface passivation layer 20 and the first doped silicon layer 12. In this case, forming ranges of the intrinsic silicon layer 15 and the second doped silicon layer 16 on the side of the back surface of the silicon substrate 100 is large, which helps reduce an etching range of the intrinsic silicon layer 15 and the second doped silicon layer 16 that are arranged on the whole layer in a manufacturing procedure, thereby helping improve the production capacity of etching. In addition, the parts of the intrinsic silicon layer 15 and the second doped silicon layer 16 covering the first doped silicon layer 12 can protect an edge of the first doped silicon layer 12, to prevent an etchant from affecting the edge of the first doped silicon layer 12, thereby ensuring high carrier collection efficiency at the edge of the first doped silicon layer 12. In addition, no isolation channel is provided between the first interface passivation layer 20 and a second interface passivation layer and between the first doped silicon layer and the second doped silicon layer. Therefore, contact areas of the first interface passivation layer and the first doped silicon layer 12 with the silicon substrate 100 and contact areas of the intrinsic silicon layer 15 and the second doped silicon layer 16 with the silicon substrate 100 can be maximized, so that the utilization rate of the silicon substrate 100 can be improved, and the photoelectric conversion efficiency can be further improved. Specifically, in this case, a distribution range of the first region 120a on the back surface may be determined based on the distribution of the first doped silicon layer 12 on the back surface in an actual application scenario. A distribution range of the second region 120b on the back surface may be determined based on the distribution of a part of the second doped silicon layer 16 that does not overlap the first doped silicon layer 12 in an actual application scenario.

Regarding the surface topography of the silicon substrate, the light-receiving surface of the silicon substrate may be a polished surface, or may be a textured surface. When the light-receiving surface of the silicon substrate is a textured surface, a light trapping effect of the light-receiving surface can be improved, thereby further improving the conversion efficiency of the back contact cell. Next, the back surface of the silicon substrate may be a polished surface. Alternatively, in the back surface of the silicon substrate, surfaces of regions corresponding to the first interface passivation layer and the first doped silicon layer may be polished surfaces, and surfaces in contact with the intrinsic silicon layer and the second doped silicon layer may be textured surfaces. In this case, after at least the parts of the first interface passivation layer and the first doped silicon layer that cover the regions corresponding to the intrinsic silicon layer and the second doped silicon layer in the back surface are removed, while texturing is performed on the light-receiving surface, texturing is also performed on the surfaces of the regions corresponding to the intrinsic silicon layer and the second doped silicon layer in the back surface, to enlarge a contact area between the second doped silicon layer and the transparent conductive layer, thereby reducing contact loss between the second doped silicon layer and the transparent conductive layer.

In addition, the topography of the side surface of the silicon substrate may be determined based on forming ranges of the first interface passivation layer and the first doped silicon layer on the side surface of the silicon substrate and an actual manufacturing procedure, which is not specifically limited herein. In an actual application procedure, as shown in FIG. 8, the first interface passivation layer 20 and the first doped silicon layer 12 that are arranged on the side surface cover all regions of the side surface. Alternatively, as shown in FIG. 9, the first interface passivation layer 20 and the first doped silicon layer 12 that are arranged on the side surface may be located on a local region of the side surface and close to the back surface. In this case, it may be understood that, in an actual manufacturing procedure, during the forming of the first doped silicon layer 12 on the back surface and the side surface of the silicon substrate 100, the first doped silicon layer 12 may be peripherally plated on the light-receiving surface. Parasitic absorption exists in the first doped silicon layer 12 located on the light-receiving surface and needs to be removed, thereby improving the utilization rate of light by the silicon substrate. Based on this, when the first interface passivation layer 20 and the first doped silicon layer 12 that are arranged on the side surface are located on a local region of the side surface, a manufacturing condition does not need to be strictly controlled to keep all the first doped silicon layer 12 formed on the side surface in a procedure of removing the first interface passivation layer 20 and the first doped silicon layer 12 that are peripherally plated on the light-receiving surface, thereby reducing the manufacturing difficulty of the back contact cell.

As shown in FIG. 8, when the first interface passivation layer 20 and the first doped silicon layer 12 that are arranged on the side surface cover all regions of the side surface, regions of the parts of the side surface of the silicon substrate 100 may have approximately the same surface reflectance and/or surface topography. In this case, the surfaces of the regions of the side surface of the silicon substrate 100 may all be polished surfaces, textured surfaces, or other topography.

For example, as shown in FIG. 10, when the first interface passivation layer 20 and the first doped silicon layer 12 that are arranged on the side surface are located on a local region of the side surface and close to the back surface, a surface reflectance of the region in the side surface that is not covered by the first doped silicon layer 12 may be less than a surface reflectance of the region in the side surface covered by the first interface passivation layer 20 and the first doped silicon layer 12. In this case, although a passivation effect of the surface of the region in the side surface of the silicon substrate 100 that is not covered by the first interface passivation layer 20 and the first doped silicon layer 12 is relatively low, the surface of the region has a relatively high light trapping effect, which is beneficial to refracting more light from the side of the side surface of the silicon substrate 100 close to the light-receiving surface into the silicon substrate 100, thereby improving the conversion efficiency of the back contact cell.

When the surface reflectance of the region in the side surface that is not covered by the first interface passivation layer and the first doped silicon layer is less than the surface reflectance of the region in the side surface that is covered by the first interface passivation layer and the first doped silicon layer, the surface topography of the region in the side surface that is not covered by the first interface passivation layer and the first doped silicon layer may be the same as the surface topography of the region in the side surface that is covered by the first interface passivation layer and the first doped silicon layer, and the size of the texture structure of the surface of the region in the side surface that is not covered by the first interface passivation layer and the first doped silicon layer is different from the size of the texture structure of the surface of the region in the side surface that is covered by the first interface passivation layer and the first doped silicon layer.

For example, the surface of the region in the side surface that is not covered by the first interface passivation layer and the first doped silicon layer and the surface of the region in the side surface that is covered by the first interface passivation layer and the first doped silicon layer may each have a pedestal-like texture structure, and a side length of the pedestal-like texture structure of the surface of the region in the side surface that is not covered by the first interface passivation layer and the first doped silicon layer is less than a side length of the pedestal-like texture structure of the surface of the region in the side surface that is covered by the first interface passivation layer and the first doped silicon layer, and/or a height of the pedestal-like texture structure of the surface of the region in the side surface that is not covered by the first interface passivation layer and the first doped silicon layer is greater than a height of the pedestal-like texture structure of the surface of the region in the side surface that is covered by the first interface passivation layer and the first doped silicon layer.

For another example, the surface of the region in the side surface that is not covered by the first interface passivation layer and the first doped silicon layer and the surface of the region in the side surface that is covered by the first interface passivation layer and the first doped silicon layer may each have a pyramid texture structure, and a side length (a diagonal, or a height) of the pyramid texture structure of the surface of the region in the side surface that is not covered by the first interface passivation layer and the first doped silicon layer is greater than a side length (a diagonal, or a height) of the pyramid texture structure of the surface of the region in the side surface that is covered by the first interface passivation layer and the first doped silicon layer.

Alternatively, when the surface reflectance of the region in the side surface that is not covered by the first interface passivation layer and the first doped silicon layer is less than the surface reflectance of the region in the side surface that is covered by the first interface passivation layer and the first doped silicon layer, the surface topography of the region in the side surface that is not covered by the first interface passivation layer and the first doped silicon layer may also be different from the surface topography of the region in the side surface that is covered by the first interface passivation layer and the first doped silicon layer. In this case, the surface topography of the two regions on the side surface may be determined based on a magnitude relationship between reflectances and an actual manufacturing procedure, which is not specifically limited herein.

For example, as shown in FIG. 10, a surface of a region in the side surface that is not covered by the first interface passivation layer 20 and the first doped silicon layer 12 may be a textured surface. In this case, the surface of the region in the side surface that is not covered by the first interface passivation layer 20 and the first doped silicon layer 12 has a relatively high light trapping effect, which is beneficial to refracting more light into the silicon substrate 100 from a side in the side surface of the silicon substrate 100 close to the light-receiving surface, thereby improving the conversion efficiency of the back contact cell.

For example, as shown in FIG. 10, a surface of a region in the side surface that is covered by the first interface passivation layer 20 and the first doped silicon layer 12 is a polished surface. In this case, the surface of the region in the side surface that is covered by the first interface passivation layer 20 and the first doped silicon layer 12 is flat, which facilitates the formation of the first interface passivation layer 20 and the first doped silicon layer 12 that are thick on the region, thereby enhancing a passivation effect of the first interface passivation layer 20 and the first doped silicon layer 12 on a corresponding region of the side surface, and further improving the conversion efficiency of the back contact cell.

For the first doped silicon layer, in terms of arrangement of substances, a phase of the first doped silicon layer may be an amorphous phase, a microcrystalline phase, a nanocrystalline phase, a monocrystalline phase, a polycrystalline phase, or the like. A specific phase of the first doped silicon layer may be determined based on a type of the first interface passivation layer. The first interface passivation layer may be a tunnel passivated layer, for example, a tunnel oxide layer. In this case, the first doped silicon layer is a doped crystalline silicon layer, and a material of the doped crystalline silicon layer may include polycrystalline silicon and/or monocrystalline silicon. Alternatively, the first interface passivation layer may be an intrinsic silicon passivation layer, for example, an intrinsic amorphous silicon layer. In this case, a material of the first interface passivation layer and the first doped silicon layer may include at least one of amorphous silicon, nanocrystalline silicon, and microcrystalline silicon.

It should be noted that, when the first interface passivation layer is the tunnel passivated layer and the first doped silicon layer is the doped crystalline silicon layer, the first interface passivation layer has higher film layer density, and therefore the first interface passivation layer has a further improved passivation effect on the silicon substrate, so that surface defects of the silicon substrate can be further reduced, thereby improving the conversion efficiency of the back contact cell.

In terms of thickness, as shown in FIG. 8, the thickness of each part of the first doped silicon layer 12 may be the same. As shown in FIG. 9, alternatively, the thickness of the first doped silicon layer 12 arranged on the side of the back surface is greater than the thickness of the first doped silicon layer 12 arranged on the side surface. When the thickness of each part of the first doped silicon layer 12 is the same, it is beneficial to endowing each part of the first doped silicon layer 12 with a high passivation effect, so that each region of the silicon substrate 100 that corresponds to the first doped silicon layer 12 has a relatively low carrier recombination rate, thereby further improving the conversion efficiency of the back contact cell.

A specific thickness of the first doped silicon layer may be determined based on an actual requirement and a material of the first doped silicon layer. This is not specifically limited herein. For example, the thickness of the first doped silicon layer may be greater than or equal to 30 nm and less than or equal to 140 nm. For example, the thickness of the first doped silicon layer may be 30 nm, 40 nm, 50 nm, 60 nm, 80 nm, 100 nm, 120 nm, 130 nm, 140 nm, or the like. With such an arrangement, the presence of the transparent conductive layer can improve carrier collection efficiency, and leave a margin for thinning the first doped silicon layer. In other words, the thickness of the first doped silicon layer can be suitably reduced due to the presence of the transparent conductive layer without reducing the carrier collection efficiency. Based on this, when the thickness of the first doped silicon layer is within the foregoing range, the first doped silicon layer has a relatively small thickness, which helps reduce the parasitic absorption of the first doped silicon layer, thereby further improving the working efficiency of the back contact cell. In addition, a time period for depositing the first doped silicon layer can also be reduced, thereby improving the manufacturing efficiency of the first doped silicon layer. In addition, the thickness of the first doped silicon layer should not be excessively small, to avoid affecting collection of carriers.

For the first interface passivation layer, as shown in FIG. 8, a thickness of each part of the first interface passivation layer 20 may be the same. Alternatively, a thickness of the first interface passivation layer arranged on a side of the back surface is greater than a thickness of the first interface passivation layer arranged on the side surface. When the thickness of each part of the first interface passivation layer is the same, it is beneficial to endowing each part of the first interface passivation layer 20 with a high passivation effect, so that each region of the silicon substrate 100 that corresponds to the first interface passivation layer 20 has a relatively low carrier recombination rate, thereby further improving the conversion efficiency of the back contact cell.

A specific thickness of the first interface passivation layer may be determined based on an actual requirement and a material of the first interface passivation layer. This is not specifically limited herein.

In addition, in a case that in the side surface of the silicon substrate, a surface of a region on which the first interface passivation layer and the first doped silicon layer are arranged has a pedestal-like texture structure, the thickness of the first interface passivation layer located on a bottom surface of the pedestal-like texture structure may be equal to the thickness of the first interface passivation layer located on a side wall of the pedestal-like texture structure. In this case, the first interface passivation layer has a high passivation effect on both the bottom surface and the side wall of the pedestal-like texture structure.

Alternatively, the thickness of the first interface passivation layer located on the bottom surface of the pedestal-like texture structure may be less than the thickness of the first interface passivation layer located on the side wall of the pedestal-like texture structure. In this case, it may be understood that the bottom surface of the pedestal-like texture structure and the side surface of the pedestal-like texture structure have different crystallographic directions. Specifically, the bottom surface of the pedestal-like texture structure is a [110] crystallographic direction, and a quantity of dangling bonds on a surface of the [110] crystallographic direction is relatively small; and the side surface of the pedestal-like texture structure is a [111] crystallographic direction, and a quantity of dangling bonds of the [111] crystallographic direction is relatively large. Based on this, when the thickness of the first interface passivation layer that is located on the bottom surface of the pedestal-like texture structure is less than the thickness of the first interface passivation layer that is located on the side wall of the pedestal-like texture structure, it is beneficial to enable a part with the thickness of the first interface passivation layer that is located on the side wall of the pedestal-like texture structure to have a relatively high passivation effect, thereby meeting a requirement of the side surface of the pedestal-like texture structure for a high passivation effect, reducing a carrier recombination rate of the side surface of the pedestal-like texture structure, and further improving the working efficiency of the back contact cell.

The thickness of the first interface passivation layer located on the bottom surface of the pedestal-like texture structure and the thickness of the first interface passivation layer located on the side wall of the pedestal-like texture structure may be determined based on requirements for passivation effects of the pedestal-like texture structure on different regions and an actual manufacturing procedure. This is not specifically limited herein.

For example, the thickness of the first interface passivation layer located on the bottom surface of the pedestal-like texture structure may be greater than or equal to 0.5 nm and less than or equal to 1.5 nm. For example, the thickness of the first interface passivation layer located on the bottom surface of the pedestal-like texture structure may be 0.5 nm, 0.6 nm, 0.8 nm, 1 nm, 1.2 nm, 1.3 nm, 1.5 nm, or the like. In this case, the thickness of the first interface passivation layer located on the bottom surface of the pedestal-like texture structure is within the foregoing range, which helps prevent the part from having a low passivation effect on the silicon substrate because the thickness of the first interface passivation layer located on the bottom surface of the pedestal-like texture structure is small, and reduces the carrier recombination rate on the side surface of the pedestal-like texture structure.

For example, the thickness of the first interface passivation layer located on the side wall of the pedestal-like texture structure may be greater than or equal to 0.5 nm and less than or equal to 2 nm. For example, the thickness of the first interface passivation layer located on the side wall of the pedestal-like texture structure may be 0.5 nm, 0.8 nm, 1 nm, 1.2 nm, 1.5 nm, 1.8 nm, 2 nm, or the like. In this case, the thickness of the first interface passivation layer located on the side wall of the pedestal-like texture structure is within the foregoing range, which helps prevent a low passivation effect of the part because the thickness of the part is small, and reduces the carrier recombination rate on the side surface of the pedestal-like texture structure.

Regarding forming ranges of the first interface passivation layer and the first doped silicon layer on the side surface of the silicon substrate, as described above, the first interface passivation layer and the first doped silicon layer that are arranged on the side surface may cover all regions of the side surface. Alternatively, the first interface passivation layer and the first doped silicon layer that are arranged on the side surface may be located only on a local region of the side surface and close to the back surface. In this case, extension ranges of the first interface passivation layer and the first doped silicon layer on the side surface may be set according to an actual manufacturing procedure and an actual requirement, and are not specifically limited herein.

For example, as shown in FIG. 10, in the thickness direction of the silicon substrate 100, a ratio of a maximum extension length of the first interface passivation layer 20 and the first doped silicon layer 12 on the side surface to a thickness of the silicon substrate 100 may be greater than or equal to 70%. For example, the ratio of the maximum extension length of the first interface passivation layer 20 and the first doped silicon layer 12 on the side surface to the thickness of the silicon substrate 100 may be 70%, 75%, 80%, 85%, 90%, 95%, 98%, or the like. In this case, as described above, the first interface passivation layer 20 and the first doped silicon layer 12 have a passivation effect on the side surface of the silicon substrate 100. Therefore, when the ratios of the maximum extension lengths of the first interface passivation layer 20 and the first doped silicon layer 12 on the side surface to the thickness of the silicon substrate 100 are greater than or equal to 70%, it is ensured that the first interface passivation layer 20 and the first doped silicon layer 12 have large forming ranges on the side surface of the silicon substrate 100, so that surfaces of more regions on the side surface have low carrier recombination rates, thereby further improving the conversion efficiency of the back contact cell. In addition, most regions of the side surface of the silicon substrate 100 are covered by the first interface passivation layer 20 and the first doped silicon layer 12. In this case, the first interface passivation layer 20 and the first doped silicon layer 12 have a protective effect on most regions of the side surface of the silicon substrate 100, and as water and the like are prevented from intruding, it is ensured that the side surface of the silicon substrate 100 is protected by the stack of layers with a large thickness, thereby further improving a protective effect of the side surface of the silicon substrate 100.

For example, in a case that the first interface passivation layer and the first doped silicon layer that are arranged on the side surface are located only on a local region of the side surface and close to the back surface, the surface of the region in the side surface that is not covered by the first interface passivation layer and the first doped silicon layer is a textured surface, and the ratio of the maximum extension length of the textured surface on the side surface to the thickness of the silicon substrate may be less than or equal to 30%. For example, the ratio of the maximum extension length of the textured surface on the side surface to the thickness of the silicon substrate may be 1%, 5%, 10%, 15%, 20%, 25%, 30%, or the like. For an application principle of a beneficial effect in this case, refer to the application principle of the beneficial effect of that the ratios of the maximum extension lengths of the first interface passivation layer and the first doped silicon layer on the side surface to the thickness of the silicon substrate are greater than or equal to 70%, and details are not described herein again.

For the surface passivation layer and the anti-reflection layer, materials of the surface passivation layer and the anti-reflection layer are not specifically limited in the embodiments of the present application, provided that the materials can be used in the back contact cell provided in the embodiments of the present application.

For example, the material of the surface passivation layer may include at least one of aluminum oxide, intrinsic amorphous silicon, or doped silicate glass. A conductivity type of the doped silicate glass is the same as or opposite to a conductivity type of the first doped silicon layer. Specifically, the material of the surface passivation layer may include only aluminum oxide, intrinsic amorphous silicon, or doped silicate glass. Alternatively, the material of the surface passivation layer may include any two of aluminum oxide, intrinsic amorphous silicon, and doped silicate glass. Alternatively, the material of the surface passivation layer may include all aluminum oxide, intrinsic amorphous silicon, and doped silicate glass. Specifically, when the surface passivation layer includes at least two materials, the distribution of the different materials may be determined based on an actual requirement and an actual manufacturing procedure, and this is not specifically limited herein. In this case, the aluminum oxide and the intrinsic amorphous silicon contain hydrogen, and when the material of the surface passivation layer includes aluminum oxide and/or intrinsic amorphous silicon, hydrogen passivation may be performed on the silicon substrate and the first doped silicon layer, thereby further improving a passivation effect of the surface passivation layer. The doped silicate glass is doped with an impurity of a corresponding conductivity type, and field passivation may further be performed on the silicon substrate and the first doped silicon layer, so that the passivation effect of the surface passivation layer can be further be improved. Next, a manufacturing procedure of the surface passivation layer made of doped silicate glass is simple, which helps reduce manufacturing difficulty of the back contact cell.

For example, a material of the anti-reflection layer may include silicon nitride and/or silicon oxynitride.

Regarding forming ranges of the surface passivation layer and the anti-reflection layer on the side surface of the silicon substrate, as shown in FIG. 8 to FIG. 10, in a thickness direction of the silicon substrate 100, the surface passivation layer 13 and the anti-reflection layer 207 may cover various regions on the side surface of the silicon substrate 100, that is, cover the entire side surface. Alternatively, as shown in FIG. 11, the surface passivation layer 13 and the anti-reflection layer 207 that are arranged on the side surface may be located on a local region of the side surface and close to the light-receiving surface. In this case, it may be understood that in an actual manufacturing procedure, when the surface passivation layer 13 and the anti-reflection layer 207 are formed on the light-receiving surface and the side surface of the silicon substrate 100, to ensure that the surface passivation layer 13 and the anti-reflection layer 207 with large coverage are formed on the side surface, the surface passivation layer 13 and the anti-reflection layer 207 may be peripherally plated on the side of the back surface. The surface passivation layer 13 and the anti-reflection layer 207 on the back surface affect carrier collection effects of the subsequently formed intrinsic silicon layer 15 and second doped silicon layer 16. Therefore, the surface passivation layer 13 and the anti-reflection layer 207 on the back surface need to be removed. Based on this, when the surface passivation layer 13 and the anti-reflection layer 207 that are arranged on the side surface are located on a local region of the side surface, it is not necessary to strictly control a manufacturing condition to keep both the surface passivation layer 13 and the anti-reflection layer 207 on the side surface in a procedure of removing the surface passivation layer 13 and the anti-reflection layer 207 that are peripherally plated on the back surface, thereby reducing the manufacturing difficulty of the back contact cell.

Specifically, it may be understood that larger extension lengths of the surface passivation layer and the anti-reflection layer on the side surface indicate a surface passivation layer and an anti-reflection layer with a larger formation range to isolate the first doped silicon layer and the second doped silicon layer on the side surface of the silicon substrate. Lower forward current leakage of the back contact cell indicates a larger protective range on the side surface of the silicon substrate by the surface passivation layer and the anti-reflection layer. However, smaller extension lengths of the surface passivation layer and the anti-reflection layer on the side surface indicate a larger range of a reverse current leakage region formed between the first doped silicon layer and the second doped silicon layer on the side surface of the silicon substrate and a lower hot spot risk of the back contact cell. Based on this, extension ranges of the surface passivation layer and the anti-reflection layer on the side surface may be determined based on forward current leakage loss, the protection of the side surface, a hot spot risk, and an actual manufacturing procedure of the back contact cell in an actual application scenario. This is not specifically limited herein.

For example, in a thickness direction of the silicon substrate, ratios of maximum extension lengths of the surface passivation layer and the anti-reflection layer on the side surface to the thickness of the silicon substrate may be less than or equal to 80%. For example, the ratios of the maximum extension lengths of the surface passivation layer and the anti-reflection layer on the side surface to the thickness of the silicon substrate may be 5%, 10%, 15%, 20%, 30%, 40%, 50%, 60%, 70%, 80%, or the like. In this case, difficulty in removing the parts of the surface passivation layer and the anti-reflection layer that are peripherally plated on the back surface can be reduced, and manufacturing precision requirements can be reduced. In addition, at the region in the side surface of the silicon substrate that is not covered by the surface passivation layer and the anti-reflection layer, the first doped silicon layer may be in electrical contact with the second doped silicon layer having a conductivity type opposite to that of the first doped silicon layer through the intrinsic silicon layer, so that a diode structure having a low reverse breakdown voltage is formed on the side surface of the silicon substrate, thereby helping reduce a hot spot risk of the back contact cell and improving the anti-burnout capability of the back contact cell. In addition, the forward current leakage, the hot spot risk, and the protection of the side surface of the back contact cell may be regulated according to an actual application scenario requirement of the back contact cell by adjusting the maximum extension lengths of the surface passivation layer and the anti-reflection layer on the side surface, thereby facilitating a balance among the forward current leakage, the hot spot risk, and the protection of the side surface of the back contact cell.

Regarding the thickness of the surface passivation layer and the anti-reflection layer, the thickness of the surface passivation layer and/or the anti-reflection layer on the side of the light-receiving surface of the silicon substrate may be approximately the same, so that each region on the side of the light-receiving surface of the silicon substrate corresponds to a high passivation effect, and the back contact cell has a relatively low reflectance on each region on the side of the light-receiving surface, thereby further improving the conversion efficiency of the back contact cell.

Regarding the thickness of the surface passivation layer and the anti-reflection layer on the side surface of the silicon substrate, the thickness of the surface passivation layer and/or the anti-reflection layer on each part of the side surface of the silicon substrate may be the same. In this case, within a particular range, the thickness of the surface passivation layer is directly proportional to the passivation effect and the insulating isolation effect of the surface passivation layer. Based on this, when the thickness of the surface passivation layer is equal on the side surface of the silicon substrate, each part of the surface passivation layer has a high passivation effect and a high insulating isolation characteristic, which helps enable each region in the side surface of the silicon substrate that is covered by the surface passivation layer to have a low quantity of surface defects, and further helps the surface passivation layer having a uniform thickness better achieve an electrical isolation effect of the first doped silicon layer and the second doped silicon layer, thereby reducing forward current leakage. Next, when the thickness of each part of the anti-reflection layer on the side surface of the silicon substrate is the same, it is beneficial to endowing each part of the anti-reflection layer on the side surface with a high insulating characteristic and protective effect, which is beneficial to better achieving an electrical isolation effect of the first doped silicon layer and the second doped silicon layer using the anti-reflection layer having a uniform thickness, thereby reducing forward current leakage, and improving the structural reliability of the side surface of the back contact cell.

Alternatively, as shown in FIG. 11, on the side surface of the silicon substrate 100, the thickness of the surface passivation layer 13 and/or the anti-reflection layer 207 may gradually increase in a direction from the back surface to the light-receiving surface. In this case, it may be understood that when the thickness of the surface passivation layer 13 gradually increases in the direction from the back surface to the light-receiving surface, the part of the surface passivation layer 13 on the side surface close to the light-receiving surface has a high passivation effect and a better insulating isolation characteristic. In this way, while the quantity of surface defects in the region in the side surface of the silicon substrate 100 close to the light-receiving surface is further reduced, the risk of current leakage between the first doped silicon layer 12 and the second doped silicon layer 16 is further reduced, thereby helping increase an open-circuit voltage and a fill factor of the back contact cell. When the thickness of the anti-reflection layer 207 gradually increases in the direction from the back surface to the light-receiving surface, the part of the surface passivation layer 13 on the side surface close to the light-receiving surface is endowed with a better insulating isolation characteristic, which further reduces a current leakage risk between the first doped silicon layer 12 and the second doped silicon layer 16, thereby helping increase an open-circuit voltage and a fill factor of the back contact cell.

On the side surface of the silicon substrate, a rate of a gradual increase in the thickness of the surface passivation layer and/or the anti-reflection layer in the direction from the back surface to the light-receiving surface and the thickness of the part of the surface passivation layer and/or the anti-reflection layer close to the back surface or the light-receiving surface may be set according to an actual requirement, and is not specifically limited herein.

For the intrinsic silicon layer and the second doped silicon layer, in terms of materials, a material of the intrinsic silicon layer and/or the second doped silicon layer may include at least one of amorphous silicon, microcrystalline silicon, and nanocrystalline silicon. Next, the conductivity types of the second doped silicon layer and the first doped silicon layer may be determined based on a material of the first doped silicon layer and an actual application scenario, provided that the conductivity types of the first doped silicon layer and the second doped silicon layer are opposite. Specifically, the conductivity type of the first doped silicon layer may be an N type, and in this case, the conductivity type of the second doped silicon layer is a P type. Alternatively, the conductivity type of the first doped silicon layer may be a P type, and in this case, the conductivity type of the second doped silicon layer is an N type.

In some embodiments, when the material of the first doped silicon layer includes polycrystalline silicon, the conductivity type of the first doped silicon layer may be an N type, and the conductivity type of the second doped silicon layer may be a P type. In this case, compared with P-type doped amorphous silicon, P-type doped microcrystalline silicon, and P-type doped nanocrystalline silicon, a contact resistance between the P-type doped polycrystalline silicon material and an electrode is high, and a field passivation effect is poor. Therefore, when the conductivity type of the first doped silicon layer is set to an N type and the conductivity type of the second doped silicon layer is set to a P type, the field passivation effect of the first doped silicon layer can be further improved, and the contact resistance between the first doped silicon layer and the electrode can be lowered, thereby helping improve the electrical performance of the back contact cell.

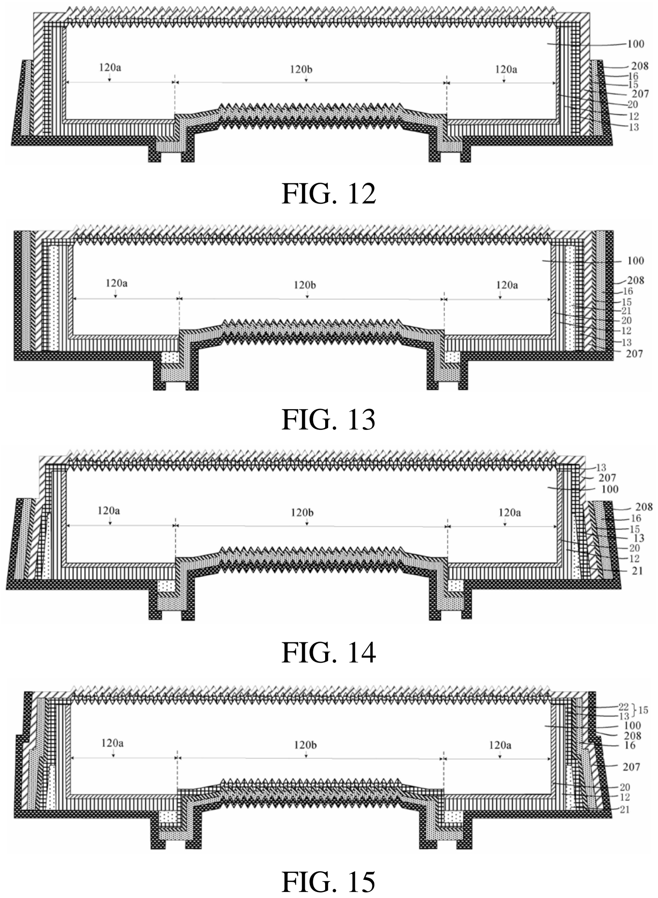

Regarding forming ranges of intrinsic silicon layer and the second doped silicon layer on the side surface of the silicon substrate, as shown in FIG. 8 to FIG. 10, in a thickness direction of the silicon substrate 100, the intrinsic silicon layer 15 and the second doped silicon layer 16 may cover various regions on the side surface of the silicon substrate 100, that is, cover the entire side surface. Alternatively, as shown in FIG. 12, the intrinsic silicon layer 15 and the second doped silicon layer 16 arranged on the side surface may be located on a local region of the side surface and close to the back surface. In this case, it may be understood that in an actual manufacturing procedure, when the intrinsic silicon layer 15 and the second doped silicon layer 16 are formed on the back surface and the side surface of the silicon substrate 100, to ensure that the intrinsic silicon layer 15 and the second doped silicon layer 16 with large coverage are formed on the side surface, the intrinsic silicon layer 15 and the second doped silicon layer 16 may be peripherally plated on the side of the light-receiving surface. Parasitic absorption exists in the intrinsic silicon layer 15 and the second doped silicon layer 16 on the light-receiving surface. Therefore, the intrinsic silicon layer 15 and the second doped silicon layer 16 on the light-receiving surface need to be removed. Based on this, when the intrinsic silicon layer 15 and the second doped silicon layer 16 that are arranged on the side surface are located on a local region of the side surface, a manufacturing condition does not need to be strictly controlled to keep all the intrinsic silicon layer 15 and the second doped silicon layer 16 on the side surface in a procedure of removing the intrinsic silicon layer 15 and the second doped silicon layer 16 that are peripherally plated on the light-receiving surface, thereby reducing the manufacturing difficulty of the back contact cell. Specifically, in this case, extension ranges of the intrinsic silicon layer 15 and the second doped silicon layer 16 on the side surfaces may be determined based on requirements of passivation and protection on the side surface of the silicon substrate 100, a requirement for preventing current leakage between the first doped silicon layer 12 and the second doped silicon layer 16 arranged on the side surface of the silicon substrate 100, and an actual manufacturing procedure in an actual application scenario. This is not specifically limited herein.

Regarding the thickness of the intrinsic silicon layer and the second doped silicon layer on the side surface of the silicon substrate, the thickness of the intrinsic silicon layer and the second doped silicon layer on the side surface of the silicon substrate may be approximately the same in the direction from the back surface to the light-receiving surface. Alternatively, as shown in FIG. 12, on the side surface of the silicon substrate 100, the thickness of the intrinsic silicon layer 15 and/or the second doped silicon layer 16 gradually increases in the direction from the light-receiving surface to the back surface. In this case, it is beneficial to improving protective effects of the intrinsic silicon layer 15 and/or the second doped silicon layer 16 on the region close to the back surface in the side surface of the silicon substrate 100, so that the structural reliability of the side surface in the back contact cell can be further improved.

For example, the thickness of the intrinsic silicon layer may be greater than or equal to 8 nm and less than or equal to 14 nm. For example, the thickness of the intrinsic silicon layer may be 8 nm, 9 nm, 10 nm, 11 nm, 12 nm, 13 nm, 14 nm, or the like. In this case, the intrinsic silicon layer has a large thickness, which is beneficial to enhancing an isolation effect of the intrinsic silicon layer on the first doped silicon layer and the second doped silicon layer, thereby reducing a risk of forward current leakage.

In addition, in the side surface of the silicon substrate, if a surface of a region covered by the intrinsic silicon layer and/or the second doped silicon layer has a pedestal-like texture structure, the thickness of the intrinsic silicon layer and/or the second doped silicon layer located on the bottom surface of the pedestal-like texture structure may be equal to the thickness of the intrinsic silicon layer and/or the second doped silicon layer located on the side wall of the pedestal-like texture structure. Alternatively, the thickness of the intrinsic silicon layer and/or the second doped silicon layer located on the bottom surface of the pedestal-like texture structure may be greater than the thickness of the intrinsic silicon layer and/or the second doped silicon layer located on the side wall of the pedestal-like texture structure. It may be understood that, the part of the intrinsic silicon layer and/or the second doped silicon layer located on the bottom surface of the pedestal-like texture structure occupies a large proportion of the side surface. Therefore, when the thickness of the intrinsic silicon layer and/or the second doped silicon layer located on the bottom surface of the pedestal-like texture structure is large, the part of the intrinsic silicon layer and/or the second doped silicon layer that occupies a large proportion may have high passivation and protective effects, so that a quantity of defects on the side surface of the back contact cell can be further reduced, thereby improving the protective effect on the side surface of the silicon substrate. Certainly, the thickness of the intrinsic silicon layer and/or the second doped silicon layer located on the bottom surface of the pedestal-like texture structure may be less than the thickness of the intrinsic silicon layer and/or the second doped silicon layer located on the side wall of the pedestal-like texture structure, thereby improving the applicability of the back contact cell provided in the embodiments of the present application in different application scenarios.

In this specification, "the thickness of the intrinsic silicon layer and/or the second doped silicon layer located on the bottom surface of the pedestal-like texture structure" may be the thickness of the intrinsic silicon layer located on the bottom surface of the pedestal-like texture structure, or may be the thickness of the second doped silicon layer located on the bottom surface of the pedestal-like texture structure, or certainly may be a sum of the thicknesses of the intrinsic silicon layer and the second doped silicon layer that are located on the bottom surface of the pedestal-like texture structure. In this specification, "the thickness of the intrinsic silicon layer and/or the second doped silicon layer located on the side wall of the pedestal-like texture structure" is similar to the foregoing explanations, and details are not described herein again.

In addition, when the thickness located on the bottom surface of the pedestal-like texture structure is compared with the thickness located on the side wall of the pedestal-like texture structure, the same film layer, for example, the intrinsic silicon layer, or for another example, the second doped silicon layer, or for yet another example, a sum of the thicknesses of the intrinsic silicon layer and the second doped silicon layer, should be compared.

In a possible implementation, when the side surface of the silicon substrate has a pedestal-like texture structure, a thickness of the first interface passivation layer located on the bottom surface of the pedestal-like texture structure may be less than a thickness of the first interface passivation layer located on the side wall of the pedestal-like texture structure. In addition, a thickness of the intrinsic silicon layer located on the bottom surface of the pedestal-like texture structure is greater than a thickness of the intrinsic silicon layer located on the side wall of the pedestal-like texture structure; and/or a thickness of the second doped silicon layer located on the bottom surface of the pedestal-like texture structure is greater than a thickness of the second doped silicon layer located on the side wall of the pedestal-like texture structure. "A thickness of the intrinsic silicon layer located on the bottom surface of the pedestal-like texture structure is greater than a thickness of the intrinsic silicon layer located on the side wall of the pedestal-like texture structure; and a thickness of the second doped silicon layer located on the bottom surface of the pedestal-like texture structure is greater than a thickness of the second doped silicon layer located on the side wall of the pedestal-like texture structure. " is that a sum of the thicknesses of the intrinsic silicon layer and the second doped silicon layer located on the bottom surface of the pedestal-like texture structure is greater than a sum of the thicknesses of the intrinsic silicon layer and the second doped silicon layer located on the side wall of the pedestal-like texture structure. Specifically, in the intrinsic silicon layer and the second doped silicon layer, it may be that only the thickness of the intrinsic silicon layer located on the bottom surface of the pedestal-like texture structure is greater than the thickness of the intrinsic silicon layer on the side wall of the pedestal-like texture structure, and the thickness of the second doped silicon layer located on the bottom surface of the pedestal-like texture structure is less than or equal to the thickness of the second doped silicon layer located on the side wall of the pedestal-like texture structure. Alternatively, in the intrinsic silicon layer and the second doped silicon layer, the thickness of the intrinsic silicon layer located on the bottom surface of the pedestal-like texture structure is less than or equal to the thickness of the intrinsic silicon layer located on the side wall of the pedestal-like texture structure, and the thickness of the second doped silicon layer located on the bottom surface of the pedestal-like texture structure is greater than the thickness of the second doped silicon layer located on the side wall of the pedestal-like texture structure. Alternatively, in the intrinsic silicon layer and the second doped silicon layer, the thickness of the intrinsic silicon layer located on the bottom surface of the pedestal-like texture structure is greater than the thickness of the intrinsic silicon layer located on the side wall of the pedestal-like texture structure, and the thickness of the second doped silicon layer located on the bottom surface of the pedestal-like texture structure is also greater than the thickness of the second doped silicon layer located on the side wall of the pedestal-like texture structure.

In the case of employing the foregoing technical solution, a magnitude relationship between the thicknesses of the first interface passivation layer on the bottom surface and the side wall of the pedestal-like texture structure is opposite to a magnitude relationship between the thicknesses of the intrinsic silicon layer and/or the second doped silicon layer on the bottom surface and the side wall of the pedestal-like texture structure. In this case, a large thickness of the first interface passivation layer that is located on the side wall of the pedestal-like texture structure may make up for a weak passivation effect and protective effect of the intrinsic silicon layer and/or the second doped silicon layer due to a small thickness of the intrinsic silicon layer and/or the second doped silicon layer on the side wall of the pedestal-like texture structure. In addition, a large thickness of the intrinsic silicon layer and/or the second doped silicon layer that are located on the bottom surface of the pedestal-like texture structure can make up for a weak passivation effect and protective effect of the first interface passivation layer due to a small thickness of the first interface passivation layer on the bottom surface of the pedestal-like texture structure, thereby ensuring that under a joint passivation effect and protective effect of the first interface passivation layer and the intrinsic silicon layer and/or the second doped silicon layer, the bottom surface and the side surface of the pedestal-like texture structure that correspond to the side surface of the silicon substrate both have high passivation effects and protective strength.

For the transparent conductive layer, as shown in FIG. 8, in a thickness direction of the silicon substrate 100, the transparent conductive layer 208 may cover various regions on the side surface of the silicon substrate 100. Alternatively, as shown in FIG. 12, the transparent conductive layer 208 arranged on the side surface may be located on a local region of the side surface and close to the back surface. In this case, a manufacturing condition does not need to be strictly controlled to keep all the transparent conductive layer 208 on the side surface in a process of removing the transparent conductive layer 208 that is peripherally plated on the light-receiving surface, thereby reducing the manufacturing difficulty of the back contact cell. Specifically, in this case, extension ranges of the transparent conductive layer 208 on the side surfaces may be determined based on a requirement of protection on the side surface of the silicon substrate 100, a requirement for preventing current leakage between the first doped silicon layer 12 and the second doped silicon layer 16 arranged on the side surface of the silicon substrate 100, and an actual manufacturing procedure in an actual application scenario. This is not specifically limited herein.

Regarding the thickness of the transparent conductive layer on the side surface of the silicon substrate, the thickness of the transparent conductive layer on the side surface of the silicon substrate may be approximately the same in the direction from the back surface to the light-receiving surface. Alternatively, as shown in FIG. 12, on the side surface of the silicon substrate 100, the thickness of the transparent conductive layer 208 gradually increases in the direction from the light-receiving surface to the back surface. In this case, it is beneficial to improving protective effects of the transparent conductive layer 208 on the region close to the back surface in the side surface of the silicon substrate 100, so that the structural reliability of the side surface in the back contact cell can be further improved.

In addition, a material of the transparent conductive layer may include indium tin oxide, aluminum-doped zinc, fluorine-doped tin oxide, or antimony-doped tin oxide.

In a possible implementation, as shown in FIG. 13, the back contact cell may further include an insulating mask layer 21. The insulating mask layer 21 is arranged between the first doped silicon layer 12 and the surface passivation layer 13 that are located on the side surface, and the insulating mask layer 21 is further arranged between the intrinsic silicon layer 15 and the first doped silicon layer 12 that are located on the back surface in the thickness direction of the silicon substrate 100. In this case, the insulating mask layer 21, together with the surface passivation layer 13 and the anti-reflection layer 207, may separate the first doped silicon layer 12 and the second doped silicon layer 16 on the side surface, thereby further suppressing current leakage on the side surface. In addition, the side surface of the silicon substrate 100 can also be passivated, thereby further reducing a quantity of defects on the side surface of the silicon substrate 100. In addition, the insulating mask layer 21 is also formed on the side surface, which further helps reduce a requirement on the thickness of the intrinsic silicon layer 15, and makes the intrinsic silicon layer 15 have a small thickness to have low tunnel resistance while ensuring low forward current leakage between the first doped silicon layer 12 and the second doped silicon layer 16, which helps improve the carrier collection efficiency of the second doped silicon layer 16 on the side of the back surface.

In terms of materials, a material of the insulating mask layer may include any insulating material having a protective effect of a mask, which is not specifically limited herein. For example, the insulating mask layer may include at least one of a doped silicate glass layer, an aluminum oxide layer, and a silicon nitride layer. A conductivity type of the doped silicate glass layer is opposite to a conductivity type of the first doped silicon layer.

In terms of coverage of the side surface, as shown in FIG. 13, in the thickness direction of the silicon substrate 100, the insulating mask layer 21 may cover various regions on the side surface of the silicon substrate 100. Alternatively, as shown in FIG. 14, the insulating mask layer 21 arranged on the side surface may be located on a local region of the side surface. For an application principle of a beneficial effect in this case, refer to the foregoing application principle of the beneficial effect of that the transparent conductive layer 208 is located on a local region of the side surface and close to the back surface, and details are not described herein again. When the insulating mask layer 21 arranged on the side surface is located on a local region of the side surface, the insulating mask layer 21 located on the side surface may be close to the side of the back surface, or may be close to the side of the light-receiving surface, or may be located on a middle region of the side surface.

Specifically, when the insulating mask layer is formed on the back surface and the side surface of the silicon substrate, the insulating mask layer may also be peripherally plated on the light-receiving surface. In this case, if the part of the insulating mask layer that is located on the side surface and close to the light-receiving surface is also removed together during the removal of the insulating mask layer peripherally plated on the light-receiving surface and in a case that an etchant has no impact or a small impact on the insulating mask layer during the removal of the surface passivation layer and the anti-reflection layer peripherally plated on the back surface, the insulating mask layer located on the side surface in the back contact cell is close to the side of the back surface. Alternatively, the insulating mask layer on the side surface is not affected during the removal of the insulating mask layer peripherally plated on the light-receiving surface. In addition, in a case that an etchant removes the part of the insulating mask layer on the side surface close to the back surface together during the removal of the surface passivation layer and the anti-reflection layer that are peripherally plated on the back surface, the insulating mask layer located on the side surface in the back contact cell is close to the side of the light-receiving surface. Further alternatively, a corresponding etchant removes a part of the insulating mask layer that is located on the side surface and close to the light-receiving surface together during the removal of the insulating mask layer peripherally plated on the light-receiving surface. In addition, in a case that an etchant removes the part of the insulating mask layer on the side surface close to the back surface together during the removal of the surface passivation layer and the anti-reflection layer that are peripherally plated on the back surface, the insulating mask layer located on the side surface in the back contact cell may be located on a middle region of the side surface.

In addition, in this case, an extension range of the insulating mask layer on the side surfaces may be determined based on requirements of passivation and protection on the side surface of the silicon substrate, a requirement for preventing current leakage between the first doped silicon layer and the second doped silicon layer arranged on the side surface of the silicon substrate, and an actual manufacturing procedure in an actual application scenario. This is not specifically limited herein.

For example, a ratio of a maximum extension length of the insulating mask layer on the side surface to a thickness of the silicon substrate may be less than or equal to 80%. For example, the ratio of the maximum extension length of the insulating mask layer on the side surface to the thickness of the silicon substrate may be 5%, 10%, 20%, 30%, 40%, 50%, 60%, 70%, 80%, or the like. In this case, it may be understood that a larger extension length of the insulating mask layer on the side surface indicates an insulating mask layer with a larger formation range to isolate the first doped silicon layer and the second doped silicon layer on the side surface of the silicon substrate. Lower forward current leakage of the back contact cell indicates a stronger protective effect on the side surface of the silicon substrate by the insulating mask layer. However, a smaller extension length of the insulating mask layer on the side surface indicates a larger range of a reverse current leakage region formed between the first doped silicon layer and the second doped silicon layer on the side surface of the silicon substrate and a lower hot spot risk of the back contact cell. Based on this, when the ratio of the maximum extension length of the insulating mask layer on the side surface to the thickness of the silicon substrate is less than or equal to 80%, the forward current leakage, the hot spot risk, and the protection of the side surface of the back contact cell may be regulated according to an actual application scenario requirement of the back contact cell by adjusting the maximum extension length of the insulating mask layer on the side surface, thereby facilitating a balance among the forward current leakage, the hot spot risk, and the protection of the side surface of the back contact cell.

Regarding the thickness of the insulating mask layer on the side surface of the silicon substrate, the thickness of the insulating mask layer on the side surface of the silicon substrate may be approximately the same in the direction from the back surface to the light-receiving surface. Alternatively, as shown in FIG. 14, on the side surface of the silicon substrate 100, the thickness of the insulating mask layer 21 gradually increases in the direction from the light-receiving surface to the back surface. An application principle of a beneficial effect in this case is similar to the application principle of the beneficial effect of that the thickness of the surface passivation layer 13 on the side surface of the silicon substrate 100 gradually increases in the direction from the back surface to the light-receiving surface, and details are not described herein again.

In a possible implementation, a doped layer may further be formed in the side surface of the silicon substrate. The dopant in the doped layer includes a dopant in the first doped silicon layer. In this case, the doped layer is formed by controlling a manufacturing process, a concentration of the dopant in the first doped silicon layer, the thickness of the first doped silicon layer, the thickness and density of the first interface passivation layer, and the like during the formation of the first doped silicon layer, so that a part of the dopant in the first doped silicon layer passes through the first interface passivation layer and enter the region of the side surface of the silicon substrate. Alternatively, the doped layer and the first doped silicon layer may be separately formed. Based on this, a high-low junction may be formed between the doped layer and the first doped silicon layer, so that energy bands of the first doped silicon layer and the side surface of the silicon substrate are more matched, a passivation effect of the first doped silicon layer on the side surface of the silicon substrate is improved, and the open-circuit voltage of the back contact cell is increased. Specifically, a forming range of the doped layer, a doping concentration of the dopant in the doped layer, and the like may be determined based on forming ranges of the first interface passivation layer and the first doped silicon layer on the side surface, the thickness and density of the first interface passivation layer, and a doping concentration of the first doped silicon layer, or according to an actual requirement. This is not specifically limited herein.

The following describes the structure of the solar cell and the like in yet some other embodiments of the first aspect of the present application with reference to FIG. 15.

FIG. 15 is a schematic diagram of a back contact cell according to an embodiment of the present application. The solar cell is a back contact cell. The first conductive layer 202 is a first doped silicon layer 12, the second conductive layer 205 is a second doped silicon layer 16, and the insulating layer 203 includes an insulating mask layer 21.

Specifically, as shown in FIG. 15, the back contact cell includes: a silicon substrate, a first interface passivation layer 20, the first doped silicon layer 12, the insulating mask layer 21, an intrinsic silicon layer 15, the second doped silicon layer 16, and a transparent conductive layer 208. The silicon substrate includes a back surface and a light-receiving surface that are oppositely arranged, and a side surface connecting the back surface and the light-receiving surface. In a direction away from the side surface, the first interface passivation layer 20, the first doped silicon layer 12, the insulating mask layer 21, the intrinsic silicon layer 15, the second doped silicon layer 16, and the transparent conductive layer 208 are arranged in sequence on the side surface. A conductivity type of the first doped silicon layer 12 is opposite to a conductivity type of the second doped silicon layer 16. The back contact cell includes a surface passivation layer 13 arranged on the light-receiving surface, and the surface passivation layer 13 extends from the light-receiving surface to the side surface; the back contact cell further includes a second interface passivation layer 22 that is arranged on the back surface and located between the silicon substrate and the second doped silicon layer 16, and the second interface passivation layer 22 extends from the back surface to the side surface; and on the side surface, the intrinsic silicon layer 15 includes the surface passivation layer 13 and the second interface passivation layer 22 that are arranged to form a stack in a direction away from the side surface.

It may be understood that in this part, the first interface passivation layer 20 may also be referred to as the foregoing first passivation layer 201, the intrinsic silicon layer 15 may also be referred to as the foregoing second passivation layer 204, and "in a direction away from the side surface" is also "in a direction away from the silicon substrate".

In the case of employing the foregoing technical solution, in addition to the intrinsic silicon layer arranged between the first doped silicon layer and the second doped silicon layer, the insulating mask layer is further arranged. In this way, while it is ensured that forward current leakage loss is reduced, a requirement on the thickness of the intrinsic silicon layer can be lowered, and the tunnel resistance of the intrinsic silicon layer can be lowered, which is beneficial to improving the carrier collection efficiency of the second doped silicon layer arranged on the side of the back surface of the silicon substrate, thereby further improving the conversion efficiency of the back contact cell. In addition, the presence of the insulating mask layer can further enhance a protective effect on the side surface of the silicon substrate, and further improve the structural reliability of the side surface of the back contact cell.

In the foregoing case, as shown in FIG. 15, the first interface passivation layer 20, the first doped silicon layer 12, the insulating mask layer 21, the intrinsic silicon layer 15, the second doped silicon layer 16, and the transparent conductive layer 208 included in the back contact cell are arranged on the side surface of the silicon substrate 100 and also arranged on the back surface of the silicon substrate 100. Specifically, on a side of the back surface of the silicon substrate 100, the transparent conductive layer 208 covers a side of the first doped silicon layer 12 and the second doped silicon layer 16 away from the silicon substrate 100, and a through isolation channel is provided in the transparent conductive layer 208 to disconnect a part of the transparent conductive layer 208 that corresponds to the first doped silicon layer 12 from a part of the transparent conductive layer 208 that corresponds to the second doped silicon layer 16, thereby preventing a short circuit. Regarding distribution of the first interface passivation layer 20, the first doped silicon layer 12, the insulating mask layer 21, the intrinsic silicon layer 15, and the second doped silicon layer 16 on the side of the back surface of the silicon substrate 100, refer to the distribution of the first interface passivation layer 20, the first doped silicon layer 12, the intrinsic silicon layer 15, and the second doped silicon layer 16 on the side of the back surface of the silicon substrate 100 described above in the descriptions of FIG. 8 to FIG. 14, and this is not specifically limited herein.

In addition, in the side surface of the back contact cell, the second doped silicon layer may be directly in contact with the transparent conductive layer. Alternatively, as shown in FIG. 15, the back contact cell may further include an anti-reflection layer 207 arranged on the light-receiving surface, and the anti-reflection layer 207 extends from the light-receiving surface to the side surface. On the side surface, the anti-reflection layer 207 is arranged between the second doped silicon layer 16 and the transparent conductive layer 208 in the direction away from the side surface. In this case, one anti-reflection layer is further added to the film layers arranged on the side surface of the silicon substrate, so that the protective effect on the side surface of the silicon substrate can be further improved, thereby reducing a damage risk of the side surface of the silicon substrate and reducing the forward current leakage loss. In addition, in this case, the anti-reflection layer is directly formed on a side of the second doped silicon layer away from the silicon substrate. A difference exists between the materials of the surface passivation layer and the second doped silicon layer, and the anti-reflection layer is easier to deposit on the surface passivation layer. Therefore, based on this, compared with that the anti-reflection layer is directly formed on the surface passivation layer, when the anti-reflection layer is directly formed on the side of the second doped silicon layer away from the silicon substrate, a peripheral plating range of the anti-reflection layer on the side of the back surface can be reduced, so that the amount of etching during the removal of the peripheral plating of the anti-reflection layer on the back surface can be reduced, thereby improving the manufacturing efficiency.

The insulating mask layer may cover each region of the side surface. Alternatively, as shown in FIG. 15, the insulating mask layer 21 may be arranged on a local region of the side surface and close to the side of the back surface. For coverage of the insulating mask layer 21 on the side surface, refer to corresponding descriptions in the foregoing text, and details are not described herein again.

It should be understood that in the first aspect, features in different embodiments may be applied alone or in a combined manner as required.

The following describes the structure of the solar cell and the like in still some other embodiments of the first aspect of the present application with reference to FIG. 3 and FIG. 8.

In some embodiments, the solar cell is a back contact cell, including: a silicon substrate 100, a first interface passivation layer 20, the first doped silicon layer 12, the surface passivation layer 13, the anti-reflection layer 207, an intrinsic silicon layer 15, the second doped silicon layer 16, and a transparent conductive layer 208. The silicon substrate 100 includes a back surface and a light-receiving surface that are oppositely arranged, and a side surface connecting the back surface and the light-receiving surface. In a direction away from the side surface, the first interface passivation layer 20, the first doped silicon layer 12, the surface passivation layer 13, the anti-reflection layer 207, the intrinsic silicon layer 15, the second doped silicon layer 16, and the transparent conductive layer 208 are arranged in sequence on the side surface. A conductivity type of the first doped silicon layer 12 is opposite to a conductivity type of the second doped silicon layer 16. In a thickness direction of the silicon substrate 100, the surface passivation layer 13 and the anti-reflection layer 207 are further arranged in sequence on the light-receiving surface, and the surface passivation layer 13 and the anti-reflection layer 207 extend from the light-receiving surface to the side surface. The protective layer 200 includes the first doped silicon layer 12, the surface passivation layer 13, the anti-reflection layer 207, and the second doped silicon layer 16, and an insulating layer 203 includes the surface passivation layer 13 and the anti-reflection layer 207. A junction between the side surface 130 and the back surface 120 is a first position 130a, and a junction between the side surface 130 and the light-receiving surface 110 is a second position 130b. The thickness of the protective layer 200 at the first position 130a is D1, and the thickness of the protective layer 200 at the second position 130b is D2, satisfying: 1 < D1/D2 ≤ 10, in some embodiments, 2.5 ≤ D1/D2 ≤ 10.

In addition, the surface passivation layer 13 and the anti-reflection layer 207 are located on the light-receiving surface of the silicon substrate 100 and also extend to the side surface of the silicon substrate 100. In this case, on the side surface of the silicon substrate 100, the first doped silicon layer 12 and the second doped silicon layer 16 that have opposite conductivity types may be isolated by the surface passivation layer 13 and the anti-reflection layer 207, to prevent conduction and current leakage between the first doped silicon layer 12 and the second doped silicon layer 16, thereby reducing the forward current leakage loss, so that the back contact cell has high conversion efficiency. In addition, the parts of the surface passivation layer 13 and the anti-reflection layer 207 that are arranged on the light-receiving surface can reduce carrier recombination and a surface reflectance, and then the surface passivation layer 13 and the anti-reflection layer 207 extend to the side surface of the silicon substrate 100, and can further be used to isolate the first doped silicon layer 12 and the second doped silicon layer 16 without additionally forming another insulating layer using another deposition step to prevent current leakage between the first doped silicon layer 12 and the second doped silicon layer 16. In this way, a manufacturing procedure of the back contact cell can be simplified, and compatibility between a film layer isolating the first doped silicon layer 12 and the second doped silicon layer 16 and another structure in the back contact cell also does not need to be considered, thereby ensuring a high yield of the back contact cell. In addition, the first interface passivation layer 20 and the first doped silicon layer 12 arranged on the side surface of the silicon substrate 100 have a passivation effect on the silicon substrate 100, and the surface passivation layer 13 that implements insulating isolation between the first doped silicon layer 12 and the second doped silicon layer 16 of the side surface can also passivate the side surface of the silicon substrate 100, thereby further reducing a carrier recombination rate on the side surface of the silicon substrate 100 and improving the conversion efficiency of the back contact cell. In addition, a proper value range of a ratio D1/D2 of the thickness D1 of the protective layer 200 of the side surface 130 of the silicon substrate 100 at the first position 130a to the thickness D2 of the protective layer 200 at the second position 130b is set, so that the thicknesses of the protective layer 200 of the side surface 130 of the silicon substrate 100 at different positions are different. In this way, the entire side surface 130 of the silicon substrate 100 can be effectively blocked and protected, and loss of materials required for manufacturing the protective layer 200 can be suitably reduced.

Further, a thickness of the insulating layer 203 (i.e., the surface passivation layer 13 and the anti-reflection layer 207) on the back surface 120 is H2, a thickness of the insulating layer 203 located at the first position 130a on the side surface 130 is H21, and a thickness of the insulating layer 203 located at the second position 130b on the side surface 130 is H22, satisfying: H22 < H21 ≤ H2. For the technical effect of H22 < H21 ≤ H2, refer to the foregoing text, and details are not described herein again.

Further, a total thickness of the first passivation layer 201 (i.e., the first interface passivation layer 20) and the first conductive layer 202 (i.e., the first doped silicon layer 12) on the back surface 120 is H1, a total thickness of the first passivation layer 201 and the first conductive layer 202 located at the first position 130a on the side surface 130 is H11, and a total thickness of the first passivation layer 201 and the first conductive layer 202 located at the second position 130b on the side surface 130 is H12, satisfying: H12 < H11 ≤ H1. For the technical effect of H12 < H11 ≤ H1, refer to the foregoing text, and details are not described herein again.

Further, a total thickness of the second passivation layer 204 (i.e., the intrinsic silicon layer 15) and the second conductive layer 205 (i.e., the second doped silicon layer 16) on the back surface 120 is H3, a total thickness of the second passivation layer 204 and the second conductive layer 205 located at the first position 130a on the side surface 130 is H31, and a total thickness of the second passivation layer 204 and the second conductive layer 205 located at the second position 130b on the side surface 130 is H32, satisfying: H32 < H31 ≤ H3. For the technical effect of H32 < H31 ≤ H3, refer to the foregoing text, and details are not described herein again.

The following describes the structure of the solar cell and the like in some other embodiments of the first aspect of the present application with reference to FIG. 3 and FIG. 15.

In some other embodiments, the solar cell is a back contact cell, including: a silicon substrate, a first interface passivation layer 20, the first doped silicon layer 12, the insulating mask layer 21, an intrinsic silicon layer 15, the second doped silicon layer 16, and a transparent conductive layer 208. The silicon substrate includes a back surface and a light-receiving surface that are oppositely arranged, and a side surface connecting the back surface and the light-receiving surface. In a direction away from the side surface, the first interface passivation layer 20, the first doped silicon layer 12, the insulating mask layer 21, the intrinsic silicon layer 15, the second doped silicon layer 16, and the transparent conductive layer 208 are arranged in sequence on the side surface. A conductivity type of the first doped silicon layer 12 is opposite to a conductivity type of the second doped silicon layer 16. The back contact cell includes a surface passivation layer 13 arranged on the light-receiving surface, and the surface passivation layer 13 extends from the light-receiving surface to the side surface; the back contact cell further includes a second interface passivation layer 22 that is arranged on the back surface and located between the silicon substrate and the second doped silicon layer 16, and the second interface passivation layer 22 extends from the back surface to the side surface; and on the side surface, the intrinsic silicon layer 15 includes the surface passivation layer 13 and the second interface passivation layer 22 that are arranged to form a stack in a direction away from the side surface. The protective layer 200 includes the first doped silicon layer 12, the insulating mask layer 21, and the second doped silicon layer 16, and the insulating layer 203 includes the insulating mask layer 21. A junction between the side surface 130 and the back surface 120 is a first position 130a, a junction between the side surface 130 and the light-receiving surface 110 is a second position 130b. The thickness of the protective layer 200 at the first position 130a is D1, and the thickness of the protective layer 200 at the second position 130b is D2, satisfying: 1 < D1/D2 ≤ 10, in some embodiments, 2.5 ≤ D1/D2 ≤ 10.

In addition to the intrinsic silicon layer arranged between the first doped silicon layer and the second doped silicon layer, the insulating mask layer is further arranged. In this way, while it is ensured that forward current leakage loss is reduced, a requirement on the thickness of the intrinsic silicon layer can be lowered, and the tunnel resistance of the intrinsic silicon layer can be lowered, which is beneficial to improving the carrier collection efficiency of the second doped silicon layer arranged on the side of the back surface of the silicon substrate, thereby further improving the conversion efficiency of the back contact cell. In addition, the presence of the insulating mask layer can further enhance a protective effect on the side surface of the silicon substrate, and further improve the structural reliability of the side surface of the back contact cell. In addition, a proper value range of a ratio D1/D2 of the thickness D1 of the protective layer 200 of the side surface 130 of the silicon substrate 100 at the first position 130a to the thickness D2 of the protective layer 200 at the second position 130b is set, so that the thicknesses of the protective layer 200 of the side surface 130 of the silicon substrate 100 at different positions are different. In this way, the entire side surface 130 of the silicon substrate 100 can be effectively blocked and protected, and loss of materials required for manufacturing the protective layer 200 can be suitably reduced.

Further, a thickness of the insulating layer 203 (i.e., the insulating mask layer 21) on the back surface 120 is H2, a thickness of the insulating layer 203 located at the first position 130a on the side surface 130 is H21, and a thickness of the insulating layer 203 located at the second position 130b on the side surface 130 is H22, satisfying: H22 < H21 ≤ H2. For the technical effect of H22 < H21 ≤ H2, refer to the foregoing text, and details are not described herein again.

Further, a total thickness of the first passivation layer 201 (i.e., the first interface passivation layer 20) and the first conductive layer 202 (i.e., the first doped silicon layer 12) on the back surface 120 is H1, a total thickness of the first passivation layer 201 and the first conductive layer 202 located at the first position 130a on the side surface 130 is H11, and a total thickness of the first passivation layer 201 and the first conductive layer 202 located at the second position 130b on the side surface 130 is H12, satisfying: H12 < H11 ≤ H1. For the technical effect of H12 < H11 ≤ H1, refer to the foregoing text, and details are not described herein again.

Further, a total thickness of the second passivation layer 204 (i.e., the intrinsic silicon layer 15) and the second conductive layer 205 (i.e., the second doped silicon layer 16) on the back surface 120 is H3, a total thickness of the second passivation layer 204 and the second conductive layer 205 located at the first position 130a on the side surface 130 is H31, and a total thickness of the second passivation layer 204 and the second conductive layer 205 located at the second position 130b on the side surface 130 is H32, satisfying: H32 < H31 ≤ H3. For the technical effect of H32 < H31 ≤ H3, refer to the foregoing text, and details are not described herein again.

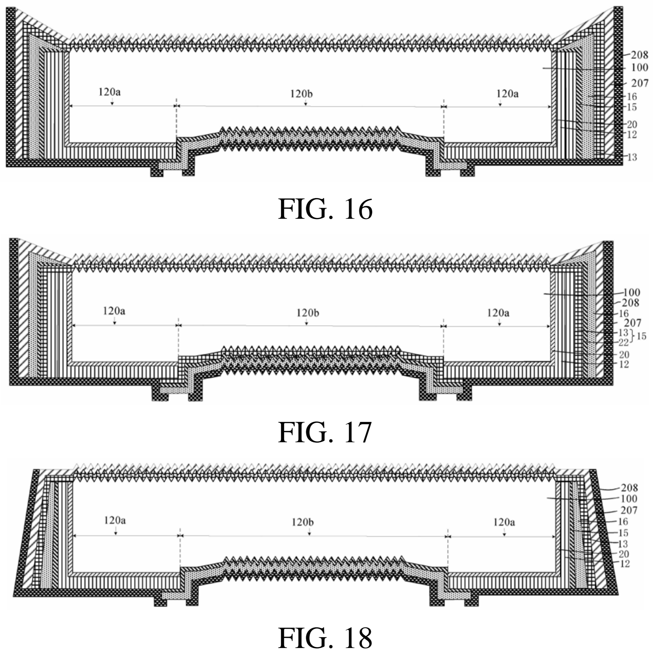

In a second aspect, FIG. 16 to FIG. 18 are schematic diagrams of another solar cell according to an embodiment of the present application.

As shown in FIG. 16, the back contact cell includes: a silicon substrate 100, a first interface passivation layer 20, the first doped silicon layer 12, an intrinsic silicon layer 15, the second doped silicon layer 16, and a transparent conductive layer 208. The silicon substrate 100 includes a back surface and a light-receiving surface that are oppositely arranged, and a side surface connecting the back surface and the light-receiving surface. In a direction away from the side surface, the first doped silicon layer 12, the intrinsic silicon layer 15, the second doped silicon layer 16, and the transparent conductive layer 208 are arranged in sequence on the side surface. On the side surface of the silicon substrate 100, the first doped silicon layer 12 and the intrinsic silicon layer 15 are in direct contact. A conductivity type of the first doped silicon layer 12 is opposite to a conductivity type of the second doped silicon layer 16.

In the case of employing the foregoing technical solution, as shown in FIG. 16, on the side surface of the silicon substrate 100, the first doped silicon layer 12 may be electrically connected to the second doped silicon layer 16 having a conductivity type opposite to that of the first doped silicon layer 12 by the intrinsic silicon layer 15, so that a diode structure having a low reverse breakdown voltage is formed on the side surface of the silicon substrate 100, thereby reducing a hot spot risk of the back contact cell. In addition, the first doped silicon layer 12, the intrinsic silicon layer 15, and the second doped silicon layer 16 arranged on the side surface of the silicon substrate 100 can further passivate the side surface of the silicon substrate 100, thereby reducing a carrier recombination rate on the side surface of the silicon substrate 100 and improving the conversion efficiency of the back contact cell. In addition, the first doped silicon layer 12, the intrinsic silicon layer 15, and the second doped silicon layer 16 that are arranged on the side surface of the silicon substrate 100 can also protect the side surface of the silicon substrate 100, to reduce risks of damage and current leakage that easily occur because the side surface of the silicon substrate 100 is directly exposed, thereby improving the structural reliability of the back contact cell.

In the foregoing case, as shown in FIG. 16, the first interface passivation layer 20, the first doped silicon layer 12, the intrinsic silicon layer 15, the second doped silicon layer 16, and the transparent conductive layer 208 included in the back contact cell are arranged on the side surface of the silicon substrate 100 and also arranged on the back surface of the silicon substrate 100. Specifically, on a side of the back surface of the silicon substrate 100, the transparent conductive layer 208 covers a side of the first doped silicon layer 12 and the second doped silicon layer 16 away from the silicon substrate 100, and a through isolation channel is provided in the transparent conductive layer 208 to disconnect a part of the transparent conductive layer 208 that corresponds to the first doped silicon layer 12 from a part of the transparent conductive layer 208 that corresponds to the second doped silicon layer 16, thereby preventing a short circuit. Regarding distribution of the first interface passivation layer 20, the first doped silicon layer 12, the intrinsic silicon layer 15, and the second doped silicon layer 16 on the side of the back surface of the silicon substrate 100, refer to the distribution of the first interface passivation layer 20, the first doped silicon layer 12, the intrinsic silicon layer 15, and the second doped silicon layer 16 on the side of the back surface of the silicon substrate 100 in the first aspect described above, and this is not specifically limited herein.

It needs to be noted that The following is merely used to describe differences between the back contact cell provided in the second aspect and the contact cell provided in the first aspect in the embodiments of the present application. For the same content between the back contact cell provided in the second aspect and the contact cell provided in the first aspect, for example, the conductivity type of the silicon substrate, the forming range and the thickness of the first doped silicon layer on the side surface, and the forming range and the thickness of the intrinsic silicon layer and the second doped silicon layer on the side surface, refer to corresponding descriptions in the first aspect, and details are not described herein again.

For the intrinsic silicon layer, the intrinsic silicon layer may have a single-layer structure. In this case, each part of the intrinsic silicon layer may form a selective contact structure with the second doped silicon layer, to achieve selective carrier absorption and passivation of a surface at which the intrinsic silicon layer is in contact with the silicon substrate.

Alternatively, as shown in FIG. 17, the back contact cell includes a surface passivation layer 13 arranged on the light-receiving surface, and the surface passivation layer 13 extends from the light-receiving surface to the side surface. In addition, the back contact cell further includes a second interface passivation layer 22 that is arranged on the back surface and located between the silicon substrate 100 and the second doped silicon layer 16, and the second interface passivation layer 22 extends from the back surface to the side surface. Based on this, on the side surface, the intrinsic silicon layer 15 includes the surface passivation layer 13 and the second interface passivation layer 22 that are arranged to form a stack in a direction away from the side surface. In this case, two film layers, that is, the surface passivation layer 13 and the second interface passivation layer 22, are provided between the first doped silicon layer 12 and the second doped silicon layer 16 on the side surface of the silicon substrate 100. In this case, the intrinsic silicon layer 15 has particular transmission resistance, which is beneficial to reducing forward current leakage of the back contact cell and beneficial to balancing the conversion efficiency and the hot spot risk of the back contact cell. In addition, when the low forward current leakage is obtained, it is not necessary to form an intrinsic silicon layer 15 having a large thickness, so that a large thickness of a single second interface passivation layer 22 or surface passivation layer 13 is avoided, thereby ensuring that the second interface passivation layer 22 has a low tunnel resistance and the surface passivation layer 13 has low resistance to light transmission, thereby ensuring high conversion efficiency of the back contact cell.

In the back contact cell provided in the embodiments of the present application, a sequence of forming the surface passivation layer and the second interface passivation layer that are included in the intrinsic silicon layer is not specifically limited. The surface passivation layer may be first formed, and then the second interface passivation layer is formed. In this case, the intrinsic silicon layer includes the surface passivation layer and the second interface passivation layer that are arranged in sequence in the direction away from the side surface. Alternatively, the second interface passivation layer may be first formed, and then the surface passivation layer is formed. In this case, the intrinsic silicon layer includes the second interface passivation layer and the surface passivation layer that are arranged in sequence in the direction away from the side surface.

Regarding the thickness of the intrinsic silicon layer on the side surface of the silicon substrate, as shown in FIG. 16 and FIG. 17, on the side surface of the silicon substrate 100, the thickness of each part of the intrinsic silicon layer 15 is the same. In this case, each part of the intrinsic silicon layer 15 arranged on the side surface of the silicon substrate 100 has high passivation performance and a high protective effect, so that the carrier recombination rate on the side surface of the silicon substrate 100 can be further reduced, and the structural reliability of the back contact cell can be improved.

Alternatively, as shown in FIG. 18, on the side surface of the silicon substrate 100, the thickness of the intrinsic silicon layer 15 may gradually increase in the direction from the light-receiving surface to the back surface. For an application principle of a beneficial effect in this case, refer to the foregoing text, and details are not described herein again.

The specific thickness of the intrinsic silicon layer arranged on the side surface of the silicon substrate may be determined based on an anti-current leakage requirement of the first doped silicon layer and the second doped silicon layer arranged on the side surface of the silicon substrate in an actual application scenario, and is not specifically limited herein.

For example, on the side surface of the silicon substrate, the thickness of the intrinsic silicon layer may be greater than or equal to 5 nm and less than or equal to 30 nm. In this case, on the side surface of the silicon substrate, the thickness of the intrinsic silicon layer is within the foregoing range, which is beneficial to preventing poor passivation performance and a poor protective effect of the intrinsic silicon layer caused by a small thickness of the intrinsic silicon layer, thereby ensuring that the side surface has a low carrier recombination rate and high structural reliability, and is further beneficial to reducing the forward current leakage loss of the back contact cell. It can further be avoided that the thickness of the second interface passivation layer (or the second interface passivation layer and the surface passivation layer) is large because the thickness of the intrinsic silicon layer is large, to ensure that the second interface passivation layer has low tunnel resistance and the surface passivation layer has low resistance to light transmission, thereby ensuring high conversion efficiency of the back contact cell.

In some embodiments, as shown in FIG. 17, the back contact cell may further include anti-reflection layer 207. On the light-receiving surface, the anti-reflection layer 207 is arranged on a side of the surface passivation layer 13 away from the silicon substrate 100. The anti-reflection layer 207 extends from the light-receiving surface to the side surface, and on the side surface, the anti-reflection layer 207 is arranged between the second doped silicon layer 16 and the transparent conductive layer 208. In this case, one anti-reflection layer 207 is further added to the film layers arranged on the side surface of the silicon substrate 100, so that the protective effect on the side surface of the silicon substrate 100 can be further improved, thereby reducing a damage risk of the side surface of the silicon substrate 100 and reducing the forward current leakage loss. In addition, in this case, the anti-reflection layer 207 is directly formed on a side of the second doped silicon layer 16 away from the silicon substrate 100. Compared with that the anti-reflection layer 207 is directly formed on the surface passivation layer 13, when the anti-reflection layer 207 is directly formed on the side of the second doped silicon layer 16 away from the silicon substrate 100, a peripheral plating range of the anti-reflection layer 207 on the side of the back surface can be reduced, so that the amount of etching during the removal of the peripheral plating of the anti-reflection layer 207 on the back surface can be reduced, thereby improving the manufacturing efficiency.

In some embodiments, as shown in FIG. 18, the back contact cell further includes a surface passivation layer 13 and an anti-reflection layer 207 that are arranged in sequence on the light-receiving surface in a thickness direction of the silicon substrate, and the surface passivation layer 13 and the anti-reflection layer 207 extend from the light-receiving surface to the side surface. In addition, on the side surface and in a direction away from the side surface, the surface passivation layer 13 and the anti-reflection layer 207 are arranged in sequence to form a stack between the second doped silicon layer 16 and the transparent conductive layer 208. In this case, the presence of the surface passivation layer 13 and the anti-reflection layer 207 can further improve a protective effect on the side surface of the silicon substrate 100, thereby reducing a damage risk of the side surface of the silicon substrate 100.

In a third aspect, embodiments of the present application further provide a photovoltaic module, including the solar cell according to any one of the foregoing embodiments.

In the description of the foregoing implementation, specific features, structures, materials or characteristics may be combined in an appropriate manner in any one or more possible embodiments or examples.

In the foregoing description, technical details such as pattering and etching of the layers are not described in detail. However, a person skilled in the art should understand that the layer, the region, and the like of a required shape may be formed by using various technical means. In addition, to form a same structure, a person skilled in the art may design a method that is not completely the same as the method described above. In addition, although the foregoing describes the embodiments separately, it does not mean that measures in the embodiments cannot be favorably combined.

In the descriptions of this specification, descriptions using reference terms "an embodiment", "some embodiments", "an exemplary embodiment", "an example", "a specific example", or "some examples" mean that specific characteristics, structures, materials, or features described with reference to the embodiment or example are included in at least one embodiment or example of the present application. In this specification, exemplary descriptions of the foregoing terms do not necessarily refer to the same embodiment or example. In addition, the described specific features, structures, materials, or characteristics may be combined in a proper manner in any one or more of the embodiments or examples.

Although the embodiments of the present disclosure have been shown and described, a person of ordinary skill in the art should understand that various changes, modifications, replacements and variations may be made to the embodiments without departing from the principles and spirit of the present disclosure, and the scope of the present disclosure is as defined by the appended claims and their equivalents.

## Claims

1. A solar cell, comprising: a silicon substrate, wherein the silicon substrate comprises a light-receiving surface and a back surface that are opposite to each other and a side surface arranged between the light-receiving surface and the back surface;
a protective layer is arranged on the side surface, and in a direction away from the silicon substrate, the protective layer comprises a first conductive layer, an insulating layer, and a second conductive layer that are arranged in sequence on the side surface; and a conductivity type of the first conductive layer is opposite to a conductivity type of the second conductive layer.

2. The solar cell according to claim 1, wherein in a direction parallel to the back surface, the back surface comprises a first region and a second region that are alternately arranged; and the first conductive layer is formed on the first region, and the second conductive layer is formed on the second region.

3. The solar cell according to claim 1, wherein the protective layer further comprises a first passivation layer located between the side surface and the first conductive layer and a second passivation layer located between the insulating layer and the second conductive layer;
in a direction parallel to the back surface, the back surface comprises a first region and a second region that are alternately arranged; in the direction away from the silicon substrate, the first passivation layer and the first conductive layer are formed in sequence on the first region, and the second passivation layer and the second conductive layer are formed in sequence on the second region; and the insulating layer is arranged between the first region and the second region.

4. The solar cell according to claim 3, wherein a junction between the side surface and the back surface is a first position, a junction between the side surface and the light-receiving surface is a second position, and a thickness of the protective layer at the first position is greater than a thickness of the protective layer at the second position.

5. The solar cell according to claim 4, wherein the thickness of the protective layer at the first position is D1, and the thickness of the protective layer at the second position is D2, satisfying: 1 < D1/D2 ≤ 10.

6. The solar cell according to claim 4, wherein a thickness of the insulating layer on the back surface is H2, a thickness of the insulating layer located at the first position on the side surface is H21, a thickness of the insulating layer located at the second position on the side surface is H22, and H2, H21, and H22 satisfy at least one of the following relational expressions: H22 < H21 ≤ H2, 0.2 ≤ H22/H21 < 1, 0.5 ≤ H211H2 ≤ 1, and 0.2 ≤ H22/H2 ≤ 0.6.

7. The solar cell according to claim 4, wherein a total thickness of the first passivation layer and the first conductive layer on the back surface is H1, a total thickness of the first passivation layer and the first conductive layer located at the first position on the side surface is H11, a total thickness of the first passivation layer and the first conductive layer located at the second position on the side surface is H12, and H1, H11, and H12 satisfy at least one of the following relational expressions: H12 < H11 ≤ H1, 0.2 ≤ H12/H11 < 1, 0.5 ≤ H11/H1 ≤ 1, and 0.2 ≤ H12/H1 ≤ 0.6.

8. The solar cell according to claim 4, wherein a total thickness of the second passivation layer and the second conductive layer on the back surface is H3, a total thickness of the second passivation layer and the second conductive layer located at the first position on the side surface is H31, a total thickness of the second passivation layer and the second conductive layer located at the second position on the side surface is H32, and H3, H31, and H32 satisfy at least one of the following relational expressions: H32 < H31 ≤ H3, 0.2 ≤ H32/H31 < 1, 0.5 ≤ H31/H3 ≤ 1, and 0.2 ≤ H32/H3 ≤ 0.6.

9. The solar cell according to claim 4, wherein the protective layer further comprises a third passivation layer and an anti-reflection layer, the third passivation layer is arranged on a side of the second conductive layer away from the side surface, and the anti-reflection layer is arranged on a side of the third passivation layer away from the second conductive layer; and
in the direction away from the silicon substrate, the third passivation layer and the anti-reflection layer are formed in sequence on the light-receiving surface.

10. The solar cell according to claim 9, wherein a total thickness of the third passivation layer and the anti-reflection layer on the light-receiving surface is H4, a total thickness of the third passivation layer and the anti-reflection layer located at the first position on the side surface is H41, a total thickness of the third passivation layer and the anti-reflection layer located at the second position on the side surface is H42, and H4, H41, and H42 satisfy at least one of the following relational expressions: H41 < H42 ≤ H4, 0.1 ≤ H42/H41 < 1, 0.1 ≤ H41/H4 ≤ 0.4, and 0.5 ≤ H42/H4 ≤ 0.8.

11. The solar cell according to claim 4, wherein the protective layer further comprises: a transparent conductive layer, wherein the transparent conductive layer is arranged on a side of the second conductive layer away from the side surface; and
the transparent conductive layer is arranged on at least one of the first region and the second region, and the transparent conductive layer is arranged on a side of the first conductive layer and/or the second conductive layer away from the back surface.

12. The solar cell according to claim 11, wherein a thickness of the transparent conductive layer located on the back surface is H5, a thickness of the transparent conductive layer located at the first position on the side surface is H51, a thickness of the transparent conductive layer located at the second position on the side surface is H52, and H5, H51, and H52 satisfy at least one of the following relational expressions: H52 < H51 ≤ H5, 0.3 ≤ H52/H51 < 1, 0.5 ≤ H51/H5 ≤ 1, and 0.2 ≤ H52/H5 ≤ 0.5.

13. The solar cell according to claim 1, wherein the solar cell is a back contact cell; and
the first conductive layer is a first doped silicon layer, the second conductive layer is a second doped silicon layer, and the insulating layer comprises a surface passivation layer and an anti-reflection layer;
the back contact cell comprises: a first interface passivation layer, the first doped silicon layer, the surface passivation layer, the anti-reflection layer, an intrinsic silicon layer, the second doped silicon layer, and a transparent conductive layer that are arranged in sequence on the side surface in the direction away from the silicon substrate; and
in a thickness direction of the silicon substrate, the surface passivation layer and the anti-reflection layer are further arranged in sequence on the light-receiving surface, and the surface passivation layer and the anti-reflection layer extend from the light-receiving surface to the side surface.

14. The solar cell according to claim 13, wherein the back surface comprises a first region and a second region; the first interface passivation layer and the first doped silicon layer are located on the first region; the intrinsic silicon layer and the second doped silicon layer are located on the second region, extend from the second region to the first region, and cover a part of the first interface passivation layer and the first doped silicon layer;
the insulating layer further comprises an insulating mask layer; and the insulating mask layer is arranged between the first doped silicon layer and the surface passivation layer that are located on the side surface, and the insulating mask layer is further arranged between the intrinsic silicon layer and the first doped silicon layer that are located on the back surface in the thickness direction of the silicon substrate.

15. The solar cell according to claim 14, wherein on the side surface of the silicon substrate, a thickness of the insulating mask layer gradually increases in a direction from the light-receiving surface to the back surface; and/or
the insulating mask layer arranged on the side surface is located on a local region of the side surface; and in the thickness direction of the silicon substrate, a ratio of a maximum extension length of the insulating mask layer on the side surface to a thickness of the silicon substrate is less than or equal to 80%.

16. The solar cell according to claim 1, wherein
the solar cell is a back contact cell;
the first conductive layer is a first doped silicon layer, the second conductive layer is a second doped silicon layer, and the insulating layer comprises an insulating mask layer;
the back contact cell comprises: a first interface passivation layer, the first doped silicon layer, the insulating mask layer, an intrinsic silicon layer, the second doped silicon layer, and a transparent conductive layer that are arranged in sequence on the side surface in the direction away from the silicon substrate; the back contact cell comprises a surface passivation layer arranged on the light-receiving surface, and the surface passivation layer extends from the light-receiving surface to the side surface; the back contact cell further comprises a second interface passivation layer that is arranged on the back surface and located between the silicon substrate and the second doped silicon layer, and the second interface passivation layer extends from the back surface to the side surface; and on the side surface, the intrinsic silicon layer comprises the surface passivation layer and the second interface passivation layer that are arranged to form a stack in a direction away from the side surface.

17. The solar cell according to claim 16, wherein the back contact cell further comprises an anti-reflection layer arranged on the light-receiving surface, and the anti-reflection layer extends from the light-receiving surface to the side surface; and
on the side surface, the anti-reflection layer is arranged between the second doped silicon layer and the transparent conductive layer in the direction away from the side surface.

18. The solar cell according to claim 13 or 16, wherein the first interface passivation layer and the first doped silicon layer that are arranged on the side surface are located only on a local region of the side surface and close to the back surface; and
in the thickness direction of the silicon substrate, a ratio of a maximum extension length of the first interface passivation layer and the first doped silicon layer on the side surface to a thickness of the silicon substrate is greater than or equal to 70%; and/or a surface of a region in the side surface that is not covered by the first interface passivation layer and the first doped silicon layer is a textured surface, and a ratio of a maximum extension length of the textured surface on the side surface to the thickness of the silicon substrate is less than or equal to 30%; and/or
in the side surface, a surface reflectance of a region that is not covered by the first interface passivation layer and the first doped silicon layer is less than a surface reflectance of a region that is covered by the first interface passivation layer and the first doped silicon layer; and/or
a surface of a region in the side surface that is not covered by the first interface passivation layer and the first doped silicon layer is a textured surface; and/or a surface of a region in the side surface that is covered by the first interface passivation layer and the first doped silicon layer is a polished surface.

19. The solar cell according to claim 13 or 16, wherein a thickness of each part of the first interface passivation layer and/or the first doped silicon layer is the same; and/or,
on the side surface of the silicon substrate, a thickness of the surface passivation layer is equal, or the thickness of the surface passivation layer gradually increases in a direction from the back surface to the light-receiving surface; and/or
on the side surface of the silicon substrate, a thickness of at least one of the intrinsic silicon layer, the second doped silicon layer, and the transparent conductive layer gradually increases in a direction from the light-receiving surface to the back surface.

20. The solar cell according to claim 13 or 16, wherein the surface passivation layer arranged on the side surface is located on a local region of the side surface and close to the light-receiving surface; and in the thickness direction of the silicon substrate, a ratio of a maximum extension length of the surface passivation layer on the side surface to a thickness of the silicon substrate is less than or equal to 80%.

21. The solar cell according to claim 13 or 16, wherein a material of the surface passivation layer comprises at least one of aluminum oxide, intrinsic amorphous silicon, and doped silicate glass;
and/or
a thickness of the first doped silicon layer is greater than or equal to 30 nm and less than or equal to 140 nm;
and/or
a thickness of the intrinsic silicon layer is greater than or equal to 8 nm and less than or equal to 14 nm.

22. The solar cell according to claim 13 or 16, wherein in the side surface of the silicon substrate, a region on which the first interface passivation layer and the first doped silicon layer are arranged has a pedestal-like texture structure; and
a thickness of the first interface passivation layer located on a bottom surface of the pedestal-like texture structure is less than a thickness of the first interface passivation layer located on a side wall of the pedestal-like texture structure.

23. The solar cell according to claim 13 or 16, wherein the side surface of the silicon substrate has a pedestal-like texture structure;
a thickness of the first interface passivation layer located on a bottom surface of the pedestal-like texture structure is less than a thickness of the first interface passivation layer located on a side wall of the pedestal-like texture structure; and
a thickness of the intrinsic silicon layer located on the bottom surface of the pedestal-like texture structure is greater than a thickness of the intrinsic silicon layer located on the side wall of the pedestal-like texture structure; and/or a thickness of the second doped silicon layer located on the bottom surface of the pedestal-like texture structure is greater than a thickness of the second doped silicon layer located on the side wall of the pedestal-like texture structure.

24. The solar cell according to claim 13 or 16, wherein a doped layer is formed in the side surface of the silicon substrate; and a dopant in the doped layer comprises a dopant in the first doped silicon layer.

25. A solar cell, the solar cell being a back contact cell, wherein the back contact cell comprises:
a silicon substrate, the silicon substrate comprising a back surface and a light-receiving surface that are arranged opposite to each other and a side surface connecting the back surface and the light-receiving surface; and
a first interface passivation layer, a first doped silicon layer, an intrinsic silicon layer, a second doped silicon layer, and a transparent conductive layer that are arranged in sequence on the side surface in a direction away from the side surface, wherein on the side surface of the silicon substrate, the first doped silicon layer and the intrinsic silicon layer are in direct contact; and a conductivity type of the first doped silicon layer is opposite to a conductivity type of the second doped silicon layer.

26. The solar cell according to claim 25, wherein the back contact cell comprises a surface passivation layer arranged on the light-receiving surface, and the surface passivation layer extends from the light-receiving surface to the side surface; the back contact cell further comprises a second interface passivation layer that is arranged on the back surface and located between the silicon substrate and the second doped silicon layer, and the second interface passivation layer extends from the back surface to the side surface; and on the side surface, the intrinsic silicon layer comprises the surface passivation layer and the second interface passivation layer that are arranged to form a stack in the direction away from the side surface; and/or
on the side surface of the silicon substrate, a thickness of each part of the intrinsic silicon layer is the same; and/or
on the side surface of the silicon substrate, a thickness of the intrinsic silicon layer is greater than or equal to 5 nm and less than or equal to 30 nm.

27. The solar cell according to claim 26, wherein the back contact cell further comprises an anti-reflection layer; on the light-receiving surface, the anti-reflection layer is arranged on a side of the surface passivation layer away from the silicon substrate; and the anti-reflection layer extends from the light-receiving surface to the side surface, and on the side surface, the anti-reflection layer is arranged between the second doped silicon layer and the transparent conductive layer.

28. The solar cell according to claim 25, wherein the back contact cell further comprises a surface passivation layer and an anti-reflection layer that are arranged in sequence on the light-receiving surface in a thickness direction of the silicon substrate, and the surface passivation layer and the anti-reflection layer extend from the light-receiving surface to the side surface; and
on the side surface and in the direction away from the side surface, the surface passivation layer and the anti-reflection layer are arranged in sequence to form a stack between the second doped silicon layer and the transparent conductive layer.

29. The solar cell according to claim 25, wherein a doped layer is formed in the side surface of the silicon substrate; and a dopant in the doped layer comprises a dopant in the first doped silicon layer.

30. A photovoltaic module, wherein the photovoltaic module comprises the solar cell according to any one of claims 1 to 24, or the photovoltaic module comprises the solar cell according to any one of claims 25 to 29.
